(19) Europäisches Patentamt
European Patent Office
Office européen des brevets

(11) EP 2 623 508 B1

(12) # EUROPEAN PATENT SPECIFICATION

(45) Date of publication and mention of the grant of the patent:
**16.03.2016 Bulletin 2016/11**

(21) Application number: **12191524.3**

(22) Date of filing: **07.11.2012**

(51) Int Cl.:
***C07F 15/00*** *(2006.01)* ***C09K 11/06*** *(2006.01)*
***H01L 51/00*** *(2006.01)* ***H01L 51/50*** *(2006.01)*
***H05B 33/14*** *(2006.01)* ***H05B 33/20*** *(2006.01)*

(54) **Iridium complex compound, organic electroluminescent element material, organic electroluminescent element, illumination device and display device**

Iridiumkomplexverbindung, Material aus organischem elektrolumineszentem Material, organisches elektrolumineszentes Material, Beleuchtungsvorrichtung und Anzeigevorrichtung

Composé complexe d'iridium, matériau pour élément électroluminescent organique, élément électroluminescent organique, dispositif d'éclairage et dispositif d'affichage

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.02.2012 JP 2012020529**
**07.08.2012 JP 2012174893**

(43) Date of publication of application:
**07.08.2013 Bulletin 2013/32**

(73) Proprietor: **Konica Minolta Advanced Layers, Inc.**
**Hachioji-shi**
**Tokyo 192-8505 (JP)**

(72) Inventors:
- **Otsu, Shinya**
**Hachioji-shi, Tokyo 192-8505 (JP)**
- **Ono, Kaori**
**Hachioji-shi, Tokyo 192-8505 (JP)**
- **Katoh, Eisaku**
**Hachioji-shi, Tokyo 192-8505 (JP)**

(74) Representative: **Gille Hrabal**
**Brucknerstrasse 20**
**40593 Düsseldorf (DE)**

(56) References cited:
**EP-A1- 2 562 229** **JP-A- 2009 130 094**
**US-A1- 2009 243 479** **US-A1- 2011 057 559**
**US-A1- 2011 204 333**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

**Description**

**BACKGROUND OF THE INVENTION**

Field of the Invention

The present invention relates to an iridium complex compound, an organic electroluminescent element material, an organic electroluminescent element, an illumination device and a display device.

Description of the Related Art

An organic electroluminescent element (hereinafter, also referred to as an organic EL element) is a light emitting element, which has a configuration in which a light emitting layer containing a light emitting compound is sandwiched by a cathode and an anode, is applied with an electric field, thereby recombines holes injected from the anode and electrons injected from the cathode with each other in the light emitting layer, thereby generates excitons, and uses emission of light (fluorescent light/phosphorescent light) in the event where the excitons are deactivated. Moreover, the organic EL element is an entirely solid element in which a film of an organic material with a thickness of no more than approximately several submicrons is formed between an electrode and an electrode, and is capable of light emission at a voltage approximately ranging from several to several ten voltages. Accordingly, the organic EL element is expected to be used for next-generation flat panel display and illumination.

As development of the organic EL element, which is oriented for practical use thereof, an organic EL element, which uses phosphorescent light emission from an excited triplet, has been reported from Princeton University (for example, refer to M. A. Baldo et al., nature, volume 395, pages 151-154 (1998)), and since then, researches for materials exhibiting the phosphorescent light at room temperature have been being actively made.

Moreover, in principle, the organic EL element using the phosphorescent light emission is capable of realizing light emission efficiency, which is approximately four times that of the conventional organic EL element using the fluorescent light emission. With regard to the organic EL element using the phosphorescent light emission, starting from material development thereof, researches and developments of a layer configuration and electrodes of this light emitting element are conducted all over the world. For example, many compounds, in which a heavy metal complex such as an iridium complex is mainly focused, are examined to be synthesized.

As described above, such a phosphorescent light emission method is a method in which a potential is extremely high. However, an organic EL device using the phosphorescent light emission is largely different from an organic EL device using the fluorescent light emission, and in the organic EL device using the phosphorescent light emission, the following is an important technical subject in order to enhance efficiency/lifetime of the element. Specifically, the technical subject is a method for controlling a position of a center of the light emission, and in particular, how to allow the organic EL device to stably perform the light emission by performing such recombination in an inside of the light emitting layer.

Accordingly, in recent years, a multilayer stack-type element is well known, which includes a hole transportation layer located on an anode side of the light emitting layer and an electron transportation layer on a cathode side of the light emitting layer, the hole transportation layer and the electron transportation layer being provided in a form of being adjacent to the light emitting layer (for example, refer to Japanese Patent Application Laid-out Publication No. 2005-112765). Moreover, as the light emitting layer, a mixed layer is frequently used, which uses a host compound and a phosphorescent light emitting compound as a dopant.

Meanwhile, from a material viewpoint, a material, which has high carrier transportability, and is stable thermally and electrically, is required. In particular, in the event of using blue phosphorescent light emission, a blue phosphorescent light emitting compound itself has high triplet excitation energy (T1), and accordingly, development of applicable peripheral materials and precise control of the light emission center are strongly required.

As a representative blue phosphorescent light emitting compound, FIrpic is known, in which wave shortening is realized by performing fluorination for phenylpyridine of a main ligand, and by using picolinic acid as an ancillary ligand. These dopants achieve a high-efficiency element by combining therewith carbazole derivatives or triaryl silanes as the host compound; however, a light emission lifetime of the element is deteriorated to a large extent, and accordingly, improvement of a tradeoff therebetween has been required.

Moreover, in recent years, as a blue phosphorescent light emitting compound with a high potential, a metal complex having a specific ligand is disclosed in U.S. 2011/0057559A and U.S. 2011/0204333A.

These literatures describe that a blue phosphorescent light emitting compound, which has a 2-phenylimidazole ligand having a twisted aryl component in which conjugation is expanded, and a specific host compound are used in combination, whereby stability of the organic EL element is enhanced, and high light emission efficiency and a low drive voltage can be realized. Moreover, the following is described: a bulky substituent such as a branched alkyl group is introduced to an ortho position of the twisted aryl component bonded to an imidazole ring, whereby packing between

molecules has been blocked by a steric effect thereof, decomposition products have been reduced, and sublimation at a lower temperature has been enabled.

However, in the case of fabricating an element, which exhibits a different emitted light color, for example, white emission light, by using in combination a plurality of light emitting materials including these blue phosphorescent light emitting materials, then as a new subject, a problem about chroma stability (that is, chroma shift) at the time when the element is continuously driven has occurred.

Moreover, when a doping concentration of the phosphorescent light emitting material in the light emitting layer is changed by several percent to several ten percent, the light emission efficiency and light emission lifetime of the element is varied. In the case where the doping concentration is low, then the transportability and recombination probability of the carriers are lowered, an increase of the drive voltage and a decrease of the light emission efficiency are prone to be brought about, and therefore, improvement of such carrier transportability is necessary.

Moreover, meanwhile, when the doping concentration is high, then there is a subject that the light emitting material is prone to be coagulated, triplet-triplet annihilation (T-T annihilation), generation of a trap site in which an energy level is low, and the like are caused, resulting in an occurrence of decreases of the light emission efficiency and the light emission lifetime. In particular, in the case of the blue phosphorescent light emitting material, since the blue phosphorescent light emitting material concerned has high T1, the blue phosphorescent light emitting material is prone to be affected by an external factor such as the trap site. Hence, it is important to suppress the coagulation among such light emitting materials and to uniformly disperse the light emitting materials concerned not only by adjustment of the concentration.

Moreover, in consideration of production suitability, in these materials in which doping concentration dependency with respect to the element performance is large, a slight change of the doping concentration at the time of production thereof affects the performance of the element, and accordingly, it cannot be said that these materials are preferable since the production suitability thereof is low.

Furthermore, if dispersibility of the light emitting material is low, then the transportability of the carriers in the light emitting layer is also decreased, and as a result, the decrease of the light emission lifetime of the element tends to be brought about.

However, in the technology described in U.S. 2011/0057559A and U.S. 2011/0204333A, the light emission efficiency and light emission lifetime of the organic EL element are improved; however, there are subjects in thermal stability and sublimability of the metal complex as the organic EL element material, and the decomposition products are generated in the event of forming an organic layer by evaporation using the metal complex concerned, whereby the light emission lifetime of the element is lowered in some case.

JP 2009 130094 A discloses an organic EL element, a lighting system using the same element, and a display device. The organic electroluminescence element contains bis-type transition metal complex and a ligand is a chelate type ligand one and contains a 5-membered ring part.

US 2009/243479 A1 discloses an organic electroluminescent element which at least contains an iridium complex compound having a chelate type ligand containing a five-membered nitrogen heterocyclic part.

Moreover, no description is made of the subjects of the chroma stability at the time of such continuous drive in the white light emitting organic EL element using a plurality of the light emitting materials, and of the doping concentration dependency with respect to the element performance, and a relationship between the dispersibility and lifetime of the light emitting material.

## SUMMARY OF THE INVENTION

Hence, it is an object of the present invention to provide an organic electroluminescent element with high light emission efficiency and a long lifetime by enhancing the thermal stability and sublimability of the organic metal complex as the organic electroluminescent element material, and to provide an illumination device and a display device, each of which uses the element concerned.

Moreover, it is another object of the present invention to solve the subject of the chroma stability (that is, the chroma shift) at the time when the white light emitting organic electroluminescent element is continuously driven, and to improve the doping concentration dependency in the element performance. It is still another object of the present invention to achieve elongation of the lifetime of the organic electroluminescent element by providing an iridium complex compound having high dispersibility.

To achieve at least one of the abovementioned objects, an iridium complex compound, reflecting one aspect of the present invention, is represented by a following general formula (1):

[general formula (1)]

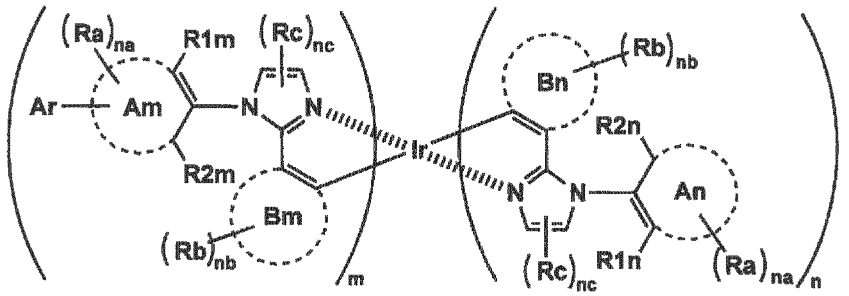

[wherein in the general formula (1), each of a ring Am, a ring An, a ring Bm and a ring Bn represents a five-membered or six-membered aromatic hydrocarbon ring or aromatic heterocyclic ring; Ar represents an aromatic hydrocarbon ring, an aromatic heterocyclic ring, a non-aromatic hydrocarbon ring, or a non-aromatic heterocyclic ring; independently of one another, each of R1m, R2m, R1n and R2n represents an alkyl group with a carbon number of 2 or more, an aromatic hydrocarbon ring group, an aromatic heterocyclic ring group, a non-aromatic hydrocarbon ring group, or a non-aromatic heterocyclic group, and moreover, may have a substituent; independently of one another, each of Ra, Rb and Rc represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent; each of na and nc represents 1 or 2, and nb represents an integer of 1 to 4; m represents 1, n represents 2, and m+n is 3; and note that a state where structures of three ligands arranged in Ir are entirely same does not occur.]

To achieve at least one of the abovementioned objects, the iridium complex compound, reflecting another aspect of the present invention, is represented by a following general formula (2):

[general formula (2)]

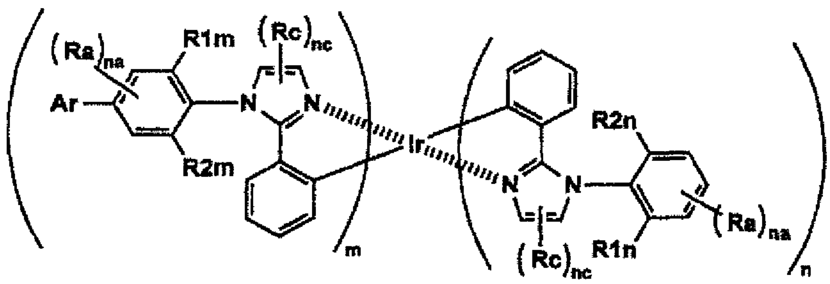

[wherein in the general formula (2), Ar represents an aromatic hydrocarbon ring, an aromatic heterocyclic ring, a non-aromatic hydrocarbon ring, or a non-aromatic heterocyclic ring; independently of one another, each of R1m, R2m, R1n and R2n represents an alkyl group with a carbon number of 2 or more, an aromatic hydrocarbon ring group, an aromatic heterocyclic ring group, a non-aromatic hydrocarbon ring group, or a non-aromatic heterocyclic group, and moreover, may have a substituent; independently of each other, Ra and Rc represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent; each of na and nc represents 1 or 2; m represents 1 or 2, n represents 1 or 2, and m+n is 3; note that a state where structures of three ligands arranged in Ir are entirely same does not occur.]

To achieve at least one of the abovementioned objects, the iridium complex compound, reflecting still another aspect of the present invention, is represented by a following general formula (3):

[general formula (3)]

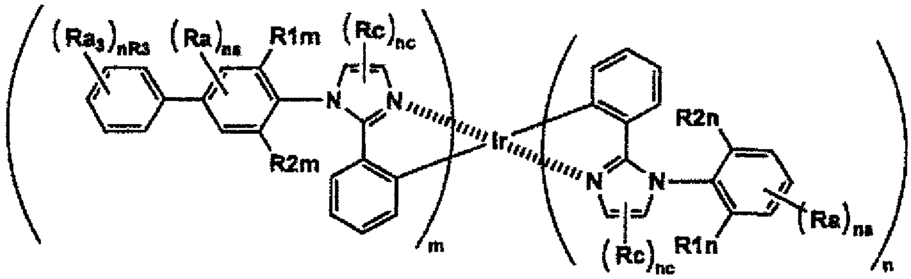

[wherein in the general formula (3), independently of one another, each of R1m, R2m, R1n and R2n represents an alkyl group with a carbon number of 2 or more, an aromatic hydrocarbon ring group, an aromatic heterocyclic ring group, a non-aromatic hydrocarbon ring group, or a non-aromatic heterocyclic group, and moreover, may have a substituent; independently of one another, Ra, Rc and Ra3 represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent; each of na and nc represents 1 or 2 ; nR3 represents an integer of 1 to 5; m represents 1 or 2, n represents 1 or 2, and m+n is 3; note that a state where structures of three ligands arranged in Ir are entirely same does not occur.]

To achieve at least one of the abovementioned objects, an organic electroluminescent element material, reflecting still another aspect of the present invention, is represented by a following general formula (1):

[general formula (1)]

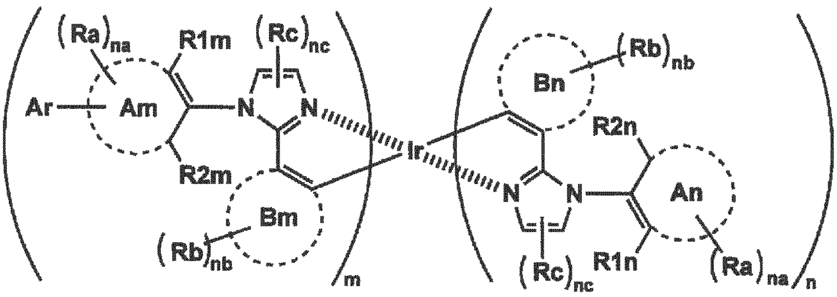

[wherein in the general formula (1), each of a ring Am, a ring An, a ring Bm and a ring Bn represents a five-membered or six-membered aromatic hydrocarbon ring or aromatic heterocyclic ring; Ar represents an aromatic hydrocarbon ring, an aromatic heterocyclic ring, a non-aromatic hydrocarbon ring, or a non-aromatic heterocyclic ring; independently of one another, each of R1m, R2m, R1n and R2n represents an alkyl group with a carbon number of 2 or more, an aromatic hydrocarbon ring group, an aromatic heterocyclic ring group, a non-aromatic hydrocarbon ring group, or a non-aromatic heterocyclic group, and moreover, may have a substituent; independently of one another, each of Ra, Rb and Rc represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent; each of na and nc represents 1 or 2, and nb represents an integer of 1 to 4; m represents 1, n represents 1 or 2, and m+n is 3; and note that a state where structures of three ligands arranged in Ir are entirely same does not occur.]

To achieve at least one of the abovementioned objects, the organic electroluminescent element material, reflecting still another aspect of the present invention, is represented by a following general formula (2):

[general formula (2)]

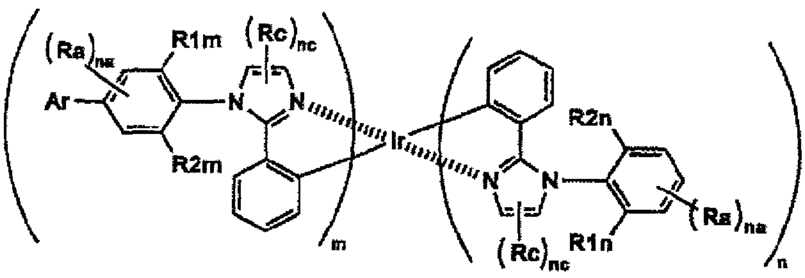

[wherein in the general formula (2), Ar represents an aromatic hydrocarbon ring, an aromatic heterocyclic ring, a non-aromatic hydrocarbon ring, or a non-aromatic heterocyclic ring; independently of one another, each of R1m, R2m, R1n and R2n represents an alkyl group with a carbon number of 2 or more, an aromatic hydrocarbon ring group, an aromatic heterocyclic ring group, a non-aromatic hydrocarbon ring group, or a non-aromatic heterocyclic group, and moreover, may have a substituent; independently of each other, Ra and Rc represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent; each of na and nc represents 1 or 2; m represents 1 or 2, n represents 1 or 2, and m+n is 3; note that a state where structures of three ligands arranged in Ir are entirely same does not occur.]

To achieve at least one of the abovementioned objects, the organic electroluminescent element material, reflecting still another aspect of the present invention, is represented by a following general formula (3):

[general formula (3)]

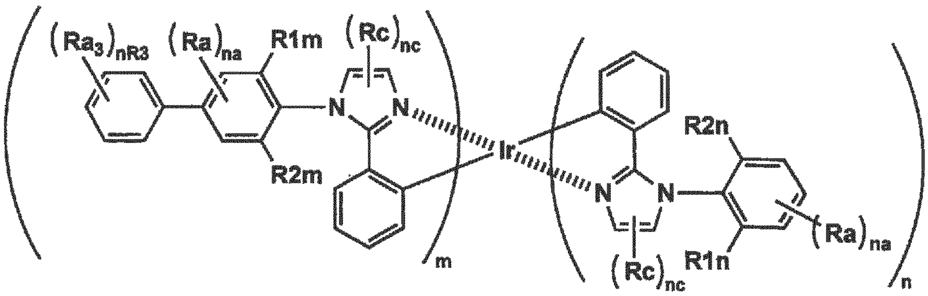

[wherein in the general formula (3), independently of one another, each of R1m, R2m, R1n and R2n represents an alkyl group with a carbon number of 2 or more, an aromatic hydrocarbon ring group, an aromatic heterocyclic ring group, a non-aromatic hydrocarbon ring group, or a non-aromatic heterocyclic group, and moreover, may have a substituent; independently of one another, Ra, Rc and Ra3 represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent; each of na and nc represents 1 or 2 ; nR3 represents an integer of 1 to 5; m represents 1 or 2, n represents 1 or 2, and m+n is 3; note that a state where structures of three ligands arranged in Ir are entirely same does not occur.]

To achieve at least one of the abovementioned objects, an organic electroluminescent element, reflecting still another aspect of the present invention, in which at least one organic layer including a light emitting layer is sandwiched between an anode and a cathode,

wherein the at least one organic layer includes an iridium complex compound represented by a following general formula (1):

[general formula (1)]

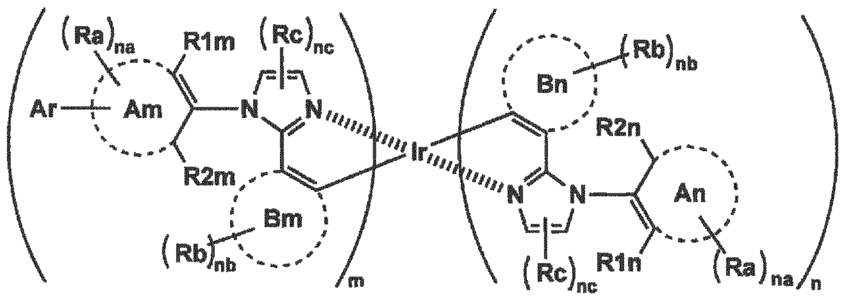

[wherein in the general formula (1), each of a ring Am, a ring An, a ring Bm and a ring Bn represents a five-membered or six-membered aromatic hydrocarbon ring or aromatic heterocyclic ring; Ar represents an aromatic hydrocarbon ring, an aromatic heterocyclic ring, a non-aromatic hydrocarbon ring, or a non-aromatic heterocyclic ring; independently of one another, each of R1m, R2m, R1n and R2n represents an alkyl group with a carbon number of 2 or more, an aromatic hydrocarbon ring group, an aromatic heterocyclic ring group, a non-aromatic hydrocarbon ring group, or a non-aromatic heterocyclic group, and moreover, may have a substituent; independently of one another, each of Ra, Rb and Rc represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent; each of na and nc represents 1 or 2, and nb represents an integer of 1 to 4; m represents 1, n represents 2, and m+n is 3; and note that a state where structures of three ligands arranged in Ir are entirely same does not occur.]

To achieve at least one of the abovementioned objects, the organic electroluminescent element, reflecting still another aspect of the present invention, in which at least one organic layer including a light emitting layer is sandwiched between an anode and a cathode,

wherein the at least one organic layer comprises an iridium complex compound represented by a following general formula (2):

[general formula (2)]

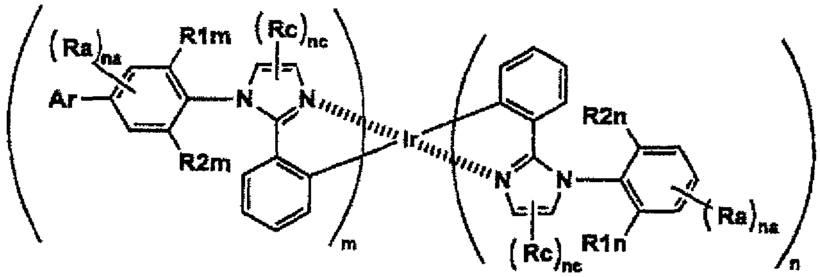

[wherein in the general formula (2), Ar represents an aromatic hydrocarbon ring, an aromatic heterocyclic ring, a non-aromatic hydrocarbon ring, or a non-aromatic heterocyclic ring; independently of one another, each of R1m, R2m, R1n and R2n represents an alkyl group with a carbon number of 2 or more, an aromatic hydrocarbon ring group, an aromatic heterocyclic ring group, a non-aromatic hydrocarbon ring group, or a non-aromatic heterocyclic group, and moreover, may have a substituent; independently of each other, Ra and Rc represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent; each of na and nc represents 1 or 2; m represents 1 or 2, n represents 1 or 2, and m+n is 3; note that a state where structures of three ligands arranged in Ir are entirely same does not occur.]

To achieve at least one of the abovementioned objects, the organic electroluminescent element, reflecting still another aspect of the present invention, in which at least one organic layer including a light emitting layer is sandwiched between an anode and a cathode,

wherein the at least one organic layer comprises an iridium complex compound represented by a following general formula (3) :

[general formula (3)]

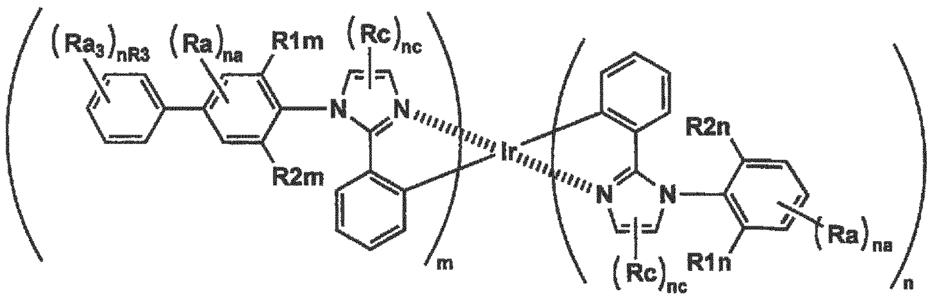

[wherein in the general formula (3), independently of one another, each of R1m, R2m, R1n and R2n represents an alkyl group with a carbon number of 2 or more, an aromatic hydrocarbon ring group, an aromatic heterocyclic ring group, a non-aromatic hydrocarbon ring group, or a non-aromatic heterocyclic group, and moreover, may have a substituent; independently of one another, Ra, Rc and Ra3 represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent; each of na and nc represents 1 or 2; nR3 represents an integer of 1 to 5; m represents 1 or 2, n represents 1 or 2, and m+n is 3; note that a state where structures of three ligands arranged in Ir are entirely same does not occur.]

To achieve at least one of the abovementioned objects, an illumination device, reflecting still another aspect of the present invention, includes the above mentioned organic electroluminescent element.

To achieve at least one of the abovementioned objects, a display device, reflecting still another aspect of the present invention, includes the above mentioned organic electroluminescent element.

## BRIEF DESCRIPTION OF THE DRAWINGS

The present invention will be more fully understood by the following detailed description and the accompanying drawings. However, these are not intended to limit the present invention, wherein:

FIG. 1 is a schematic view showing an example of a display device composed of an organic EL element;
FIG. 2 is a schematic view of a display unit A;
FIG. 3 is a schematic diagram of a pixel;
FIG. 4 is a schematic view of a full color display device of a passive matrix method;
FIG. 5 is a rough view of an illumination device;
FIG. 6 is a schematic view of the illumination device;
FIGS. 7A to 7E are rough schematic views of an organic EL full color display device;
FIG. 8 shows Table 1;
FIG. 9 shows Table 2;
FIG. 10 shows Table 3;
FIG. 11 shows Table 4;
FIG. 12 shows Table 5;
FIG. 13 shows Table 6;
FIG. 14 shows Table 7;
FIG. 15 shows Table 8; and
FIG. 16 shows Table 9.

## PREFERRED EMBODIMENTS OF THE PRESENT INVENTION

A description is made below in detail of embodiments for carrying out the present invention; however, the present invention is not limited to these.

«Constituent layers of organic EL element»

A description is made of constituent layers of the organic EL element of the present invention. Preferable specific examples of layer configurations of a variety of organic layers to be sandwiched between an anode and a cathode in the organic EL element of the present invention are shown below; however, the present invention is not limited to these.

(i) anode / light emitting layer unit / electron transportation layer / cathode
(ii) anode / hole transportation layer / light emitting layer unit / electron transportation layer / cathode
(iii) anode / hole transportation layer / light emitting layer unit / hole blocking layer / electron transportation layer / cathode
(iv) anode / hole transportation layer / light emitting layer unit / hole blocking layer / electron transportation layer / cathode buffer layer / cathode
(v) anode / anode buffer layer / hole transportation layer / light emitting layer unit / hole blocking layer / electron transportation layer / cathode buffer layer / cathode

Moreover, the light emitting layer unit may include a non-light emitting intermediate layer between a plurality of light emitting layers, and may have such a multiphoton unit configuration in which the intermediate layer concerned is a charge generation layer. In this case, as the charge generation layer, there are mentioned: a layer of a conductive inorganic compound such as indium/tin oxide (ITO), indium/zinc oxide (IZO), $ZnO_2$, TiN, ZrN, HfN, TiOx, VOx, CuI, InN, GaN, $CuAlO_2$, $CuGaO_2$, $SrCu_2O_2$, $LaB_6$, and $RuO_2$; a film of two layers such as $Au/Bi_2O_3$; a film of multilayers such as $SnO_2/Ag/SnO_2$, ZnO/Ag/ZnO, $Bi_2O_3/Au/Bi_2O_3$, $TiO_2/TiN/TiO_2$, and $TiO_2/ZrN/TiO_2$; a layer of a conductive organic material such as fullerenes such as C60, and oligothiophene; and a layer of a conductive organic compound such as metal phthalocyanines, metal-free phthalocyanines, metal porphyrins, and metal-free porphyrins.

Preferably, light emitting layers of the organic EL element of the present invention are white light emitting layers, and more preferably, an illumination device of the present invention is an illumination device using these.

A description is made below of the respective layers which compose the organic EL element of the present invention.

«Light emitting layer»

The light emitting layer according to the present invention is a layer that emits light in such a manner that electrons and holes, which are injected from the electrodes, or the electron transportation layer and the hole transportation layer, are recombined with each other. A portion that emits light may be an inside of the light emitting layer or an interface between the light emitting layer and an adjacent layer thereto.

A total sum of film thicknesses of the light emitting layer is not particularly limited; however, from viewpoints of uniformity of films, and preventing unnecessary application of a high voltage at the time of light emission, and enhancing stability of a light emission color with respect to a drive current, the total sum is preferably adjusted to a range of 2 nm to 5 $\mu$m, is more preferably adjusted to a range of 2 nm to 200 nm, and is particularly preferably adjusted to a range of 5 nm to 100 nm.

For fabricating the light emitting layer, light emitting dopants and host compounds, which will be described later, can be used. For example, the light emitting layer can be formed by deposition using a vacuum evaporation method, a wet method and the like. The wet method is also referred to as a wet process, and for example, there can be mentioned a spin coat method, a cast method, a die coat method, a blade coat method, a roll coat method, an ink-jet method, a printing method, a spray coat method, a curtain coat method, a Langmuir Blodgett method (LB method), and the like. Note that, in the case of using, as a material of the light emitting layer, a hexadentate ligand-type ortho-metalated iridium complex, preferably, the light emitting layer is deposited in the wet process.

Preferably, the light emitting layer of the organic EL element of the present invention contains a compound of the light emitting dopant (a phosphorescent light emitting dopant (also referred to as a phosphorescent light dopant and a phosphorescent light emitting dopant group), a fluorescent dopant, and the like) and a light emitting host compound.

(1) Light emitting dopant compound

A description is made of such a light emitting dopant compound (also referred to as a light emitting dopant, as a dopant compound, or simply as a dopant).

As the light emitting dopant, there can be used a fluorescent dopant (also referred to as a fluorescent compound), and a phosphorescent dopant (also referred to as a phosphorescent light emitting material, a phosphorescent compound, a phosphorescent light emitting compound, or the like).

(1. 1) Phosphorescent dopant (also referred to as a phosphorescent light emitting dopant)

A description is made of the phosphorescent dopant according to the present invention.

The phosphorescent dopant compound according to the present invention is a compound in which light emission from an excited triplet is observed, specifically, is a compound that exhibits phosphorescent light emission at room temperature (25°C), and is defined to be a compound in which a phosphorescent quantum yield is 0.01 or more at 25°C. However, a preferable phosphorescent quantum yield is 0.1 or more.

The above-described phosphorescent quantum yield can be measured by a method described in the page 398 of Spectrum II of the Experimental Chemistry Lecture 7, 4th-edition (1992 edition, Maruzen). The phosphorescent quantum yield in a solution can be measured by using a variety of solvents, and in the phosphorescent dopant according to the present invention, the above-described phosphorescent quantum yield (0.01 or more) just needs to be achieved in any of arbitrary solvents.

With regard to the light emission of the phosphorescent dopant, two types of principles thereof are mentioned. One is an energy transfer type, in which carrier recombination occurs on the host compound to which the carriers are transported, an excited state of the light emitting host compound is generated, and this energy is transferred to the phosphorescent dopant, whereby the light emission from the phosphorescent dopant is obtained. The other is a carrier trap type, in which the phosphorescent dopant becomes a carrier trap, the recombination of the carriers occurs on the phosphorescent dopant, and the light emission from the phosphorescent dopant compound is obtained. In any of the cases, it is conditioned that energy in the excited state of the phosphorescent dopant is lower than energy in an excited state of the host compound.

Here, as a result of repeating researches assiduously in order to achieve the above-described object of the present invention, the inventors of the present invention have uncovered that the thermal stability and sublimability of the organic EL element can be enhanced by containing an iridium complex dopant, which is represented by the following general formula (1), in the organic layers of the organic EL element. That is to say, structures of any of a plurality of ligands to be arranged in iridium atoms are differentiated from each other, and substituents with a carbon number of 2 or more are used for R1m, R2m, R1n and R2n in the general formula (1), whereby an interaction between such iridium complexes has been absorbed, the sublimability has been improved, and finally, further, the thermal stability of the iridium complex has been enhanced. In such a way, continuous and repeated evaporation has been enabled in the event of forming the organic layers by depositing the iridium complex dopant concerned by evaporation. Moreover, the inventors of the present invention have found out that enhancement of light emission brightness of the organic EL element and the elongation of the light emission lifetime thereof can be achieved by the fact that the iridium complex dopant is contained in the organic EL element.

Hence, the organic EL element of the present invention is an element, which is composed in such a manner that the iridium complex compound represented by the following general formula (1) is contained as an organic EL element material in at least one layer of the organic layers, and preferably, is an element composed in such a manner that the iridium complex compound represented by the following general formula (1) is contained as the organic EL element material in the light emitting layer among the organic layers.

(1. 1. 1) Iridium complex compound represented by general formula (1)

A description is made of the iridium complex compound to be contained as the organic EL element material in the organic EL element of the present invention. The iridium complex compound according to the present invention is represented by the following general formula (1).

[general formula (1)]

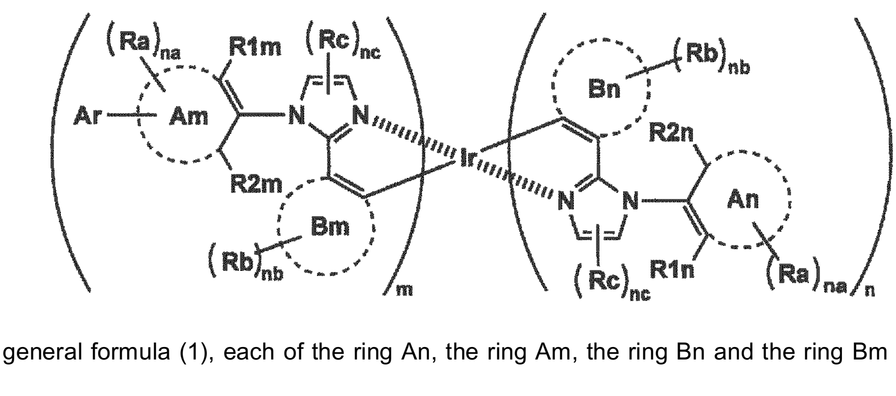

In the general formula (1), each of the ring An, the ring Am, the ring Bn and the ring Bm represents a five-membered or six-membered aromatic hydrocarbon ring or aromatic heterocyclic ring.

In the general formula (1), as the five-membered or six-membered aromatic hydrocarbon ring represented by each of the ring An, the ring Am, the ring Bn and the ring Bm, for example, a benzene ring is mentioned.

In the general formula (1), as the five-membered or six-membered aromatic heterocyclic ring represented by each of the ring An, the ring Am, the ring Bn and the ring Bm, for example, there are mentioned a furan ring, a thiophene ring, an oxazole ring, a pyrrole ring, a pyridine ring, a pyridazine ring, a pyrimidine ring, a pyrazine ring, a triazine ring, an oxadiazole ring, a triazole ring, an imidazole ring, a pyrozole ring, a thiazole ring, and the like. Preferably, at least one of the rings Bn and Bm is the benzene ring, more preferably, at least one of the rings An and Am is the benzene ring.

In the general formula (1), Ar represents an aromatic hydrocarbon ring, an aromatic heterocyclic ring, a non-aromatic hydrocarbon ring, or a non-aromatic heterocyclic ring.

In the general formula (1), as the aromatic hydrocarbon ring represented by Ar, for example, there are mentioned a benzene ring, a biphenyl ring, a naphthalene ring, an azulene ring, an anthracene ring, a phenanthrene ring, a pyrene ring, a chrysene ring, a naphthacene ring, a triphenylene ring, an o-terphenyl ring, an m-terphenyl ring, a p-terphenyl ring, an acenaphthene ring, a coronene ring, a fluorene ring, a fluoranthrene ring, a naphthacene ring, a pentacene ring, a perylene ring, a pentaphene ring, a picene ring, a pyrene ring, a pyranthrene ring, an anthranthrene ring, and the like.

In the general formula (1), as the aromatic heterocyclic ring represented by Ar, for example, there are mentioned a silole ring, a furan ring, a thiophene ring, an oxazole ring, a pyrrole ring, a pyridine ring, a pyridazine ring, a pyrimidine ring, a triazine ring, an oxadiazole ring, a triazole ring, an imidazole ring, a pyrazole ring, a thiazole ring, an indole ring, a benzimidazole ring, a benzthiazole ring, a benzoxazole ring, a quinoxaline ring, a quinazoline ring, a phthalazine ring, a thienothiophene ring, a carbazole ring, an azacarbazole (representing one in which nitrogen atoms are substituted for arbitrary one or more carbon atoms which compose the carbazole ring), a dibenzosilole ring, a dibenzofuran ring, a dibenzothiophene ring, a ring in which nitrogen atoms are substituted for arbitrary one or more carbon atoms which compose a benzothiophene ring or the dibenzofuran ring, a benzodifuran ring, a benzodithiophene ring, an acridine ring, a benzoquinoline ring, a phenazine ring, a phenanthridine ring, a phenanthroline ring, a cyclazine ring, a quindoline ring, a thepenidine ring, a quinindoline ring, a triphenodithiazine ring, a triphenodioxazine ring, a phenanthlazine ring, an anthrazine ring, a perimidine ring, a naphthofuran ring, a naphthothiophene ring, a naphthodifuran ring, a naphthodithiophene ring, an anthrafuran ring, an anthradifuran ring, an anthrathiophene ring, an anthradithiophene ring, a thianthrene ring, a phenoxathiin ring, a dibenzocarbazole ring, an indolocarbazole ring, a dithienobenzene ring, and the like.

In the general formula (1), as the non-aromatic hydrocarbon ring represented by Ar, for example, there are mentioned a cycloalkane group (for example, a cyclopentane ring, a cyclohexane ring and the like), a cycloalkoxy group (for example, a cyclopentyloxy group, a cyclohexyloxy group and the like), a cycloalkylthio group (for example, a cyclopentylthio group, a cyclohexylthio group and the like), a cyclohexylaminosulfonyl group, a tetrahydronaphthalene ring, a 9,10-dihydroanthracene ring, a biphenylene ring, and the like.

In the general formula (1), as the non-aromatic heterocyclic ring represented by Ar, for example, there are mentioned an epoxy ring, an aziridine ring, a thiirane ring, an oxetane ring, an azetidine ring, a thietane ring, a tetrahydrofuran ring, a dioxyolane ring, a pyrrolidine ring, a pyrazolidine ring, an imidazolidine ring, an oxazolidine ring, a tetrahydrothiophene ring, a sulfolane ring, a thiazolidine ring, an ε-caprolactone ring, an ε-caprolactam ring, a piperidine ring, a hexahydropyridazine ring, a hexahydropyrimidine ring, a piperazine ring, a morpholine ring, a tetrahydropyran ring, a 1,3-dioxane ring, 1,4-dioxane ring, a trioxane ring, a tetrahydrothiopyran ring, a thiomorpholine ring, a thiomorpholine-1,1-dioxide ring, a pyranose ring, a diazabicyclo[2,2,2]octane ring, a phenoxazine ring, a phenothiazine ring, an oxanthrene ring, a thioxanthene ring, a phenoxathiin ring, and the like.

In the general formula (1), these rings represented by Ar may have substituents, and further, the substituents concerned are combined with one another to for the rings.

In the general formula (1), Ar is preferably the aromatic hydrocarbon ring or the aromatic heterocyclic ring, more preferably, the aromatic hydrocarbon ring, still more preferably, the benzene ring.

In the general formula (1), independently of each other, each of R1m and R2m represents an alkyl group with a carbon number of 2 or more, an aromatic hydrocarbon ring group, an aromatic heterocyclic ring group, a non-aromatic hydrocarbon ring group, or a non-aromatic heterocyclic group, and moreover, R1m and R2m may have a substituent.

In the general formula (1), as the alkyl group represented by R1m and R2m, for example, there are mentioned a methyl group, an ethyl group, a trifluoromethyl group, an isopropyl group, an n-butyl group, a t-butyl group, an n-hexyl group, a 2-methylhexyl group, a pentyl group, an adamantyl group, an n-decyl group, an n-dodecyl group, and the like.

In the general formula (1), as the aromatic hydrocarbon ring group, the aromatic heterocyclic ring group, the non-aromatic hydrocarbon ring group, or the non-aromatic heterocyclic ring group, which is represented by each of R1m and R2m, there is mentioned a monovalent group to be derived from the aromatic hydrocarbon ring, the aromatic heterocyclic ring, the non-aromatic hydrocarbon ring or the non-aromatic heterocyclic ring, which is represented by Ar in the above-mentioned general formula (1).

As the substituent which the alkyl group with a carbon number of 2 or more, the aromatic hydrocarbon ring group, the aromatic heterocyclic ring group, the non-aromatic hydrocarbon ring group, or the non-aromatic heterocyclic

ring group, which is represented by each of R1m and R2m in the general formula (1), may further have, for example, there are mentioned a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group, the non-aromatic heterocyclic ring group, or the like.

In the general formula (1), preferably, each of R1m and R2m is the alkyl group with a carbon number of 2 or more, or a cycloalkyl group, and moreover, also preferably, either one of R1m and R2m is a branched alkyl group with a carbon atom number of 3 or more. Further, more preferably, each of R1m and R2m is a branched alkyl group with a carbon atom number of 3 or more.

In the general formula (1), R1n and R2n has the same definitions as those of R1m and R2m in the above-mentioned general formula (1).

In the general formula (1), independently of one another, each of Ra, Rb and Rc represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent. In the case where each of Ra, Rb and Rc exists in plural, Ra, Rb and Rc may be the same or may be different from one another.

In the general formula (1), as each of the aryl group and the heteroaryl group, which is represented by each of Ra, Rb and Rc, there is mentioned a monovalent group to be derived from the aromatic hydrocarbon ring, and the aromatic heterocyclic ring, which is represented by Ar in the above-mentioned general formula (1).

In the general formula (1), as each of the non-aromatic hydrocarbon ring group and the non-aromatic heterocyclic ring group, which is represented by each of Ra, Rb and Rc, there is mentioned a monovalent group to be derived from the non-aromatic hydrocarbon ring, and the non-aromatic heterocyclic ring, which is represented by Ar in the above-mentioned general formula (1).

In the general formula (1), na and nc represents 1 or 2, and nb represents an integer of 1 to 4.

In the general formula (1), m represents 1, n represents 2, and m+n is 3.

Note that, in the general formula (1), such a state does not occur where the structures of three ligands arranged in Ir are entirely the same.

(1. 1. 2) Iridium complex compound represented by general formula (2)

Preferably, the iridium complex compound represented by the above-mentioned general formula (1) is represented by the following general formula (2).

[general formula (2)]

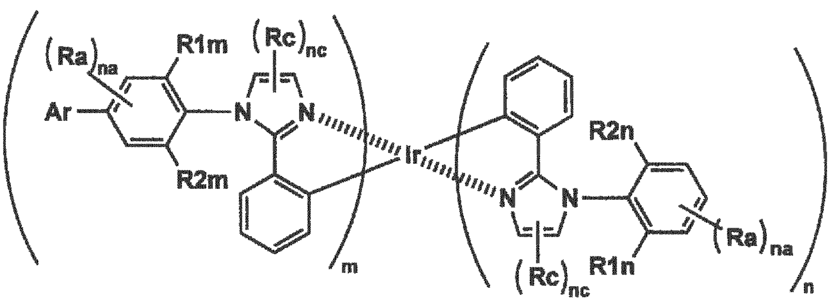

In the general formula (2), Ar, R1m, R2m, R1n, R2n, Ra, Rc, na, nc, m and n have the same definitions as those of Ar, R1m, R2m, R1n, R2n, Ra, Rc, na, nc, m and n in the general formula (1).

Note that, in the general formula (2), such a state does not occur where the structures of three ligands arranged in Ir are entirely the same.

Moreover, it is possible to synthesize the iridium complex oxides according to the present invention, which are individually represented by the general formulas (1) and (2), by referring to a publicly known method described in Internal Publication No. WO 2006/121811.

(1. 1. 3) Iridium complex compound represented by general formula (3)

Preferably, the iridium complex compound represented by the above-mentioned general formula (1) or (2) is represented by the following general formula (3).

[general formula (3)]

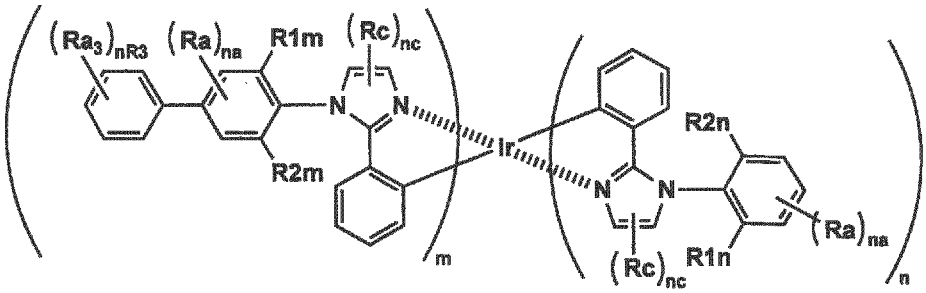

In the general formula (3), R1m, R2m, R1n, R2n, Ra, Rc, na, nc, m and n have the same definitions as those of R1m, R2m, R1n, R2n, Ra, Rc, na, nc, m and n in the general formula (1).

In the general formula (3), Ra3 has the same definition as those of Ra, Rb and Rc in the general formula (1).

In the general formula (3), nR3 represents an integer of 1 to 5.

Note that, in the general formula (3), such a state does not occur where the structures of three ligands arranged in Ir are entirely the same.

(1. 1. 6) Specific example

Specific examples of the iridium complex compounds represented by the general formulas (1) to (3) are mentioned below; however, the present invention is not limited to these.

DP-1

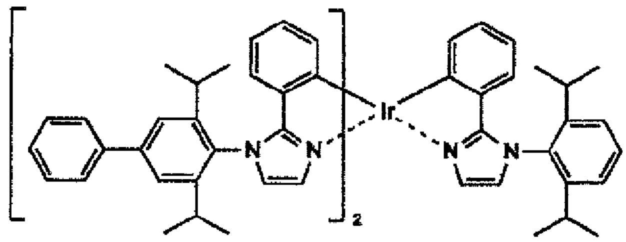

(not according to the present invention)

DP-2

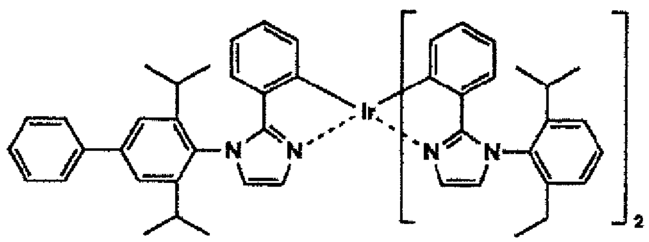

DP-3

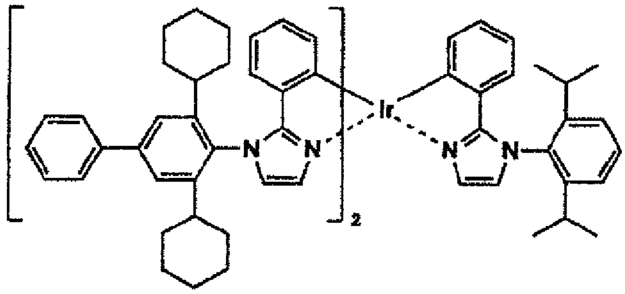

(not according to the present invention)

DP-4

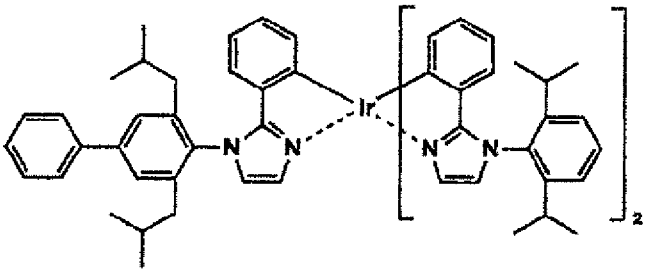

DP-5

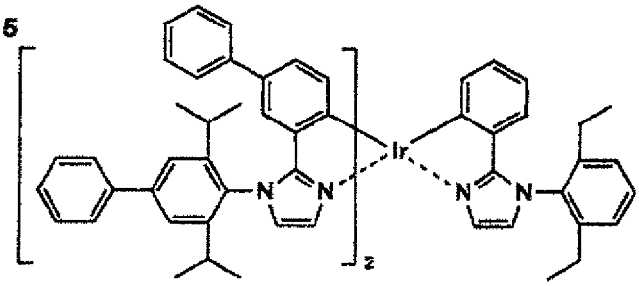

(not according to the present invention)

DP-6

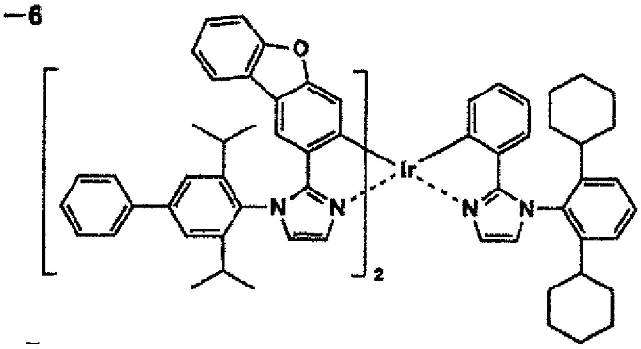

(not according to the present invention)

DP-7

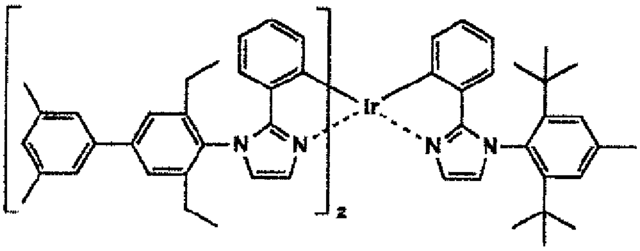

(not according to the present invention)

DP-8

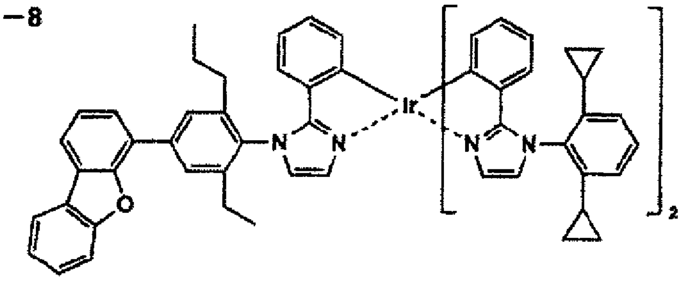

DP-9

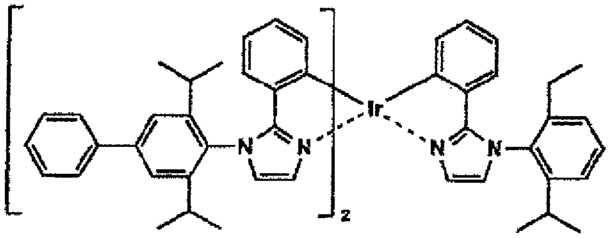

(not according to the present invention)

DP-10

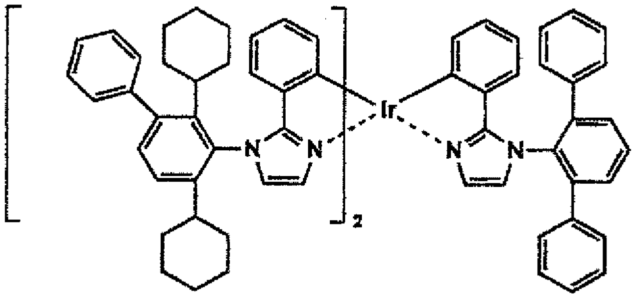

(not according to the present invention)

DP-11

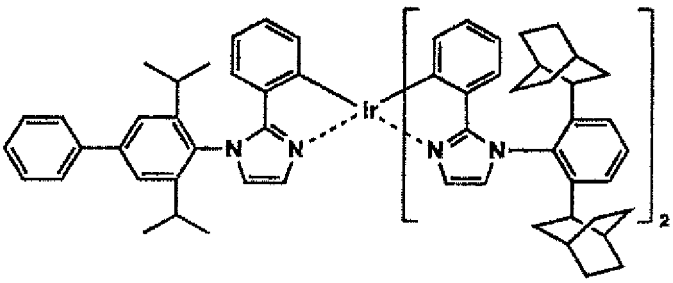

DP-12

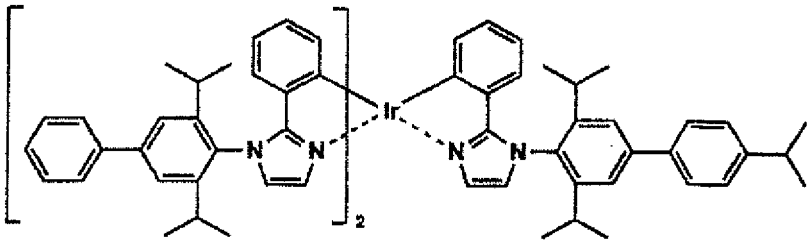

DP-13

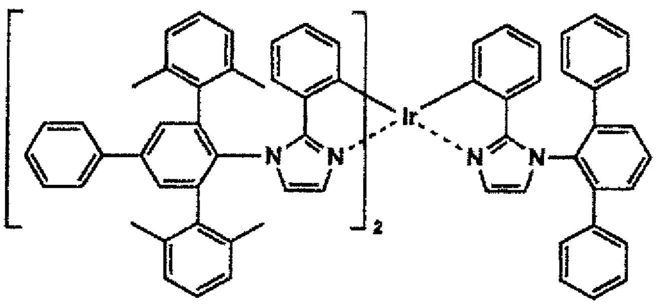

(not according to the present invention)

DP−18

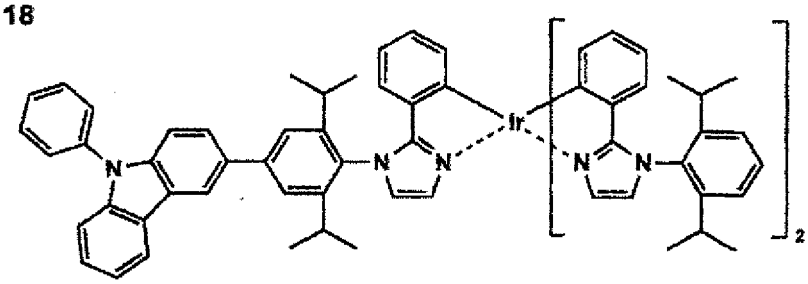

DP−19

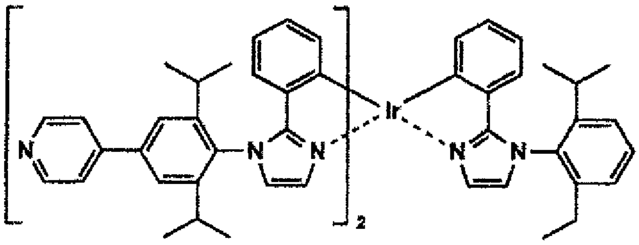

(not according to the present invention)

DP−20

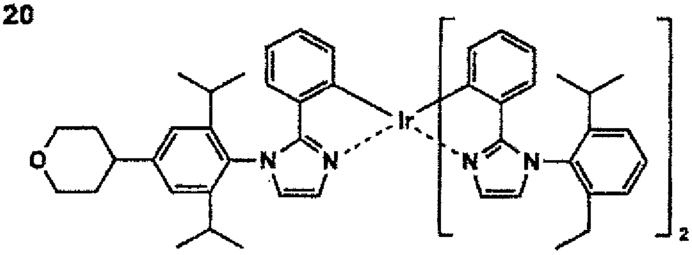

DP−21

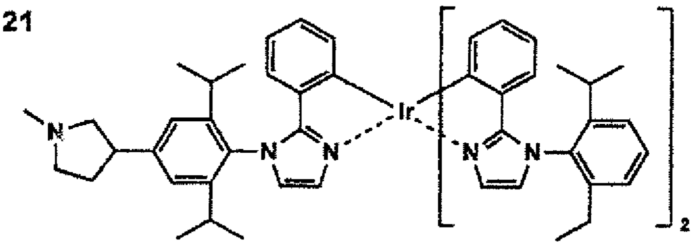

DP−34

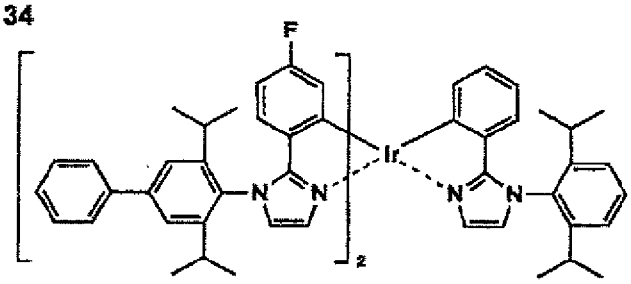

(not according to the present invention)

DP-35

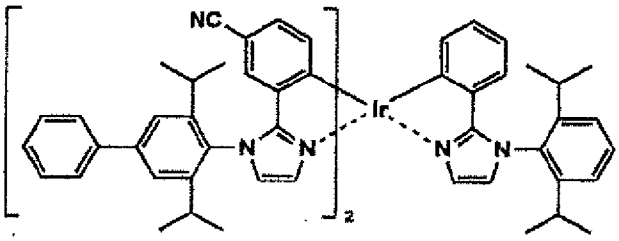

(not according to the present invention)

DP-36

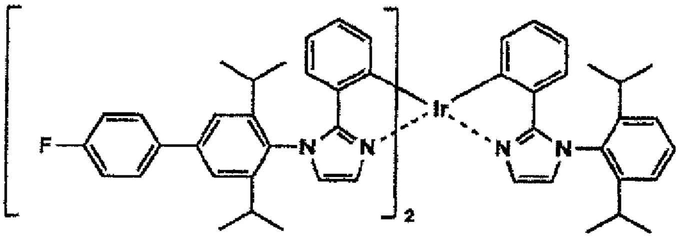

(not according to the present invention)

DP-37

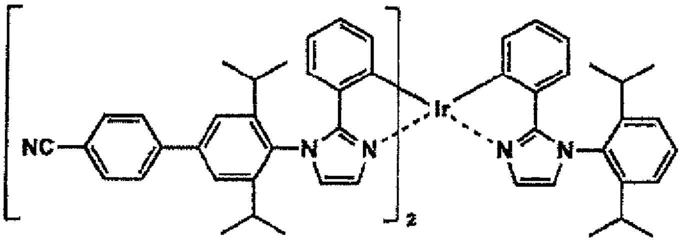

(not according to the present invention)

DP-38

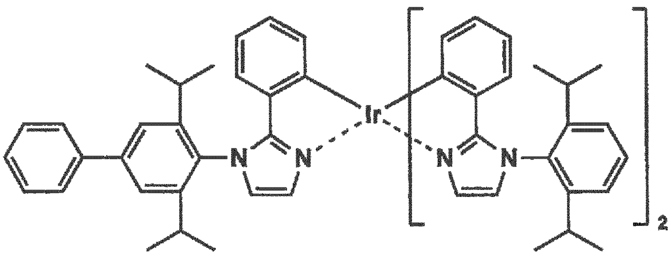

DP-39

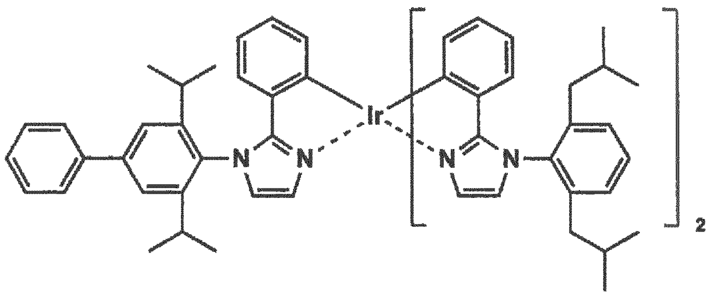

DP-40

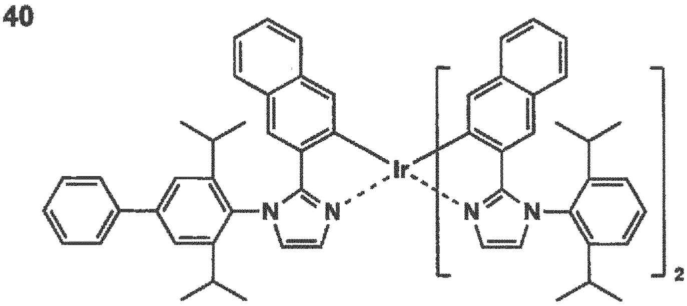

DP-41

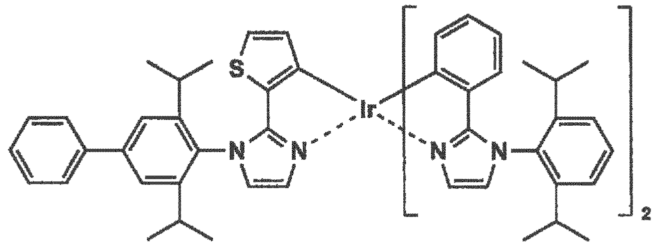

DP-42

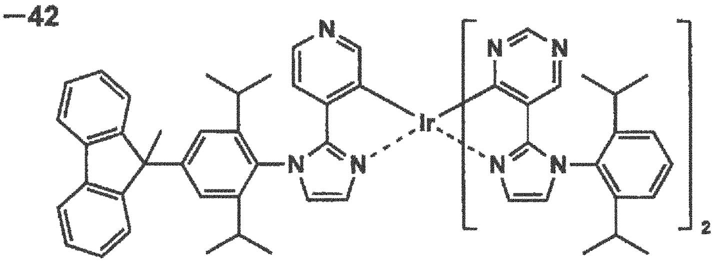

DP-43

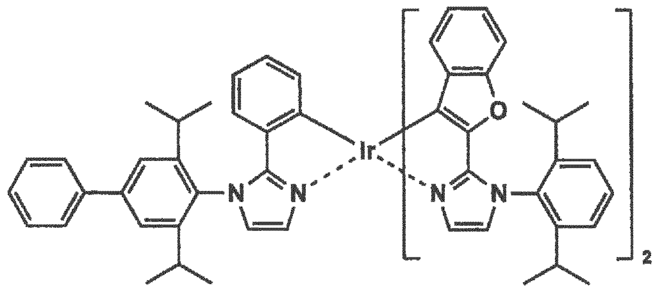

DP-44

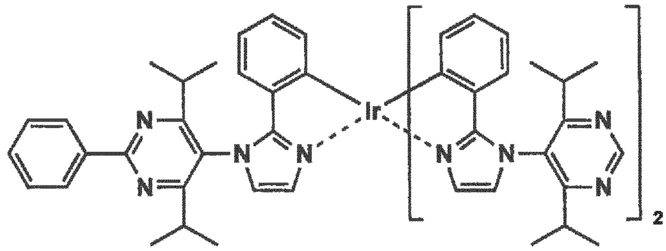

DP-45

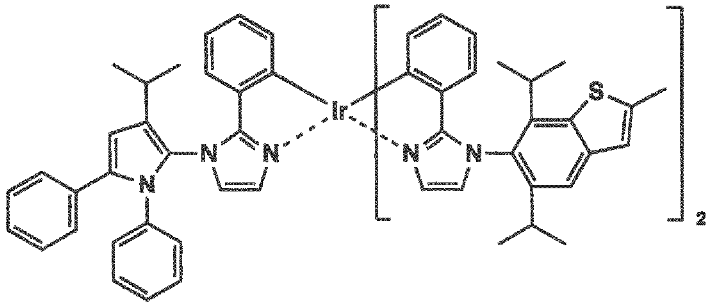

DP-46

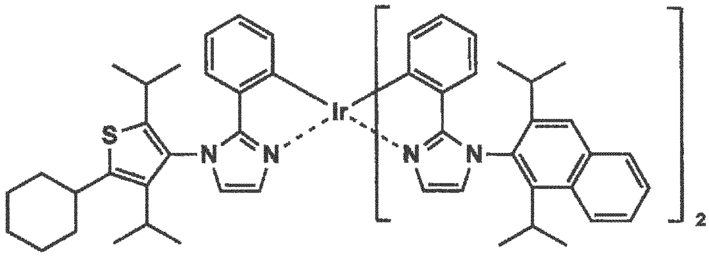

DP-47

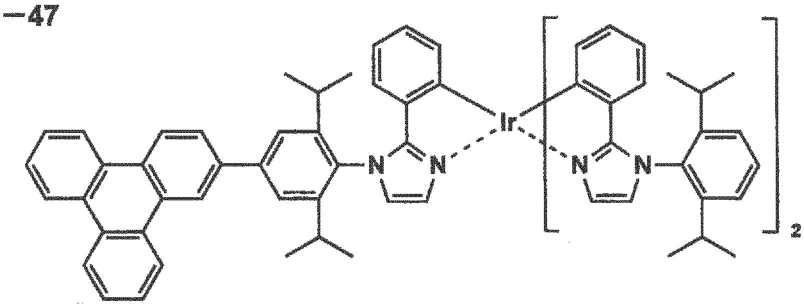

DP-48

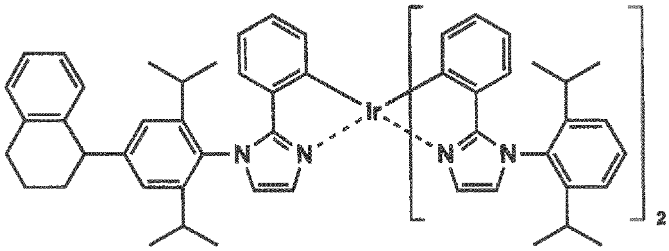

DP-49

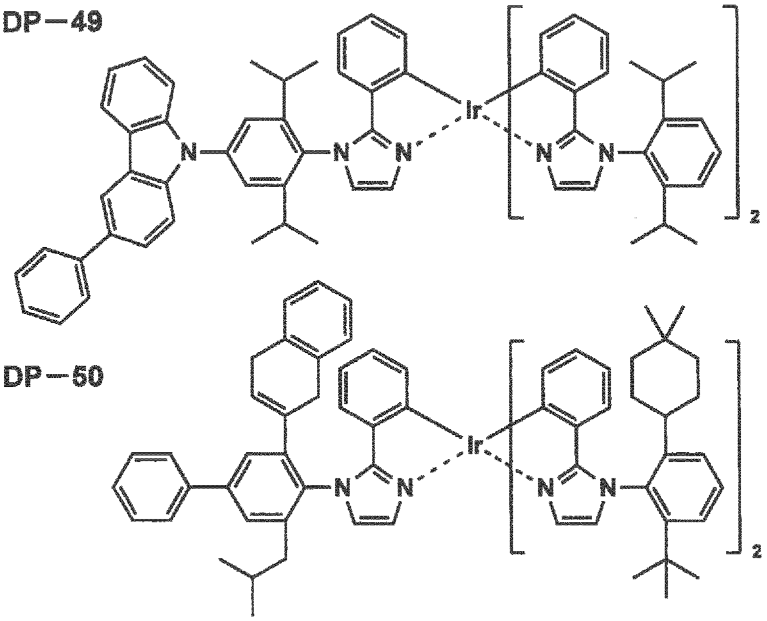

DP-50

DP-51

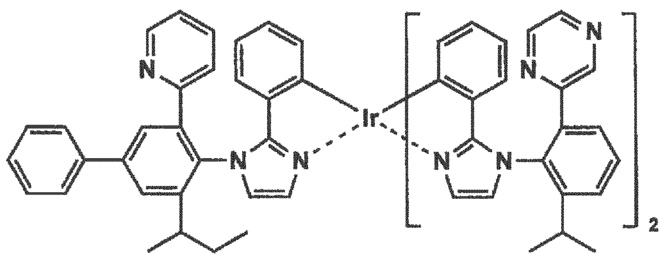

DP-52

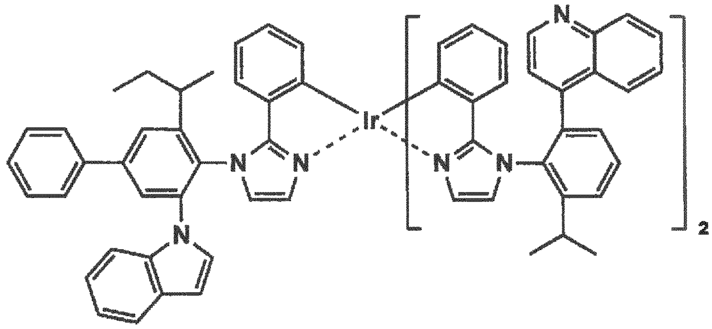

DP-53

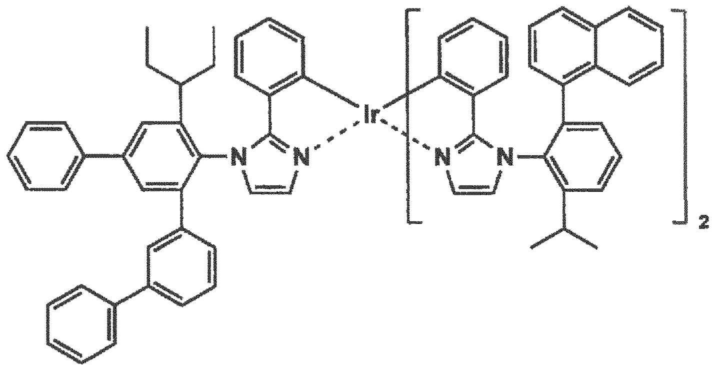

DP−54

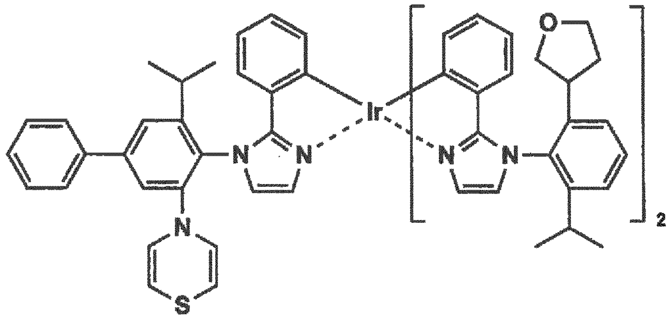

DP−55

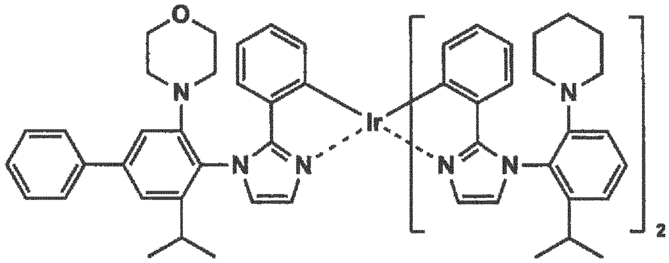

DP−56

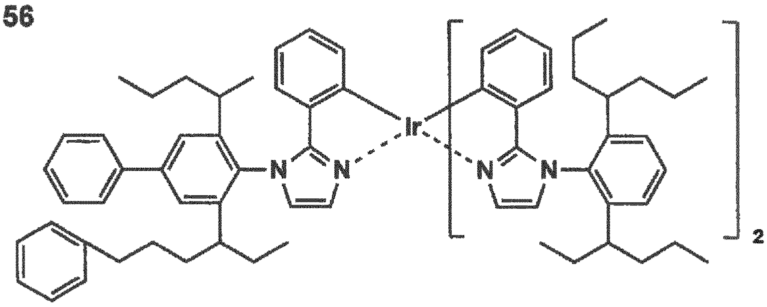

DP−57

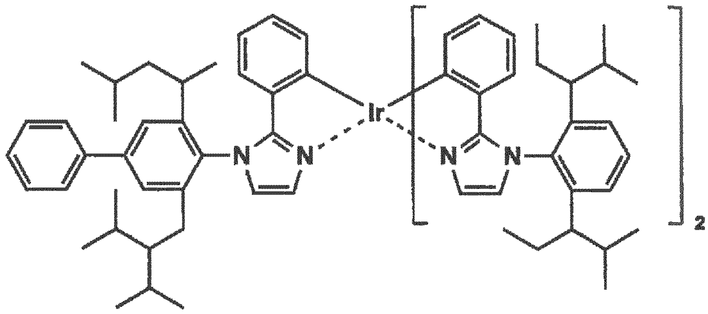

DP−58

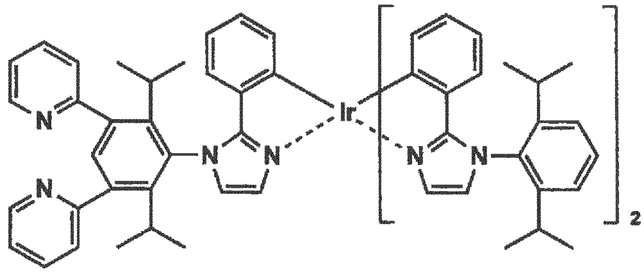

DP-59

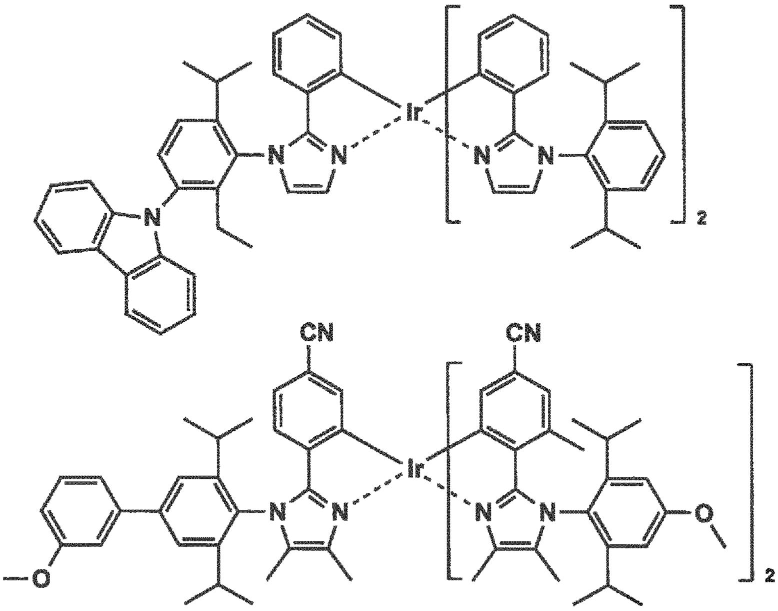

DP-60

DP-61

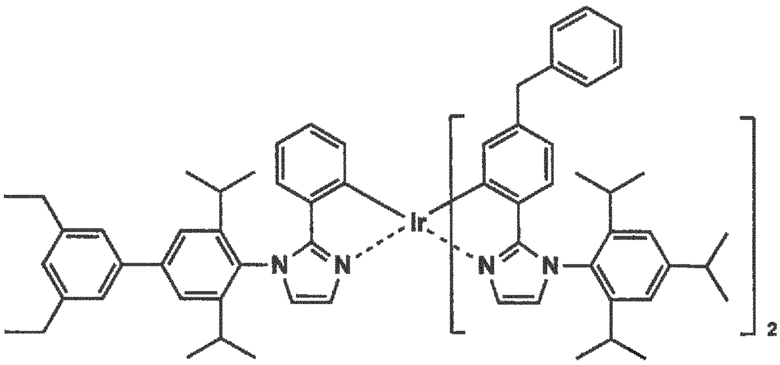

DP-62

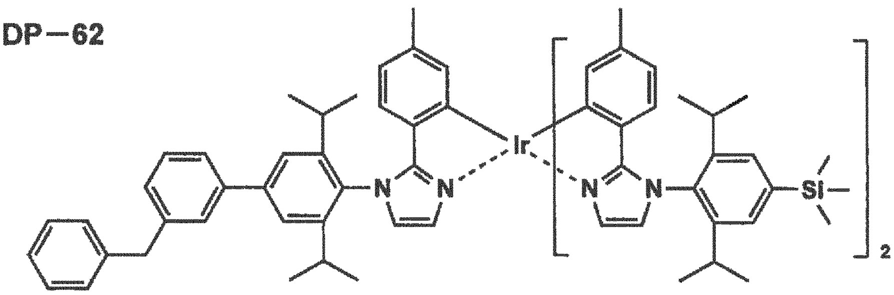

DP-63

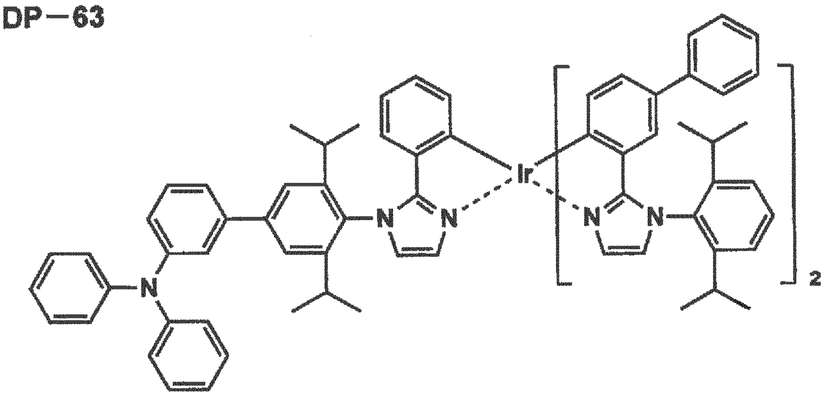

DP−64

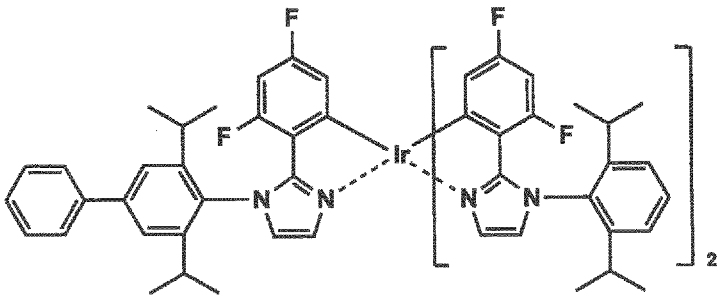

DP−65

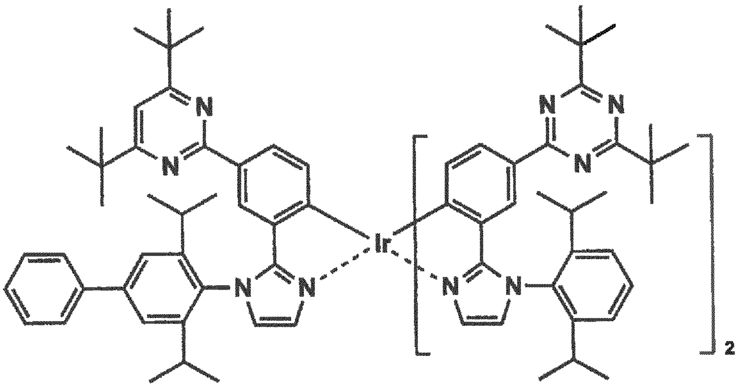

DP−66

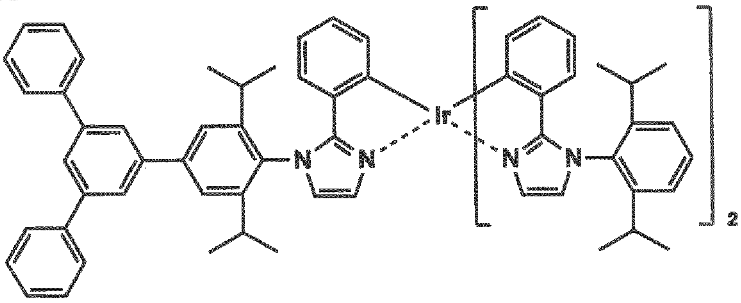

DP−67

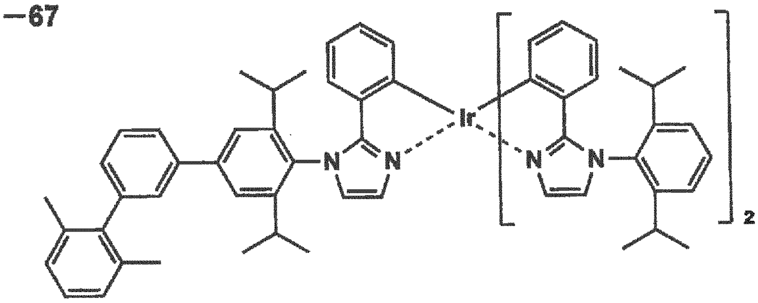

DP−68

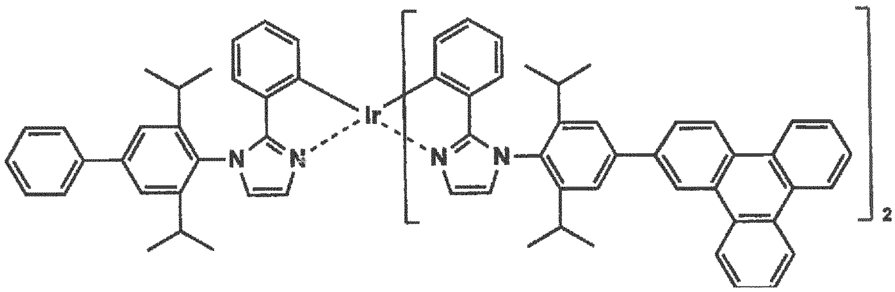

DP−69

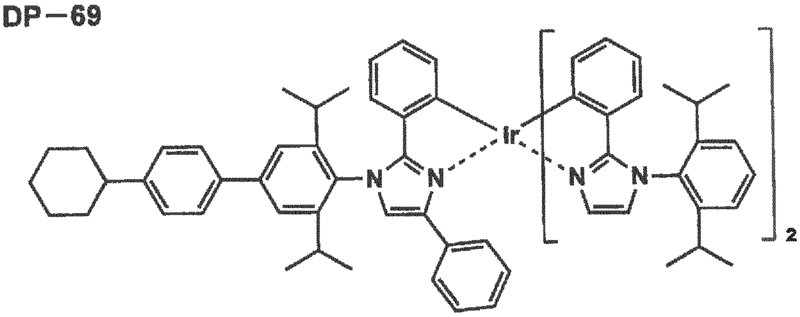

DP−70

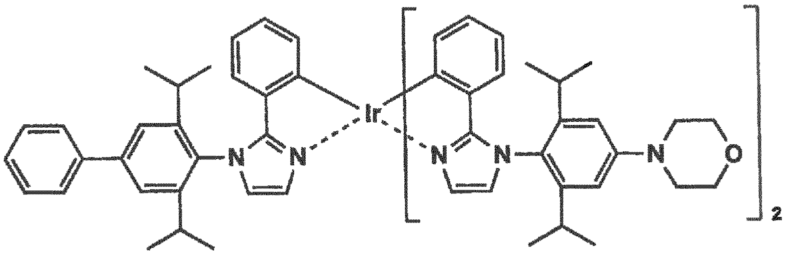

DP−71

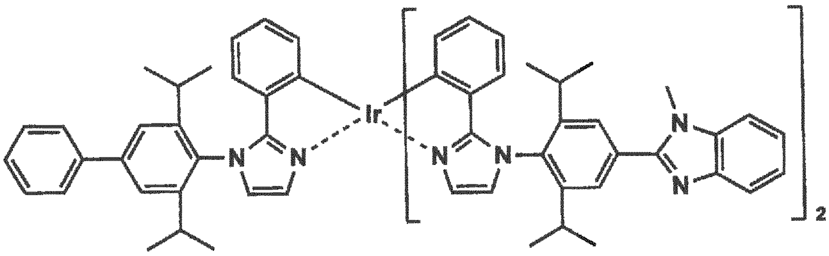

DP−72

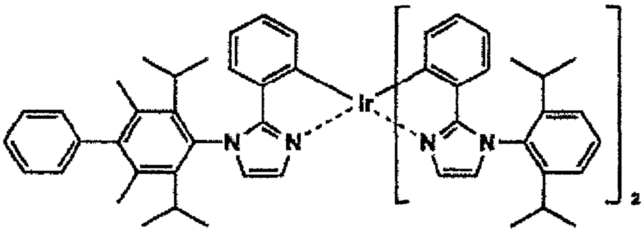

DP−73

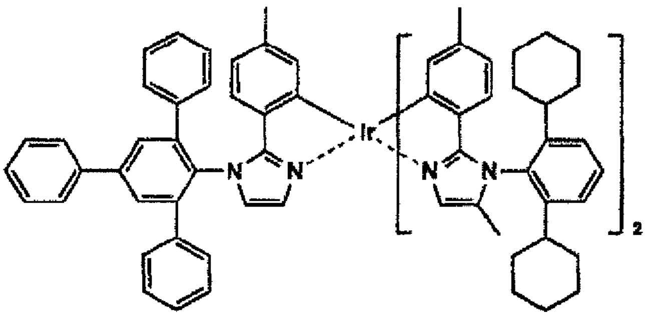

(1. 1. 7) Synthesis examples

A description is made below of synthesis examples of the compounds represented by the general formulas (1) to (3); however, the present invention is not limited to these. A description is made below of a synthesis method of the DP-1 among the above-described specific compounds whereby DP-1 is a reference example.

The DP-1 can be synthesized in accordance with the following scheme.

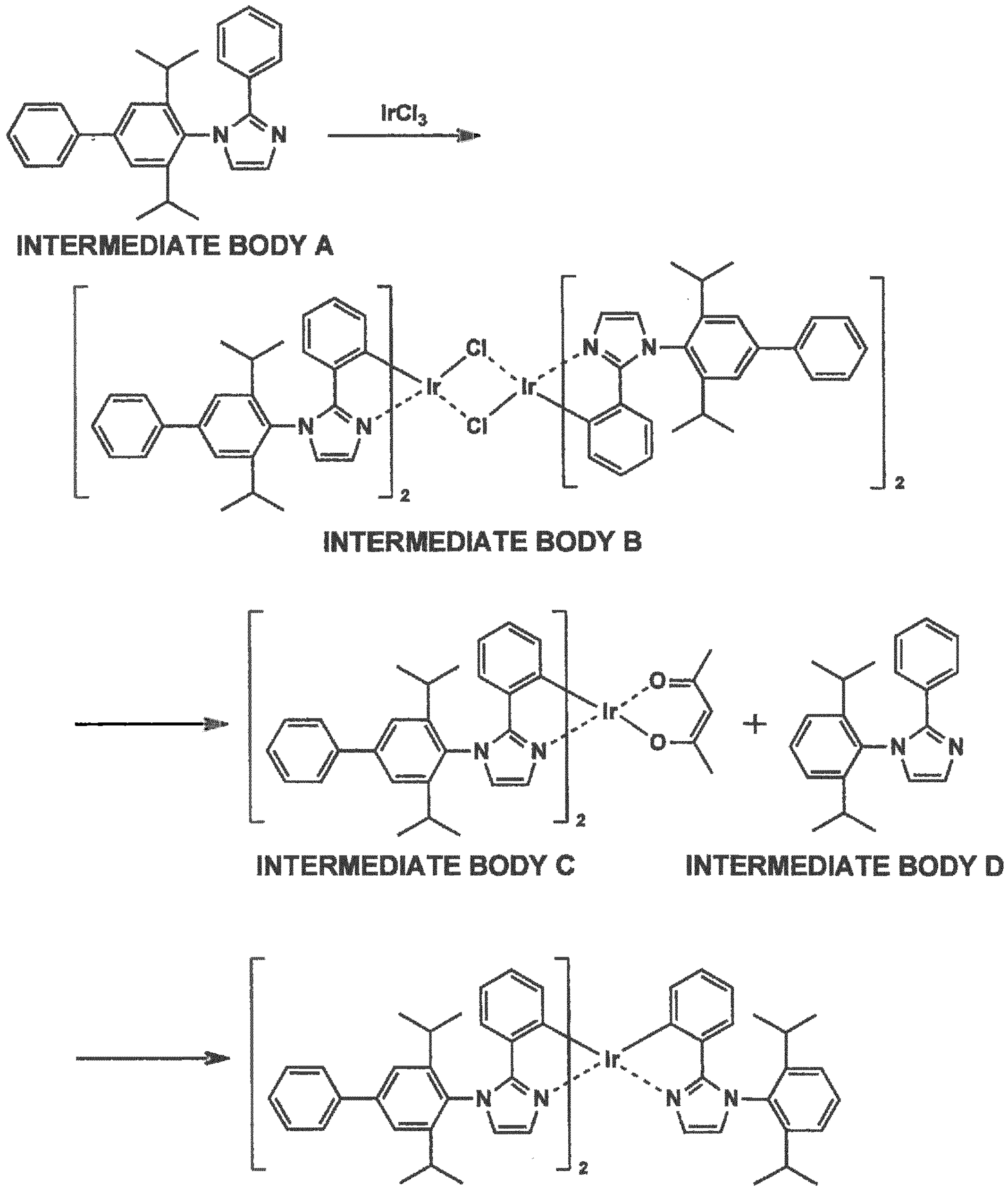


INTERMEDIATE BODY A

INTERMEDIATE BODY B

INTERMEDIATE BODY C

INTERMEDIATE BODY D

DP-1

(Step 1)

Into a three-head flask, there were put 5 g of an intermediate body A, 1.9 g of iridium chloride, 100 ml of ethoxyethanol, and 30 ml of water, and this mixture was heated and stirred for 4 hours at 100°C under a nitrogen atmosphere.

Precipitated crystals were obtained by filtration, and the crystals obtained by the filtration were washed by methanol, whereby 4.5 g of an intermediate body B was obtained.

(Step 2)

Into a three-head flask, there were put 4.0 g of the intermediate body B obtained in Step 1, 2.5 g of acetylacetone, 7 g of potassium carbonate, and 100 ml of ethoxyethanol, and this mixture was heated and stirred for 5 hours at 80°C under a nitrogen atmosphere.

Precipitated crystals were obtained by filtration, and the crystals obtained by the filtration were washed by methanol, whereby 2.8 g of an intermediate body C was obtained.

(Step 3)

Into a three-head flask, there were put 2.8 g of the intermediate body C obtained in Step 2, 1.6 g of an intermediate body D, and 50 ml of ethylene glycol, and this mixture was heated and stirred for 7 hours at 150°C under a nitrogen atmosphere.

Precipitated crystals were obtained by filtration, and the crystals obtained by the filtration were washed by methanol, and thereafter, were separated and purified by silica gel chromatography, whereby 0.7 g of the DP-1 was obtained.

A structure of the compound example DP-1 was confirmed by MASS spectrum and 1H-NMR.
MASS spectrum (ESI): m/z = 1179 [M+]
$^1$H-NMR ($CD_2Cl_2$, 400 MHz)$\delta$: 7.71 (2H, d, J = 28.3 Hz), 7.42 (1H, t, J = 28.3 Hz), 7.33-7.57(6H, m), 7.34(4H, t, J - 33.2 Hz), 6.96 (2H, S), 6.81-6.86 (6H, m), 6.69 (2H, d, J = 33.2 Hz), 6.56-6.60 (2H, m), 6.44 (1H, t, J = 23.4 Hz), 6.38 (2H, d, J = 17.6 Hz), 6.32 (1H, d, J =23.4 Hz), 6.16 (2H, d, J = 44.9 Hz), 2.65-2.80 (3H, m, CH of iso-Pr), 2.29-2.41 (3H, m, CH of iso-Pr), 1.26 (3H, d, J = 26.3 Hz, CH3 of iso-Pr), 1.21 (6H, d, J = 20.5 Hz, $CH_3$ of iso-Pr), 0.92-1.08 (m, 27H, $CH_3$ of iso-Pr)

(1. 2) Fluorescent dopant (also referred to as a fluorescent compound)

As the fluorescent dopant, there are mentioned a coumarin-based dye, a pyran-based dye, a cyanine-based dye, a croconium-based dye, a squarylium-based dye, an oxobenzanthracene-based dye, a fluorescein-based dye, a rhodamine-based dye, a pyrylium-based dye, a perylene-based dye, a stilbene-based dye, a polythiophene-based dye, or rare earth complex-based fluorescent materials, or a compound with a high fluorescent quantum yield, which is represented by a laser dye.

(1. 3) Combined use with dopant heretofore known in public

Moreover, for the light emitting dopant, plural types of compounds may be used in combination, and phosphorescent dopants different in structure may be used in combination, or the phosphorescent dopant and the fluorescent dopant may be used in combination.

Here, as the light emitting dopant heretofore known in public, which may be used in combination with the iridium complex compound according to the present invention, which is represented by the general formula (1), there are mentioned compounds and the like described in the following Patent Publications; however, the present invention is not limited to these.

For example, US2006835469, US20060202194, US20070087321, WO2009100991, WO2008101842, WO2003040257, US20050244673, US20020034656, US7332232, US20090108737, US20090039776, US6921915, US6687266, US20070190359, US2006008670, WO2009050290, US20090165846, US20080015355, US7250226, US7396598, WO2002015645, US20060263635, WO2009000673, US20030138657, US20030152802, US7090928, WO2002002714, WO2006009024, WO2007097149, WO2006056418, WO2005019373, US7534505, US7445855, US20070190359, US20080297033, US7338722, US20020134984, WO2005123873, WO2007004380, WO2006082742, US7279704, WO2006098120, WO2006103874, US20110057559, WO2011063083, US20110204333, US20110215710, WO2005076380, WO2010032663, WO2008140115, JP2012-069737, JP2011-181303, WO2007052431, JP2009-114086, WO2011134013, WO2011157339, WO2010086089, WO2009113646, WO2012020327, WO2011051404, US7544426, US6821645, JP2003-81988, JP 2002-302671, JP2002-363552, WO2011004639, and the like may be cited.

(2) Light emitting host compound (also referred to as a light emitting host and a host compound)

The host compound in the present invention is defined, among the compounds contained in the light emitting layer, as a compound in which a mass ratio in the layer concerned is 20% or more, and a phosphorescent quantum yield of the phosphorescent light emission is less than 0.1 at room temperature (25°C). Preferably, the phosphorescent quantum yield is less than 0.01. Moreover, preferably, the mass ratio of the host compound in the light emitting layer is 20% or more among the compounds contained in the light emitting layer.

The light emitting host usable in the present invention is not particularly limited, and as the light emitting host concerned, a compound heretofore used in the organic EL element can be used. Representatively, there are mentioned those having basic structures such as carbazole derivatives, triarylamine derivatives, aromatic derivatives, nitrogen-containing heterocyclic compounds, thiophene derivatives, furan derivatives, and oligoarylene compounds, or carboline derivatives, diazacarbazole derivatives (here, the diazacarbazole derivatives represent those in which a nitrogen atom is substituted for at least one carbon atom in a hydrocarbon ring that composes a carboline ring of the carboline derivatives) or the like.

As the publicly known light emitting host usable in the present invention, such a compound is preferable, which prevents elongation of a wavelength of the light emission while having a hole transport capacity and an electron transport capacity, and further, has a high glass transition temperature (Tg).

Moreover, in the present invention, the light emitting host heretofore known in public may be used singly, or plural types thereof may be used in combination. By using the plural types of light emitting hosts, it is possible to adjust transfer of the electric charges, and the efficiency of the organic EL element can be enhanced. Furthermore, by using plural types of the metal complexes and/or the compounds heretofore known in public, which are to be used as the above-described phosphorescent dopants, it becomes possible to mix different light emissions with each other, whereby an arbitrary light emission color can be obtained.

Moreover, the light emitting host for use in the present invention may be a low molecular weight compound, or a polymer compound having a repetition unit, or a low molecular weight compound having a polymeric group such as a vinyl group and an epoxy group (that is, a polymeric light emitting host), and a single type or plural types of such compounds as described above may be used.

As specific examples of the publicly known light emitting host, compounds described in the following literatures are mentioned.

Japanese Patent Laid-Open Publications Nos. 2001-257076, 2002-308855, 2001-313179, 2002-319491, 2001-357977, 2002-334786, 2002-8860, 2002-334787, 2002-15871, 2002-334788, 2002-43056, 2002-334789, 2002-75645, 2002-338579, 2002-105445, 2002-343568, 2002-141173, 2002-352957, 2002-203683, 2002-363227, 2002-231453, 2003-3165, 2002-234888, 2003-27048, 2002-255934, 2002-260861, 2002-280183, 2002-299060, 2002-302516, 2002-305083, 2002-305084, 2002-308837, and the like.

Specific examples to be used as the light emitting host of the light emitting layer of the organic EL element of the present invention are mentioned below; however, the present invention is not limited to these.

OC−1

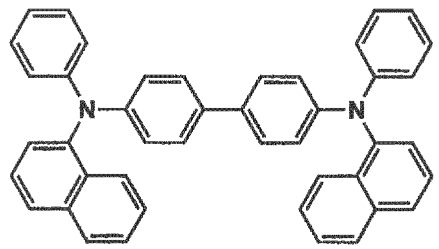

OC−2

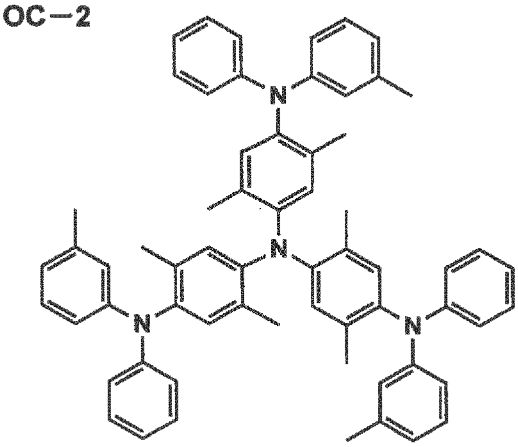

OC−3

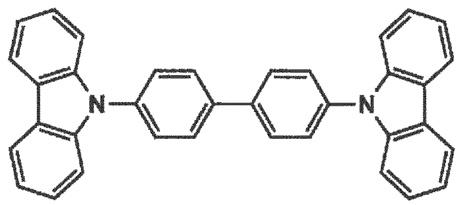

OC−4

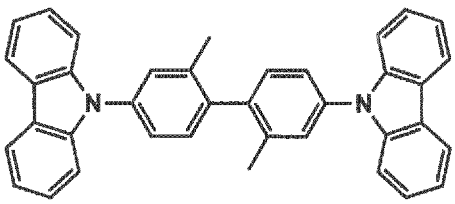

OC−5

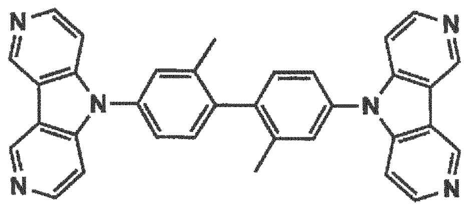

OC-6

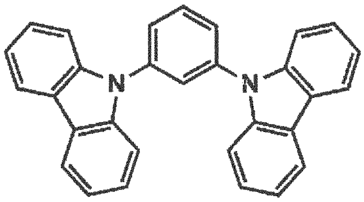

OC-7

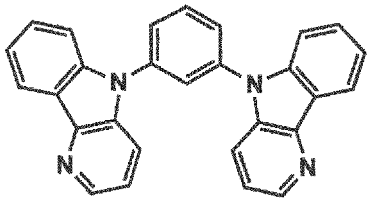

OC-8

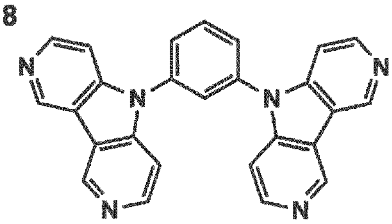

OC-9

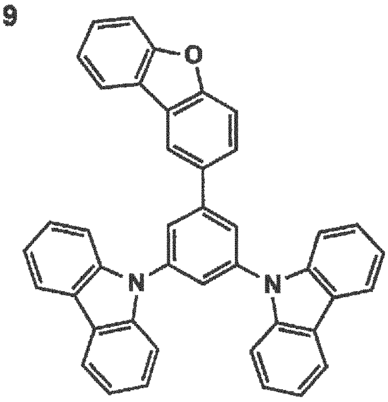

OC-10

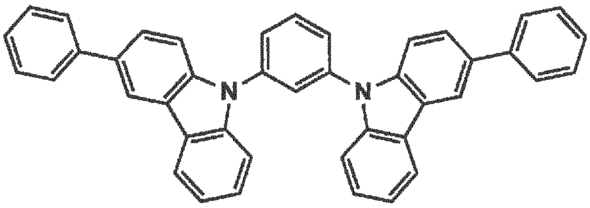

OC-11

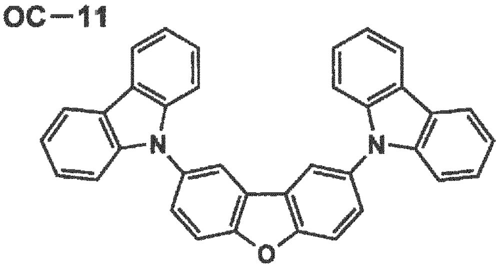

OC-12

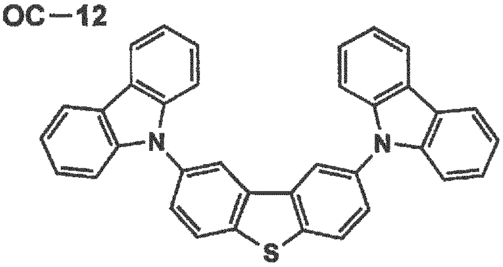

OC-13

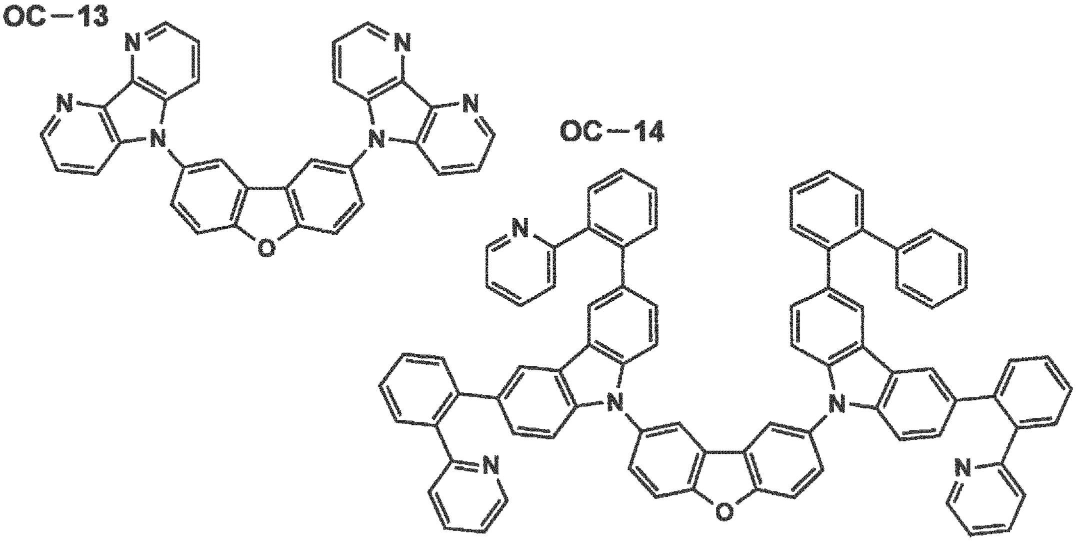

OC-14

OC−15

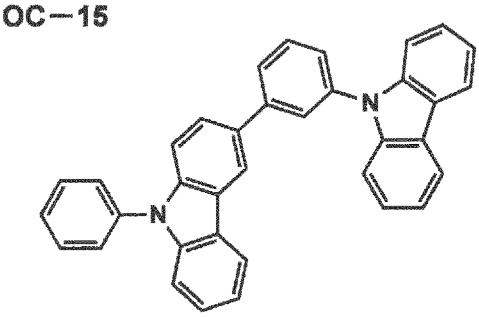

OC−16

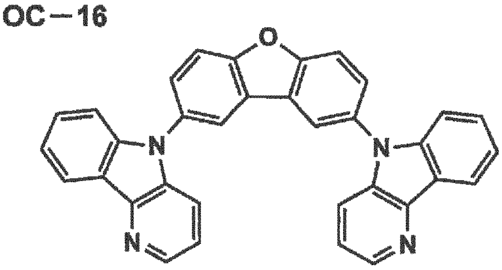

OC−17

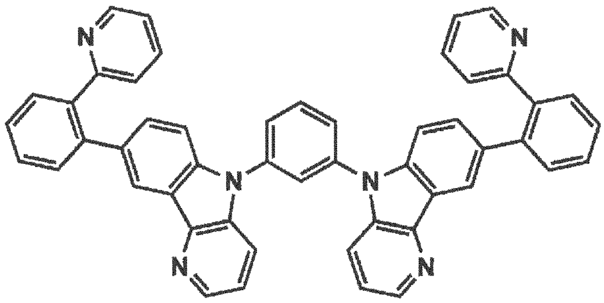

OC−18

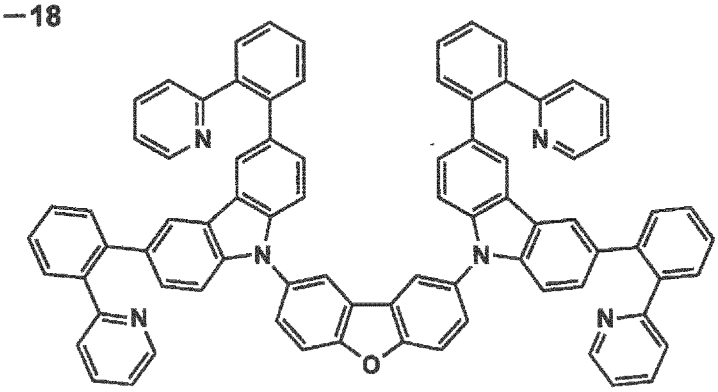

OC−19

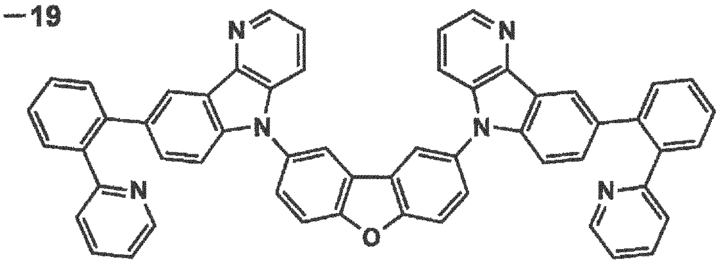

OC−20

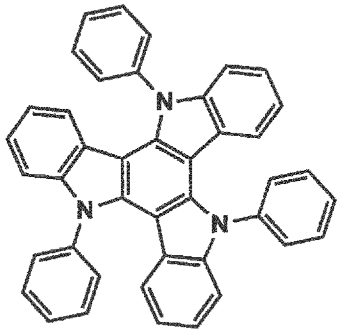

OC−21

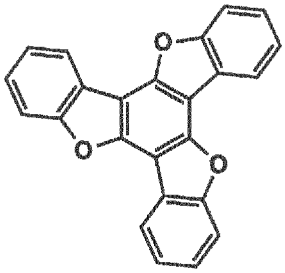

OC−22

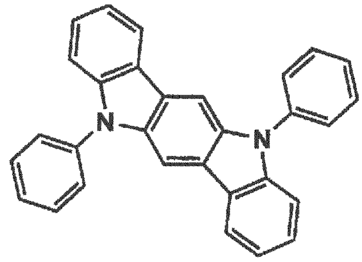

OC−23

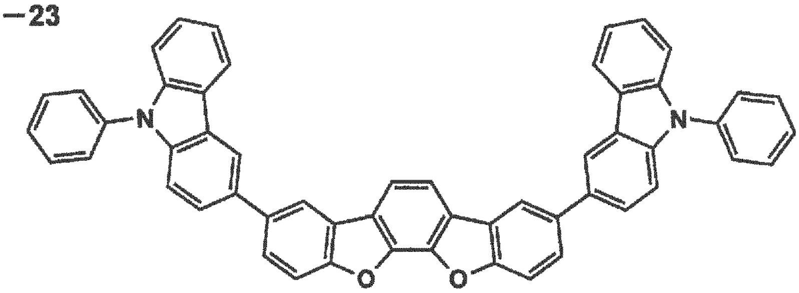

OC−24

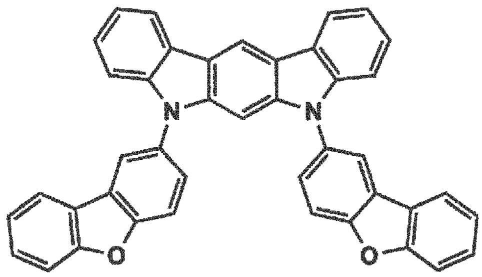

OC−25

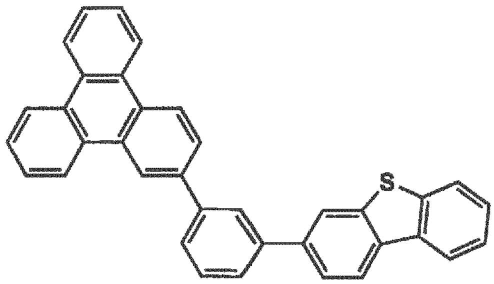

OC−26

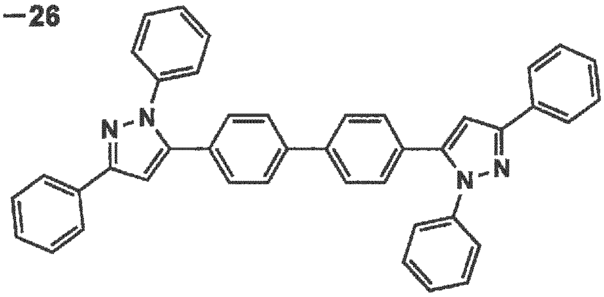

OC−27

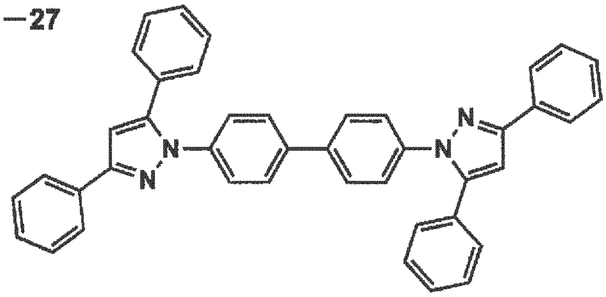

OC−28

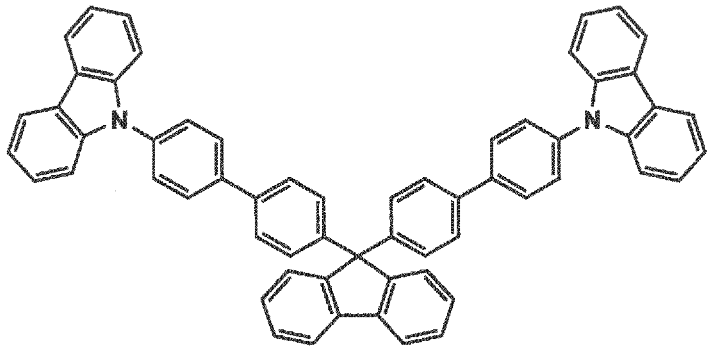

OC−29

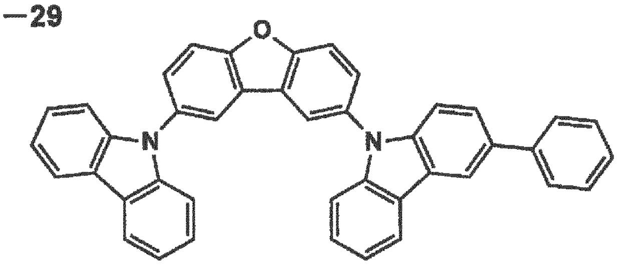

OC−30

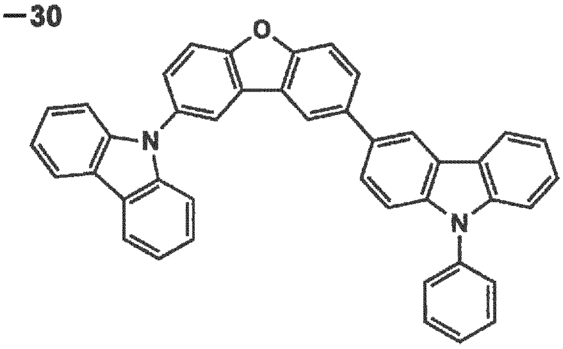

OC−31

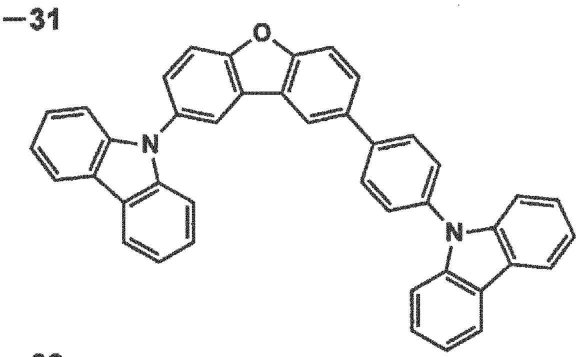

OC−32

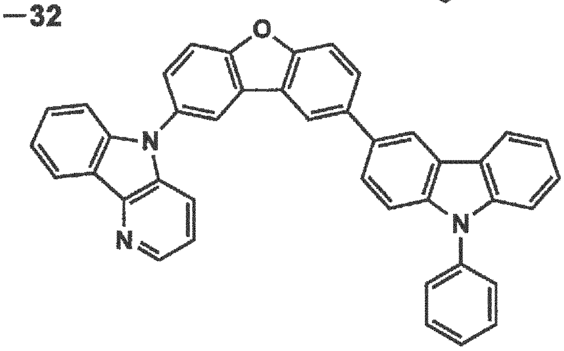

Moreover, a particularly preferable one as the light emitting host of the light emitting layer of the organic EL element of the present invention is a compound represented by the following general formula (B) or general formula (E).

[general formula (B)]

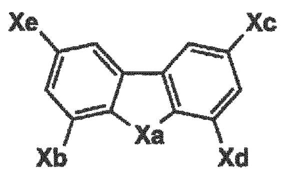

[general formula (E)]

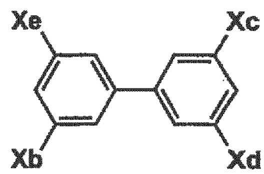

In the general formulae (B) and (E), Xa represents 0 or S, each of Xb, Xc, Xd and Xe represents a hydrogen atom, a substituent or a group represented by the following general formula (C), at least one of Xb, Xc, Xd and Xe represents the group represented by the following general formula (C), and in at least one of groups represented by the following general formula (C), Ar represents a carbazolyl group.

General formula (C) $Ar\text{-}(L_4)n\text{-}*$

In the general formula (C), $L_4$ represents a divalent bonded group to be derived from the aromatic hydrocarbon ring or the aromatic heterocyclic ring. n represents an integer of 0 to 3, and in the case where n is 2 or more, a plurality of $L_4$ may be the same or different. * represents a bonded region to the general formula (B) or (E). Ar represents a group represented by the following general formula (D).

[general formula (D)]

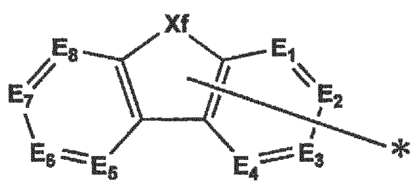

In the general formula (D), Xf represents N(R"), O or S, E1 to E8 represent C(R"$_1$) or N, and each of R" and R"$_1$ represents a hydrogen atom, a substituent or a bonded region to $L_4$ in the general formula (C). * represents the bonded region to $L_4$ in the general formula (C).

In the compound represented by the above-described general formula (B), preferably, at least two of Xb, Xc, Xd and Xe are represented by the general formula (C), more preferably, Xc is represented by the general formula (C), and Ar in the general formula (C) represents a carbazolyl group that may have a substituent.

Mentioned below are specific examples of the compound, which is represented by the general formula (B), and is preferably used as the host compound (also referred to as a light emitting host) of the light emitting layer of the organic EL element of the present invention; however, the present invention is not limited to these.

1

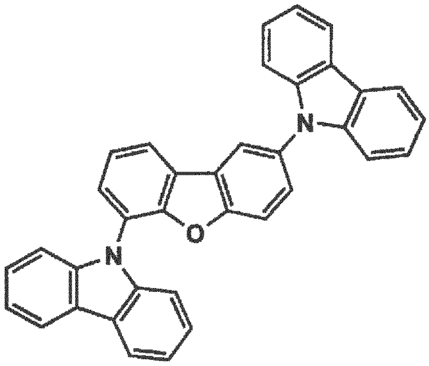

2

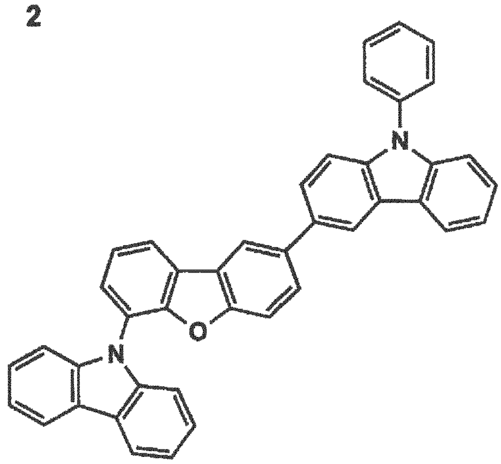

3

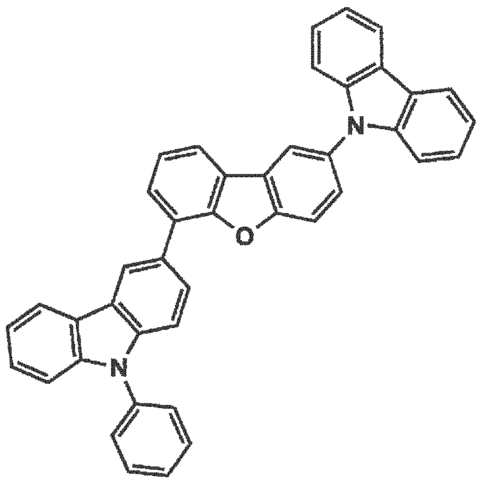

4

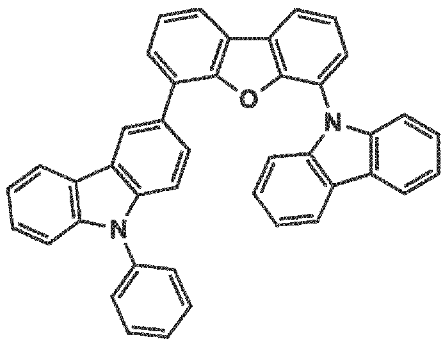

5

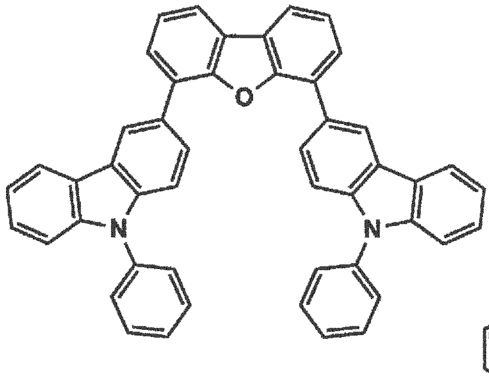

6

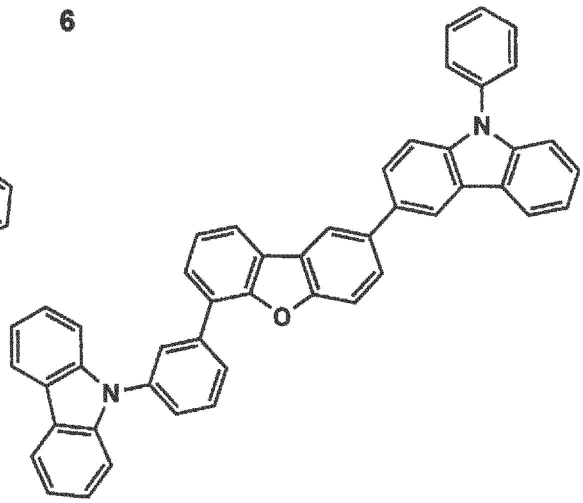

7

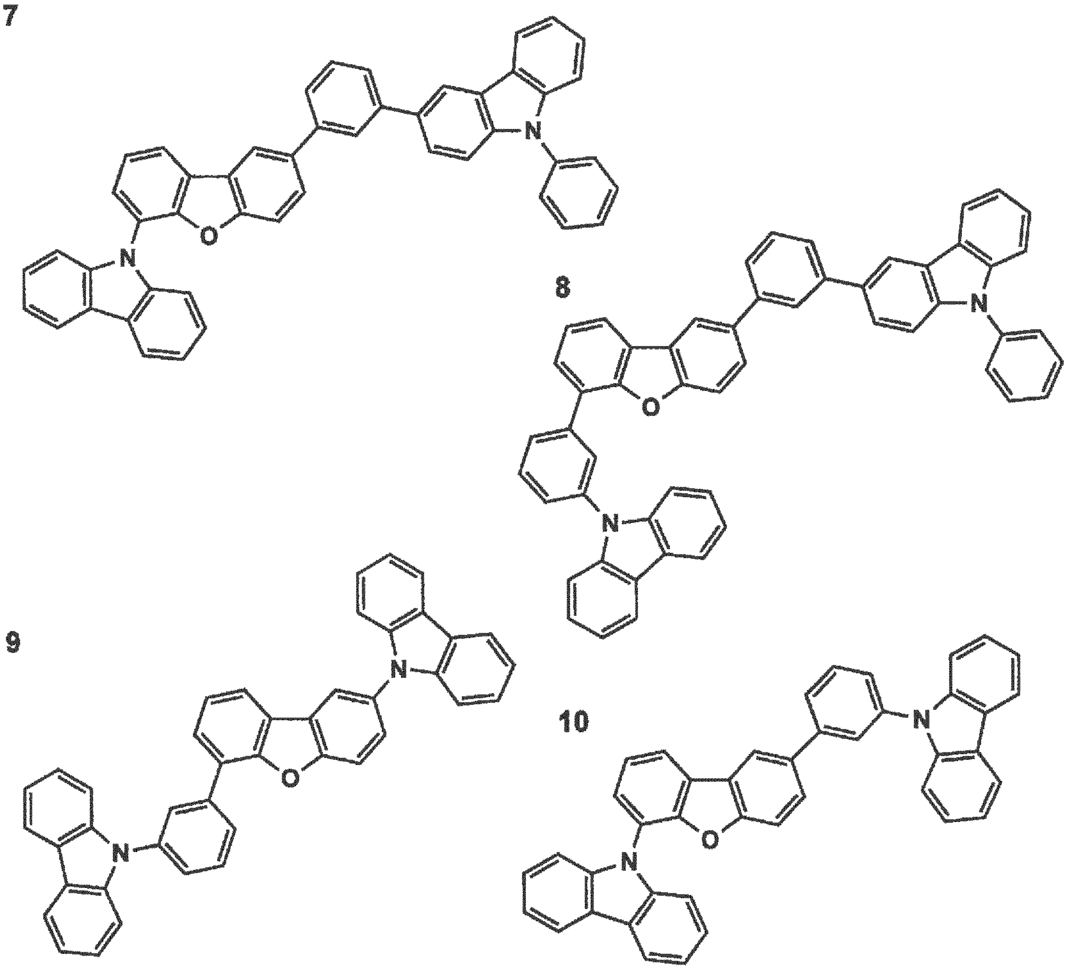

8

9

10

11

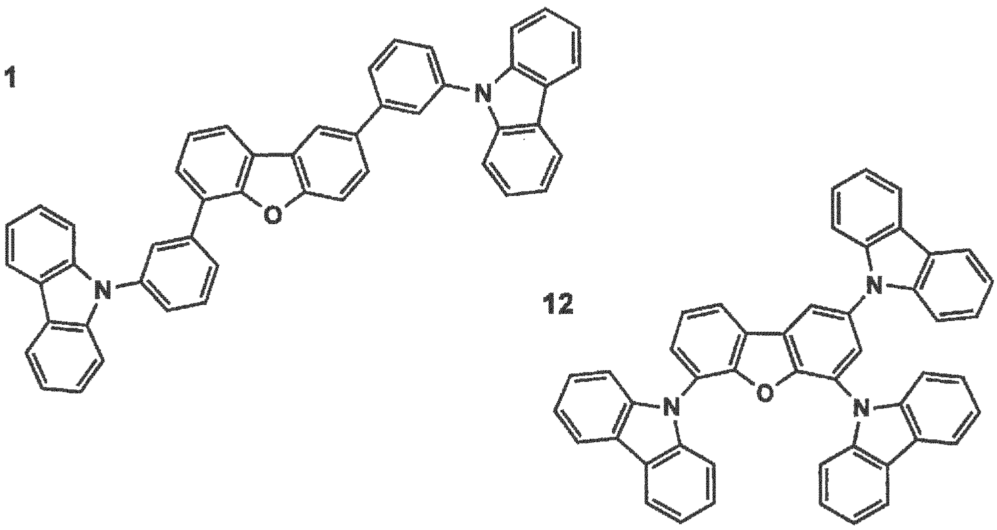

12

13

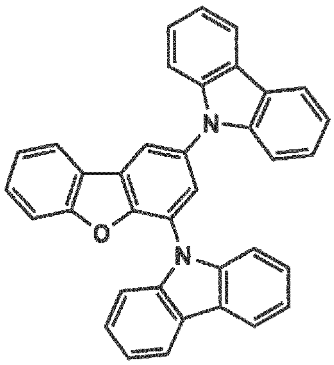

14

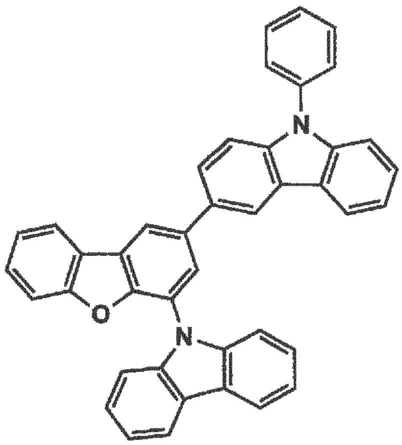

15

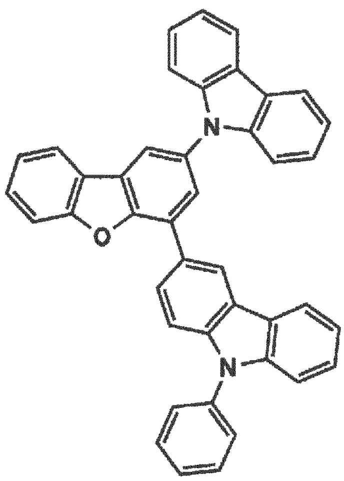

16

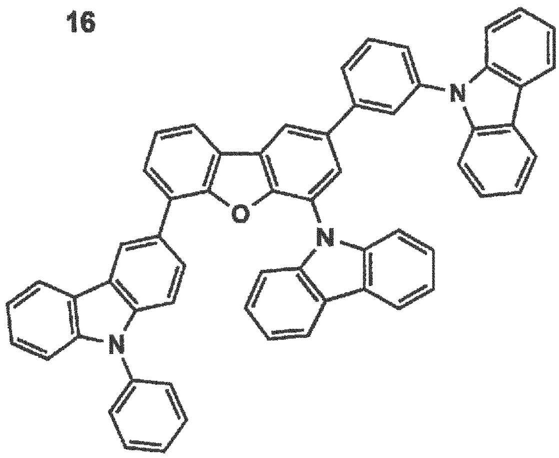

17

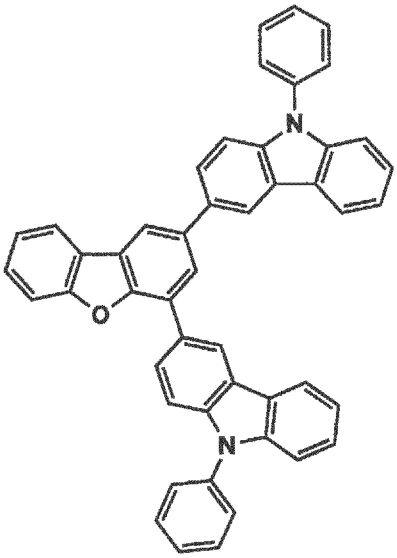

18

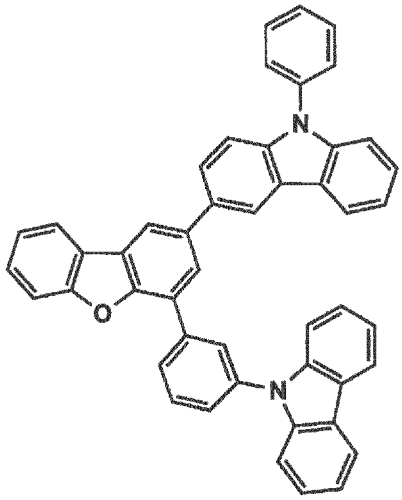

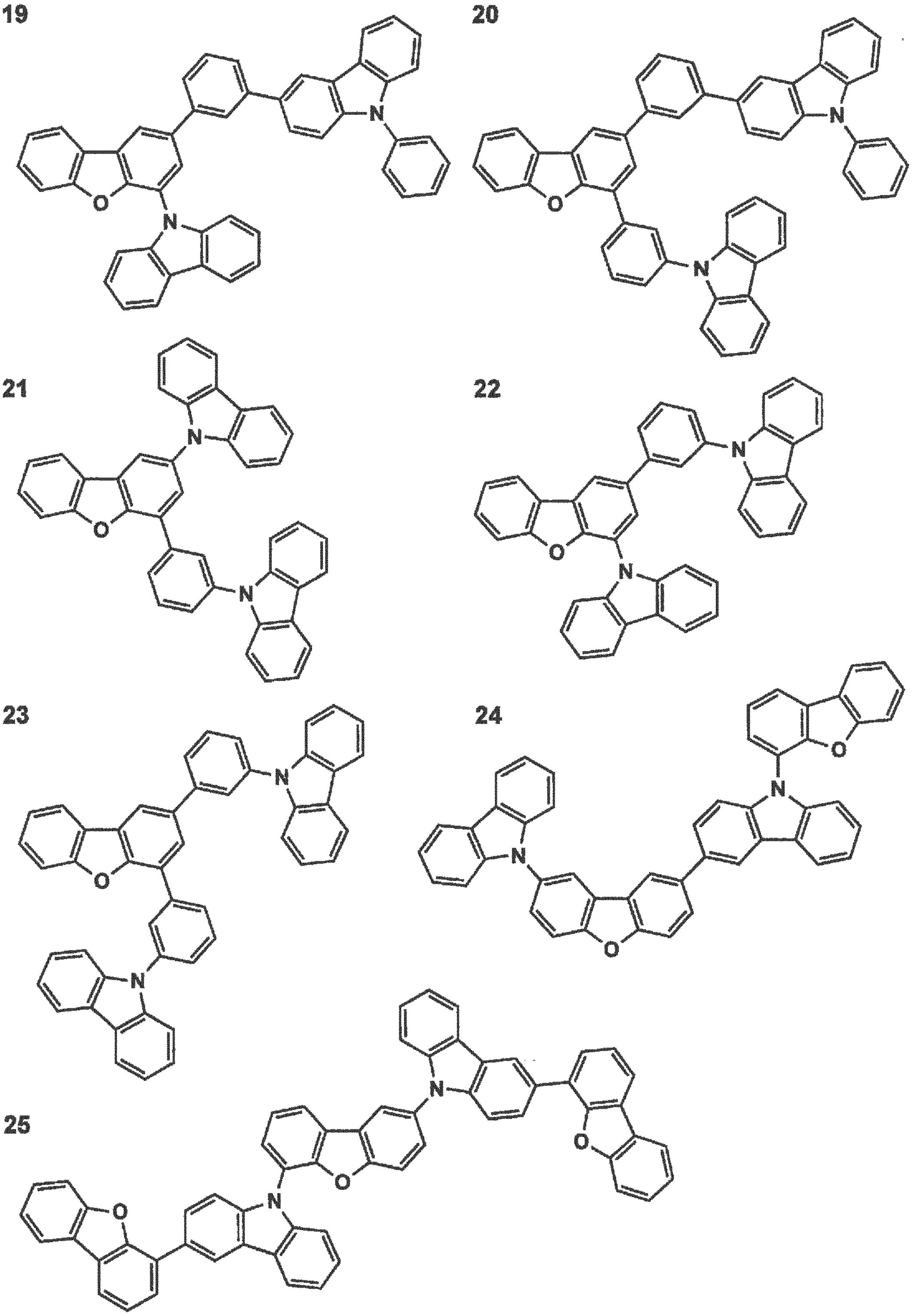

19

20

21

22

23

24

25

26

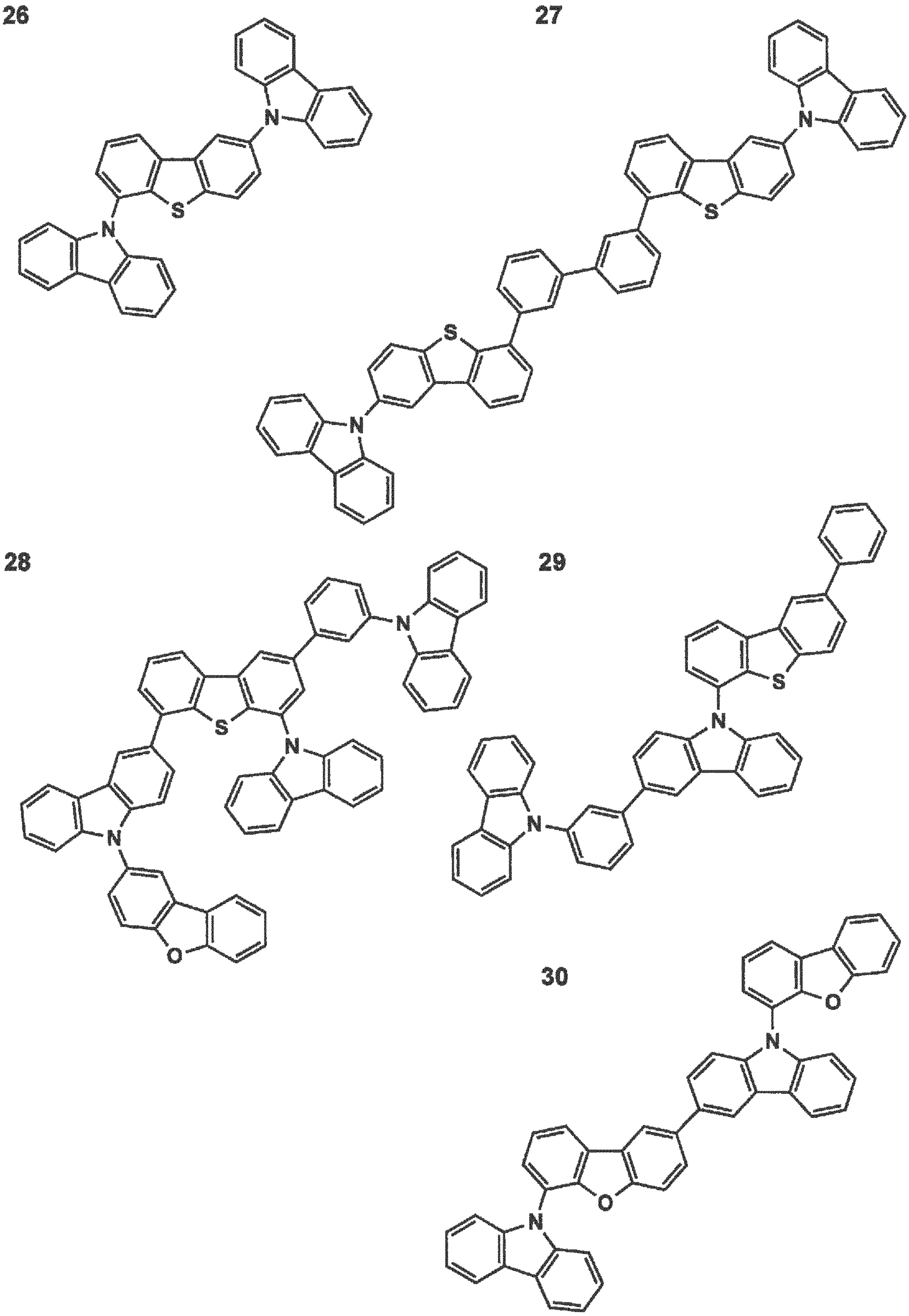

27

28

29

30

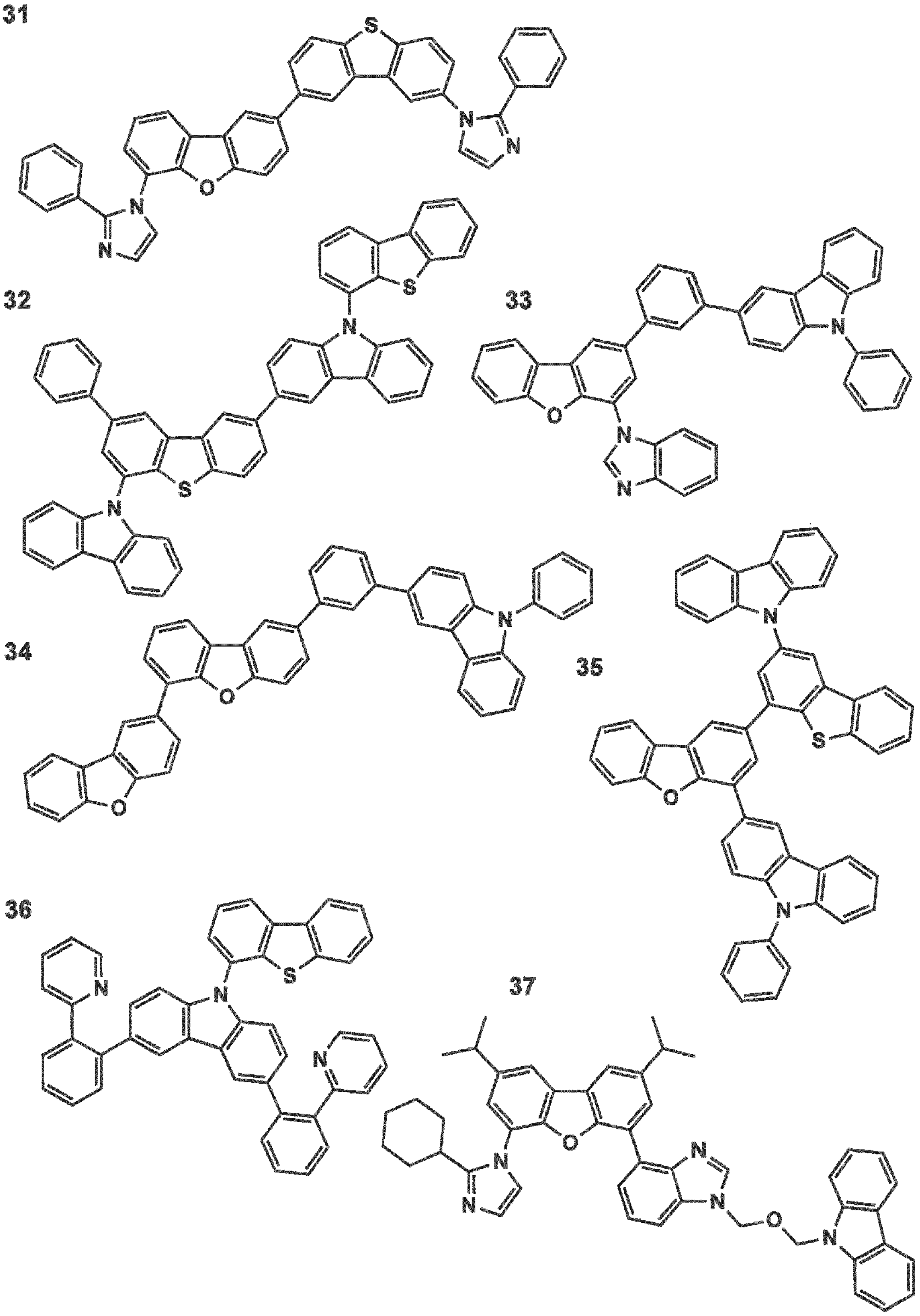

31

32

33

34

35

36

37

38

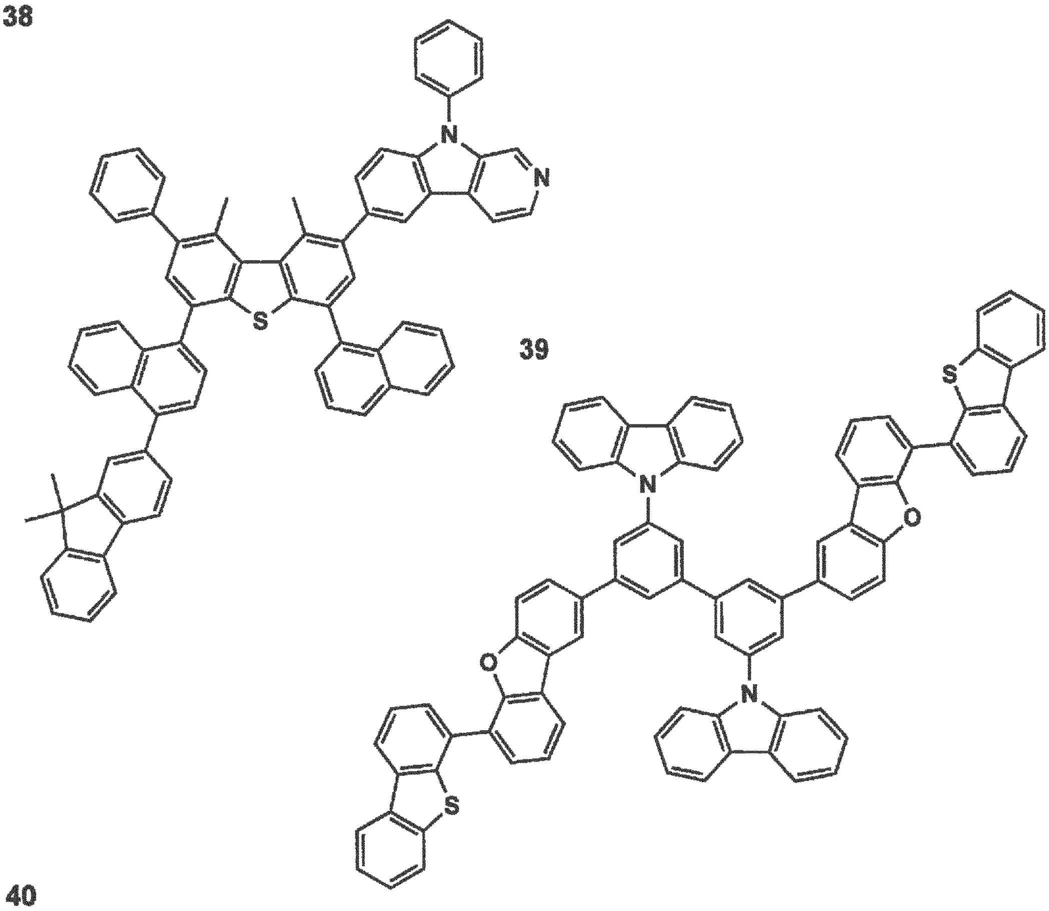

39

40

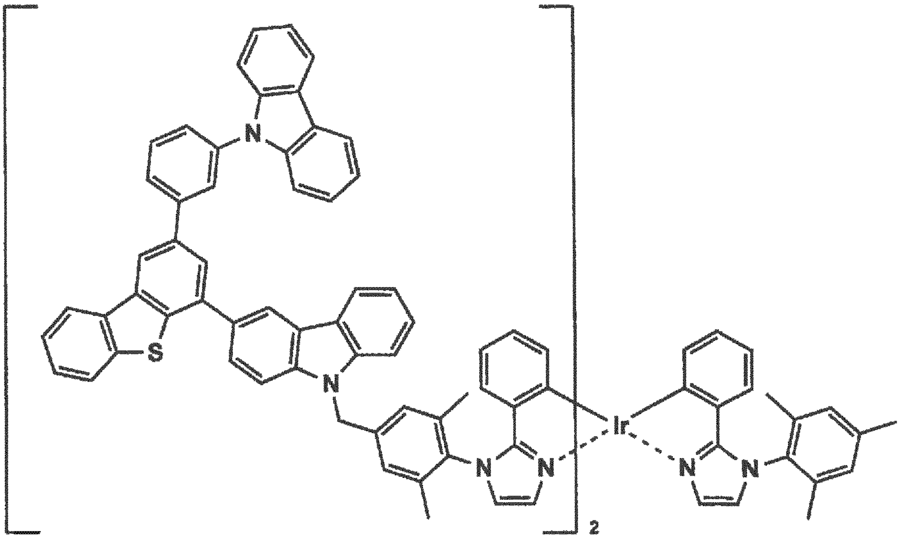

41

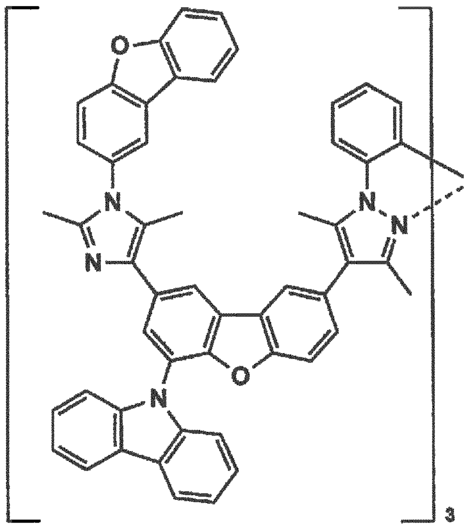

42

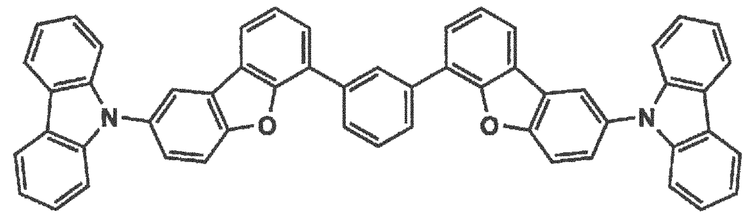

43

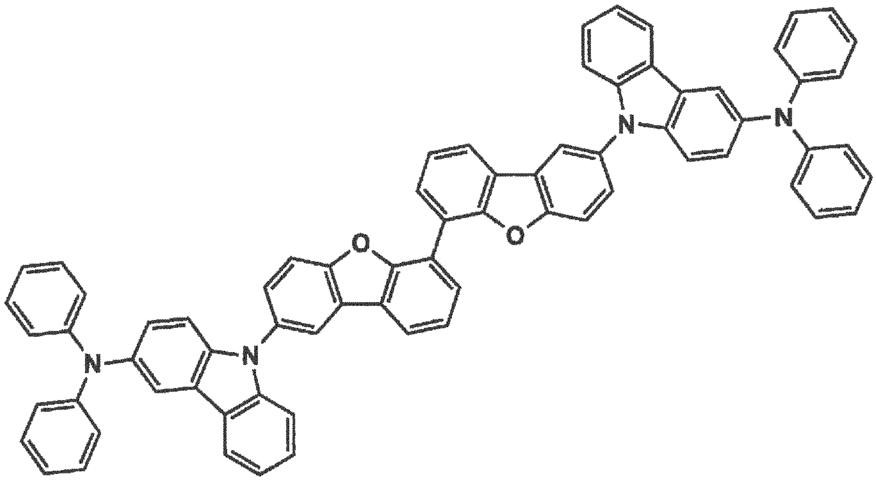

44

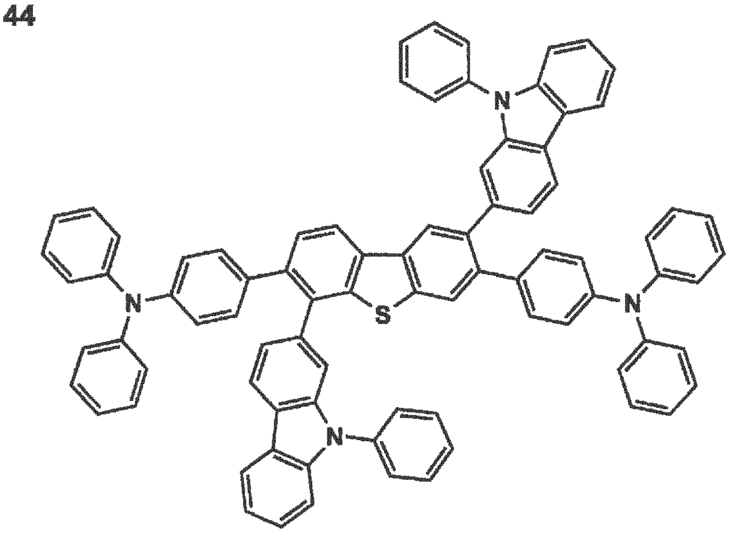

45

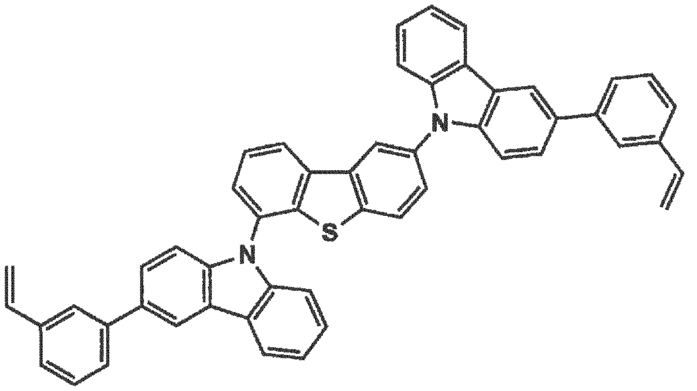

46

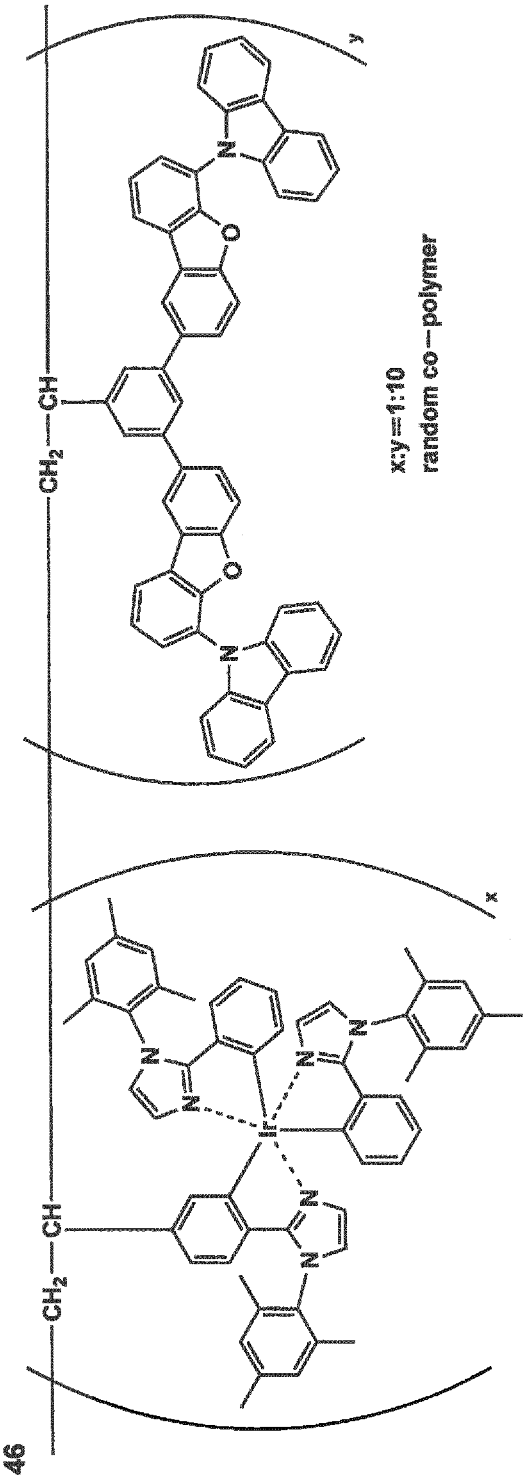


47

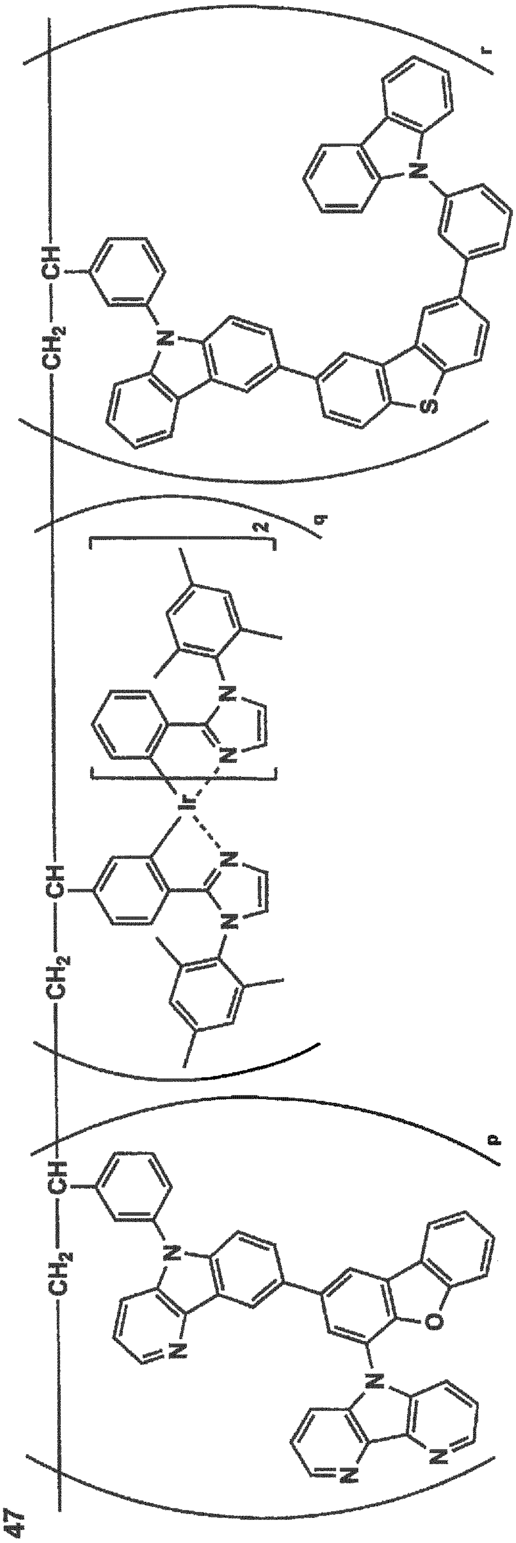

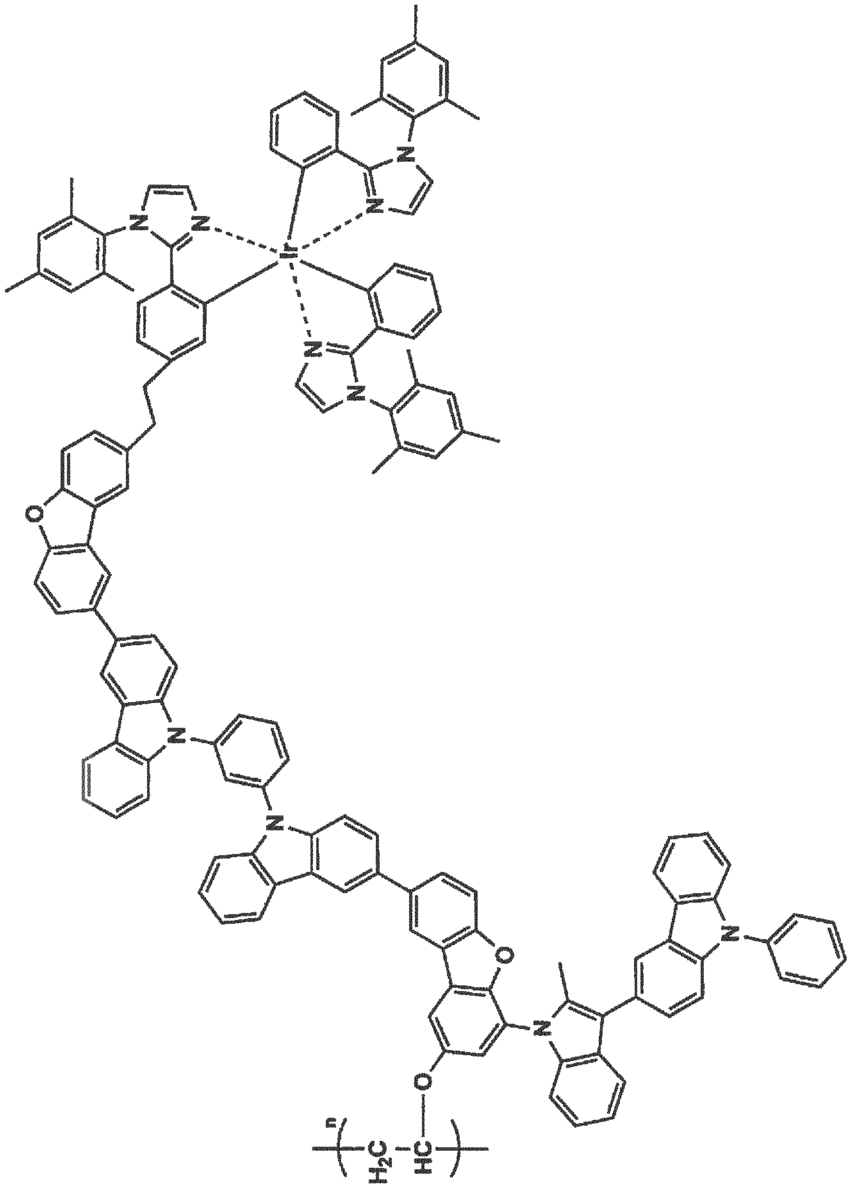

48

49

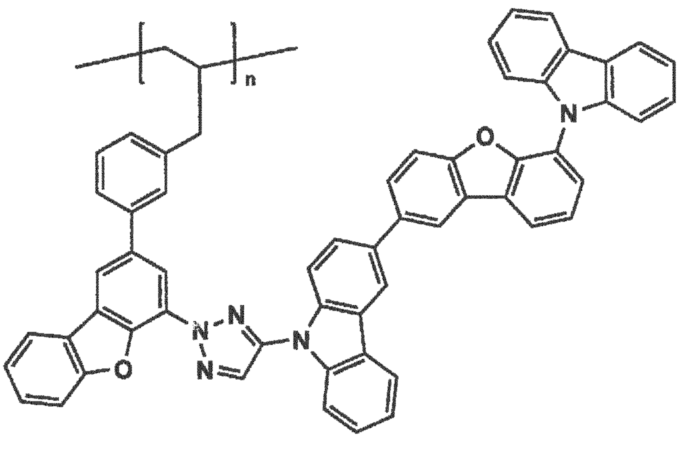

50

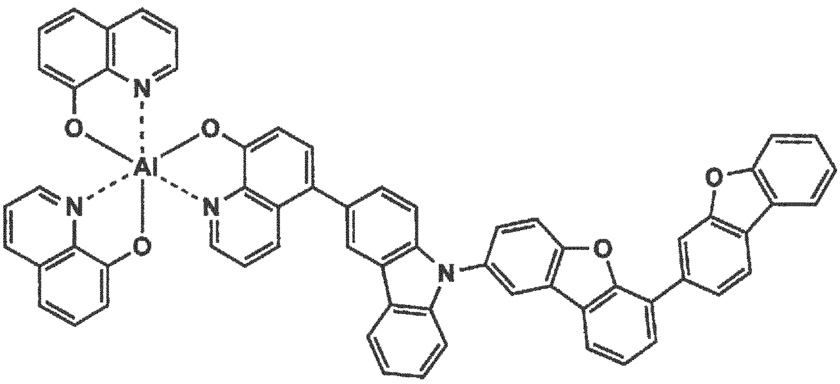

51

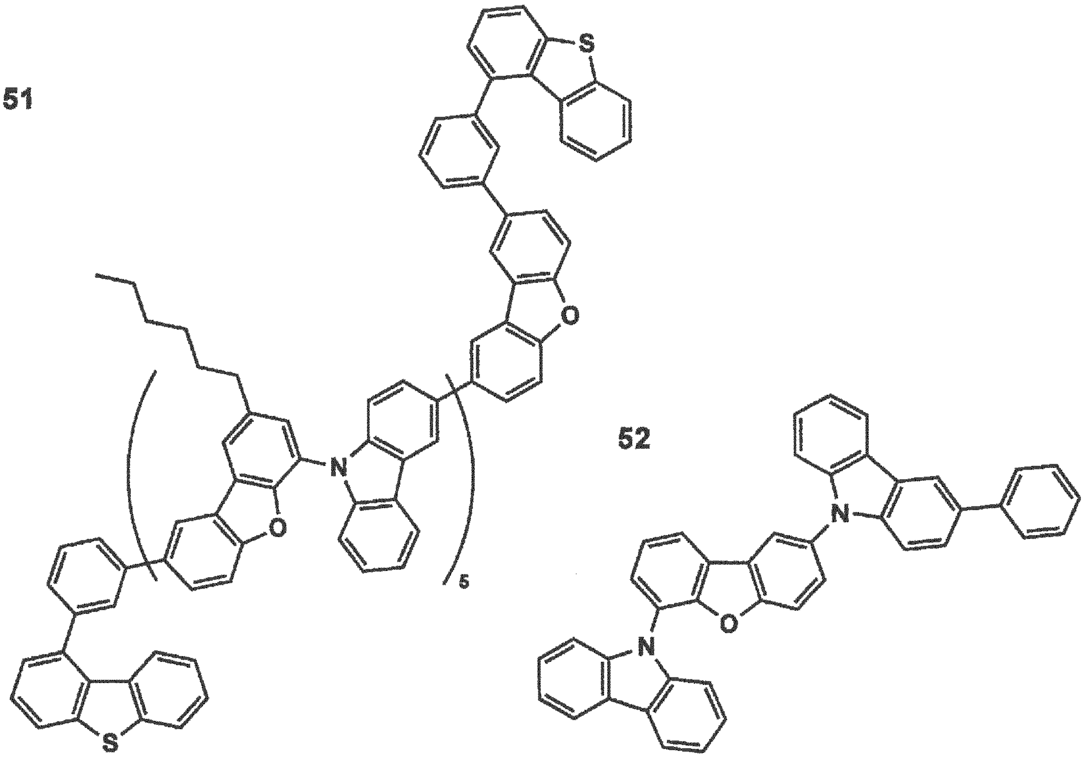

52

53

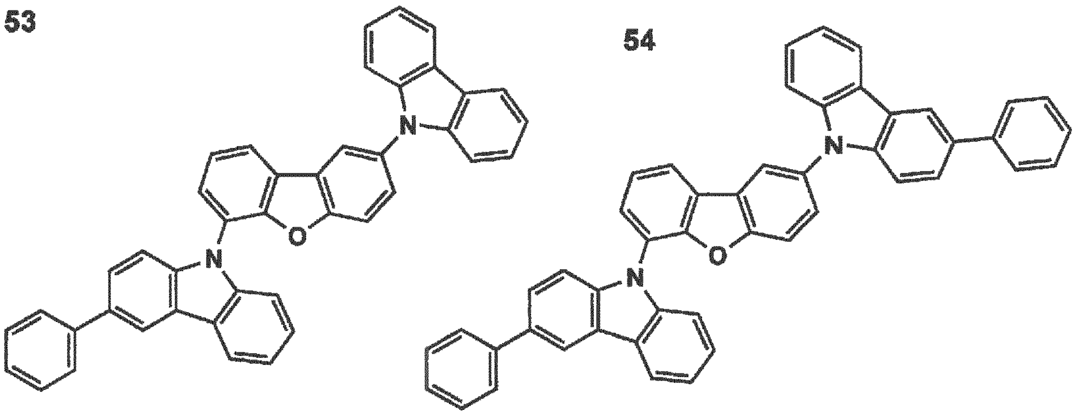

54

55 56

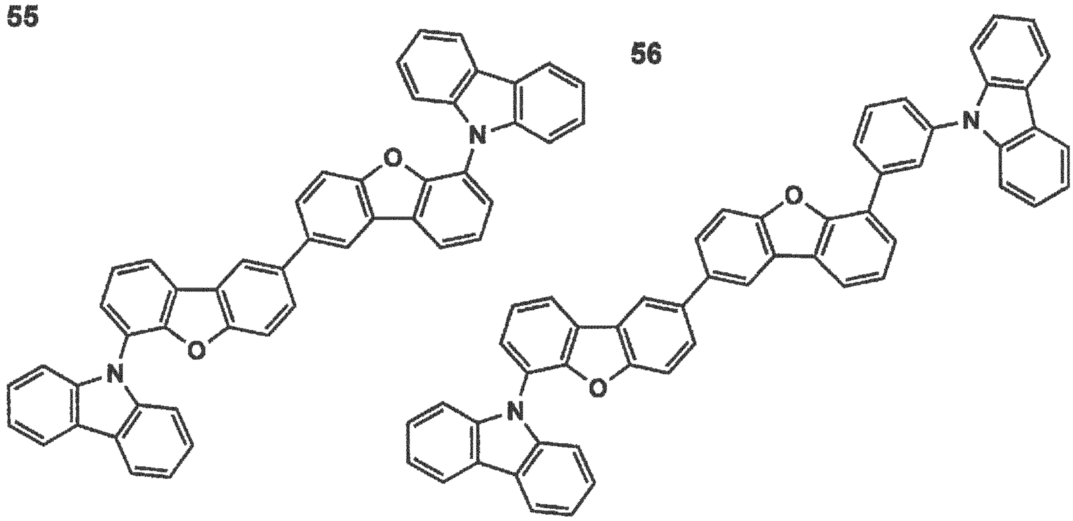

57

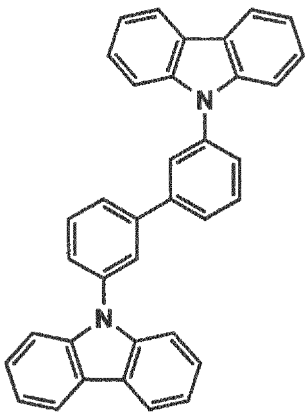

58

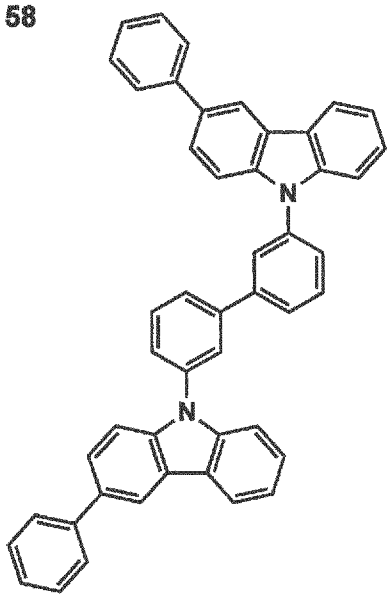

59

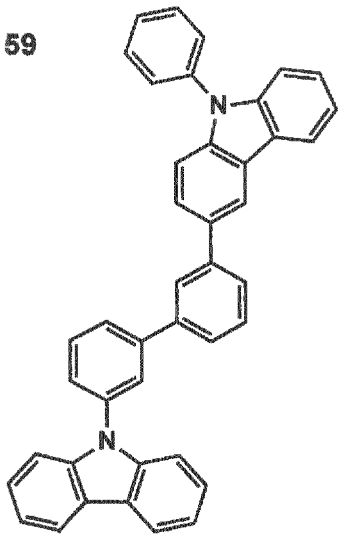

Moreover, as the light emitting host of the light emitting layer of the organic EL element of the present invention, a compound represented by the following general formula (B') is also particularly preferably used.

[general formula (B')]

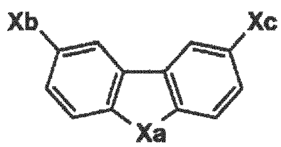

In the general formula (B'), Xa represents O or S, and each of Xb and Xc represents a substituent or a group represented by the above-described general formula (C).

At least one of Xb and Xc represents the group represented by the above-described general formula (C), and in at least one of the groups represented by the general formula (C) concerned, Ar represents a carbazolyl group.

In the compound represented by the above-described general formula (B'), preferably, Ar in the general formula (C) represents a carbazolyl group that may have a substituent, more preferably, Ar in the general formula (C) represents a carbazolyl group, which may have a substituent, and is bonded to $L_4$ in the general formula (C) at an N-th order.

As the compound represented by the general formula (B') to be preferably used as the host compound (also referred to as the light emitting host) of the light emitting layer of the organic EL element of the present invention, specifically, there are mentioned OC-9, OC-11, OC-12, OC-14, OC-18, OC-29, OC-30, OC-31, and OC-32, which are previously mentioned as the specific examples to be used as the light emitting host; however, the present invention is not limited to these.

«Electron transportation layer»

The electron transportation layer is made of a material having a function to transport electrons, and in a broad sense, an electron injection layer and the hole blocking layer are also included in the electron transportation layer. With regard to the electron transportation layer, a single layer or plural layers thereof can be provided.

The electron transportation layer just needs to have a function to transmit the electrons, which are injected from the cathode, to the light emitting layer, and as constituent materials of the electron transportation layer, it is also possible to select arbitrary ones from among the compounds heretofore known in public, and to use the ones in combination.

As such materials, which are heretofore known in public and are to be used for the electron transportation layer (the materials are hereinafter referred to as electron transportation materials), there are mentioned nitro-substituted fluorene derivatives, diphenylquinone derivatives, thiopyran dioxide derivatives, polycyclic aromatic hydrocarbon such as naphthalene perylene, heterocyclic tetracarbonic acid anhydride, carbodiimide, fluorenylidene methane derivatives, anthraquinodimethane and anthrone derivatives, oxadiazole derivatives, carboline derivatives, or derivatives having a ring system in which a nitrogen atom is substituted for at least one carbon atom in a hydrocarbon ring that composes a carboline ring of the carboline derivatives concerned, hexaazatriphenylene derivatives, or the like.

Moreover, as the electron transportation materials, there can also be used: thiadiazole derivatives in which a sulfur atom is substituted for an oxygen atom of an oxadiazole ring in the above-described oxadiazole derivatives; and quinoxaline derivatives having a quinoxaline ring known as an electron withdrawing group.

Polymer materials can also be used, in which these materials are introduced into polymer chains, or in which these materials are used as principal chains of polymers.

Moreover, as the electron transportation materials, there can also be used: metal complexes of 8-quinolinol derivatives, for example, such as tris(8-quinolinol)aluminum (Alq), tris(5,7-dichloro-8-quinolinol)aluminum, tris(5,7-dibromo-8-quinolinol)aluminum, tris(2-methyl-8-quinolinol)aluminum, tris(5-methyl-8-quinolinol)aluminum, and bis (8-quinolinol) zinc (Znq); and metal complexes in which In, Mg, Cu, Ca, Sn, Ga or Pb is substituted for center metals of these metal complexes.

Besides, metal-free or metal phthalocyanine, or those in which an alkyl group, a sulfonic acid group and the like are substituted for ends thereof can also be used as the electron transportation materials.

Moreover, an inorganic semiconductor such as an n-type Si and an n-type SiC can also be used as the electron transportation layer.

Preferably, the electron transportation layer is formed by thinning the electron transportation material, for example, by a vacuum evaporation method, a wet method and the like. The wet method is also referred to as a wet process, and for example, there can be mentioned a spin coat method, a cast method, a die coat method, a blade coat method, a roll coat method, an ink-jet method, a printing method, a spray coat method, a curtain coat method, a Langmuir Blodgett method (LB method), and the like.

A film thickness of the electron transportation layer is not particularly limited; however, in usual, approximately ranges from 5 nm to 5000 nm, preferably, ranges from 5 nm to 200 nm. This electron transportation layer may have a single layer structure made of one or two or more types of the above-described materials.

Moreover, an n-type dopant such as a metal compound such as the metal complex and metal halide may be used by being doped.

Further, as compounds (electron transportation materials, which are heretofore known in public and are preferably used for forming the electron transportation layer of the white organic EL element of the present invention, there are mentioned compounds and the like described in the following Patent Publications; however, the present invention is not limited to these.

For example, US20050025993, WO2008132085, WO2003060956, US7230107, US6S28187, US20090179554, US20090115316, US20090101870, US20040036077, JP2010-251675, JP2009-209133, JP2009-124114, JP2008-277810, JP2006-156445, JP2005-340122, JP2003-45662, JP2003-31367, JP2003-282270, WO2011086935, WO2010150593, WO2010047707, WO2009069442, WO2009066779, WO2009054253, WO2008114690, WO2007/086552, WO2006067931, WO2005085387, WO2004080975, WO2004063159, US7964293, US2009030202, EP2311826, JP Application 2011-272858, and the like may be cited.

«Cathode»

Meanwhile, as the cathode, one is used, which uses metal (referred to as electron injective metal) with a small work function (4 eV or less), an alloy, an electric conductive compound, or a mixture of these, as an electrode substance. As specific examples of the electrode substances as described above, there are mentioned sodium, a sodium-potassium alloy, magnesium, lithium, a magnesium/copper mixture, a magnesium/silver mixture, a magnesium/aluminum mixture, a magnesium/indium mixture, an aluminum/aluminum oxide ($Al_2O_3$) mixture, indium, a lithium/aluminum mixture, rare earth metal and the like. Among them, from viewpoints of electron injection property and durability against oxidation and the like, suitable is a mixture of the electron injective metal and second metal as stable metal with a larger work function than that of the electron injective metal, for example, the magnesium/silver mixture, the magnesium/aluminum mixture, the magnesium/indium mixture, the aluminum/aluminum oxide ($Al_2O_3$) mixture, the lithium/aluminum mixture, the aluminum, or the like.

The cathode can be fabricated by forming a thin film from these electrode substances by a method such as evaporation and sputtering. Moreover, preferably, a resistance of a sheet as the cathode is several hundred Ω/□ or less, and a film thickness thereof is selected usually from a range of 10 nm to 5 μm, preferably from a range of 50 nm to 200 nm.

Note that, in order to allow transmission of the emitted light, either one of the anode and cathode of the organic EL element is made transparent or translucent. Then, this is advantageous since the light emission brightness is enhanced.

Moreover, on the cathode, the above-described metal is fabricated with a film thickness of 1 nm to 20 nm, and thereafter, a conductive transparent material to be mentioned in the later description of the anode is fabricated thereon, whereby the transparent or translucent cathode can be fabricated. By applying this fabrication, an element in which both of the anode and the cathode have transmittance can be fabricated. «Injection layers: electron injection layer (cathode buffer layer), hole injection layer»

The injection layers are provided according to needs, in which the electron injection layer and the hole injection layer are included. As described above, the injection layers may be allowed to exist between the anode and the light emitting layer or the hole transportation layer, and between the cathode and the light emitting layer or the electron transportation layer.

The injection layers stand for layers to be provided between the electrodes and the organic layers in order to decrease the drive voltage and to enhance the light emission brightness. The injection layers concerned are described in detail in "Electrode Material", pp. 123 to 166, in 2nd chapter of "Organic EL Element and Front Line of Industrialization Thereof, 2nd edition, issued by NTS Inc. on November 30, 1998". In the injection layers, the hole injection layer (anode buffer layer) and the electron injection layer (cathode buffer layer) are included.

Details of the anode buffer layer (hole injection layer) are also described in Japanese Patent Laid-Open Publications Nos. H09-45479 (published in 1997), H09-260062, H08-288069 (published in 1996), and the like. As specific examples of the anode buffer layer, there are mentioned: a phthalocyanine buffer layer represented by copper phthalocyanine; a hexaazatriphenylene derivative buffer layer as described in Japanese Unexamined Patent Application Publication No. 2003-519432 and Japanese Patent Laid-Open Publication No. 2006-135145; an oxide buffer layer represented by vanadium oxide; an amorphous carbon buffer layer; a polymer buffer layer using a conductive polymer such as polyaniline (emeraldine) and polythiophene; an ortho-metalated complex layer represented by a tris(2-phenylpyridine)iridium complex; and the like.

Details of the cathode buffer layer (electron injection layer) are also described in Japanese Patent Laid-Open Publications Nos. H06-325781 (published in 1994), H09-17574 (published in 1997), H10-74586 (published in 1998), and the like. Specifically, there are mentioned: a metal buffer layer represented by strontium, aluminum and the like; an alkali metal compound buffer layer represented by lithium fluoride and potassium fluoride; an alkali earth metal compound buffer layer represented by magnesium fluoride and cesium fluoride; an oxide buffer layer represented by aluminum oxide; and the like. Desirably, the above-described buffer layer (injection layer) is an extremely thin layer, and though depending on a material thereof, preferably, a film thickness thereof ranges from 0.1 nm to 5 μm.

«Blocking layer: hole blocking layer; electron blocking layer»

The blocking layer is a layer to be provided according to needs besides the basic constituent layers of the organic compound thin film formed as described above. For example, there are hole blocking (hole block) layers described in Japanese Patent Laid-Open Publications Nos. H11-204258 (published in 1999) and H11-204359, "Organic EL element and Front Line of Industrialization Thereof, p. 237, issued by NTS Inc. on November 30, 1998", and the like.

The hole blocking layer has a function of the electron transportation layer in a broad sense, is made of a hole blocking material that has a significantly small capability of transporting holes while having a function to transport electrons, and blocks the holes while transporting the electrons, and can thereby enhance the recombination probability between the electrons and the holes.

Moreover, according to needs, the configuration of the above-mentioned electron transportation layer can be used as the hole blocking layer.

Preferably, the hole blocking layer of the organic EL element of the present invention is provided adjacent to the light emitting layer.

Preferably, the hole blocking layer contains the carbazole derivatives, the carboline derivatives, or the diazacarbazole derivatives, which are previously mentioned as the host compound. Here, the diazacarbazole derivatives represent those in which a nitrogen atom is substituted for any one of carbon atoms which compose the carboline ring.

Moreover, in the present invention, in the case where a plurality of the light emitting layers with a plurality of different light emitting colors are provided, preferably, such a light emitting layer in which a maximum light emitting wavelength is the shortest is nearest the anode among all of the light emitting layers. In such a case, preferably, the hole blocking layer is added and provided between such a shortest wavelength layer and a light emitting layer near the anode next to the layer concerned. Furthermore, preferably, with regard to 50 mass% or more of the compound contained in the hole blocking layer to be provided at the position concerned, an ionization potential thereof is larger by 0.3 eV or more with respect to that of the host compound of the above-described shortest wavelength light emitting layer.

The ionization potential is defined by energy necessary to emit electrons of the compound, which are located at a level of a highest occupied molecular orbital (HOMO), to a vacuum level. For example, the ionization potential can be obtained by such methods as shown below.

(1) The ionization potential can be obtained as a value (eV unit conversion value) calculated by performing structure optimization by using Gaussian98 (Gaussian98, Revision A. 11. 4, M. J. Frisch, et al, Gaussian, Inc., Pittsburgh Pa, 2002.) as molecular orbital calculation software made by Gaussian Inc. in the U.S.A., and using B3LYP/6-31G* as a keyword. The reason why a calculation value thus obtained is effective is that a correlation between the calculation value obtained by this method and an experimental value is high.

(2) The ionization potential can be obtained by a method of directly measuring the same by photoelectron spectroscopy. For example, "Model AC-1" as a low-energy electron spectrometer made by Riken Keiki Co. , Ltd. can be suitably used, or a method known as ultraviolet photoelectron spectroscopy can be suitably used.

Meanwhile, the electron blocking layer has a function of the hole transportation layer in a broad sense, is made of a material that has a significantly small capability of transporting electrons while having a function to transport holes, and blocks the electrons while transporting the holes, and can thereby enhance the recombination probability between the electrons and the holes.

Moreover, according to needs, a configuration of the hole transportation layer to be described later can be used as the electron blocking layer. A film thickness of the hole blocking layer and the electron transportation layer according to the present invention preferably ranges from 3 nm to 100 nm, and more preferably, 5 nm to 30 nm.

«Hole transportation layer»

The hole transportation layer is made of a hole transportation material that has a function to transport holes , and in a broad sense, the hole injection layer and the electron blocking layer are also included in the hole transportation layer. With regard to the hole transportation layer, a single layer or plural layers thereof can provided.

The hole transportation layer has either of hole injection or transportation property and electron barrier property, and may be either of organic matter and inorganic matter. For example, there are mentioned triazole derivatives, oxadiazole derivatives, imidazole derivatives, polyaryl alkane derivatives, pyrazoline derivatives and pyrazolone derivatives, phenylene diamine derivatives, aryl amine derivatives, amino-substituted chalcone derivatives, oxazole derivatives, styryl anthracene derivatives, fluorenone derivatives, hydrazine derivatives, stilbene derivatives, silazane derivatives, an aniline-based copolymer, and a conductive polymer oligomer, and particularly, a thiophene oligomer, and the like.

Moreover, in a similar way, such azatriphenylene derivatives as described in Japanese Unexamined Patent Application Publication No. 2003-519432 and Japanese Patent Laid-Open Publication No. 2006-135145 can also be used as the hole transportation material.

Those described above can be used as the hole transportation materials; however, it is preferable to use a porphyrin compound, an aromatic tertiary amine compound and a styryl amine compound, and is particularly preferable to use the aromatic tertiary amine compound.

As representative examples of the aromatic tertiary amine compound and the styryl amine compound, there are mentioned: N,N,N',N'-tetraphenyl-4,4'-diaminophenyl; N,N'-diphenyl-N,N'-bis(3-methylphenyl)-[1,1'-biphenyl]-4,4 '-diamine (TPD); 2,2-bis(4-di-p-tolylaminophenyl)propane; 1,1-bis(4-di-p-tolylaminophenyl)cyclohexane; N,N,N',N'-tetra-p-tolyl-4,4'-diaminobiphenyl; 1,1-bis(4-di-p-tolylaminophenyl)-4-phenylcyclohexane; bis(4-dimethylamino-2-methylphenyl)phenylmethane; bis(4-di-p-tolylaminophenyl)phenylmethane; N,N'-diphenyl-N,N'-di(4-methoxyphenyl)-4,4'-diaminobipheny 1; N,N,N',N'-tetraphenyl-4,4'-diaminodiphenylether; 4,4'-bis(diphenylamino)quaterphenyl; N,N,N-tri(p-tolyl)amine; 4-(di-p-tolylamino)-4'-[4-(di-p-tolylamino)styryl]stilbene ; 4-N,N-diphenylamino-(2-diphenylvinyl)benzene; 3-methoxy-4'-N,N-diphenylaminostilbene; N-phenylcarbazole; further, those described in US Patent No. 5,061,569, each of which has two fused aromatic rings in molecules, for example, 4,4'-bis[N-(1-naphthyl)-N-phenylamino]biphenyl (NPD); 4,4',4"-tris[N-(3-methylphenyl)-N-phenylamino]triphenylami ne (MTDATA), described in Japanese Patent Laid-Open Publication No. H04-308688, to which three triphenylamine units are coupled in a starburst form; and the like.

Moreover, polymer materials can also be used, in which these materials are introduced into polymer chains, or in which these materials are used as principal chains of polymers.

Moreover, an inorganic compound such as a p-type Si and a p-type SiC can also be used as the hole injection layer and the hole transportation layer.

Moreover, a so-called p-type hole transportation material as described in Japanese Patent Laid-Open Publication No. H11-251067 (published in 1999) and a literature (Applied Physics Letters 80 (2002), p. 139) written by J. Huang et. al. can also be used. In the present invention, it is preferable to use these materials since a light emitting element with higher efficiency is obtained.

The hole transportation layer can be formed by thinning the above-described hole transportation material by a publicly known method, for example, such as a vacuum evaporation method, a spin coat method, a cast method, a printing method including an ink-jet method, and an LB method.

A film thickness of the hole transportation layer is not particularly limited; however, in usual, approximately ranges from 5 nm to 5 μm, preferably, ranges from 5 nm to 200 nm. This hole transportation layer may have a single layer structure made of one or two or more types of the above-described materials.

Moreover, a high p-character hole transportation layer doped with impurities can also be used. As examples of this layer, there are mentioned those described in Japanese Patent Laid-Open Publications Nos. H04-297076 (published in 1992), and 2000-196140 and 2001-102175, J. Appl. Phys., 95, 5773 (2004) and the like.

In the present invention, it is preferable to use such a hole transportation layer with a high p-character since an element with a low power consumption can be fabricated.

«Anode»

As the anode in the organic EL element, one is preferably used, which uses metal, an alloy, an electric conductive compound, or a mixture of these, which has a large work function (4 eV or more), as an electrode substance. As specific examples of the electrode substance as described above, there are mentioned metal such as Au, and a conductive transparent material such as CuI, indium tin oxide (ITO), SnO2, and ZnO.

Moreover, a material such as IDIXO ($In_2O_3$-ZnO), which is amorphous and capable of fabricating the transparent conductive film, may also be formed. In the anode, a thin film may be formed from these electrode substances by a method such as evaporation and sputtering, and a pattern with a desired shape may be formed thereon by a photolithography method. Alternatively, in the case where a pattern accuracy is not required to a large extent (the required accuracy is approximately 100 μm or more), the pattern may be formed through a mask with a desired shape at the time of the evaporation and sputtering of the above-described electrode substances.

Alternatively, in the case of using a substance such as an organic conductive compound, which is capable of being coated, a wet deposition method such as a printing method and a coating method can also be used. In the case of extracting the light emission from this anode, desirably, transmittance thereof is set at larger than 10%, and moreover, and moreover, preferably, a resistance of a sheet as the anode is several hundred Ω/□ or less. Furthermore, though depending on a material of the anode, a film thickness thereof is selected usually from a range of 10 nm to 1000 nm, preferably from a range of 10 nm to 200 nm.

«Support substrate»

With regard to a support substrate (hereinafter, also referred to as a base, a substrate, a base material, a support body and the like), which can be used for the organic EL element of the present invention, a type thereof, such as glass and plastics, is not particularly limited, and the support substrate concerned may be either transparent or opaque. As a transparent support substrate to be preferably used, glass, quartz and a transparent resin film can be mentioned. A particularly preferable support substrate is the resin film capable of imparting flexibility to the organic EL element.

As the resin film, for example, there can be mentioned: polyester such as polyethylene terephthalate (PET) and polyethylene naphthalate (PEN); polyethylene; polypropylene; cellulose esters such as cellophane, cellulose diacetate, cellulose triacetate, cellulose acetate butyrate, cellulose acetate propionate (CAP), cellulose acetate terephthalate (TAC), and cellulose nitrate, and derivatives thereof; polyvinylidene chloride; polyvinyl alcohol; polyethylene vinyl alcohol; syndiotactic polystyrene; polycarbonate; norbornene resin; polymethyl pentene; polyether ketone; polyimide; polyether sulfone (PES), polyphenylene sulfide; polysulfones; polyether imide; polyether ketone imide; polyamide; fluorine resin;

Nylon; polymethyl methacrylate; acrylics or polyarylates; cycloolefin-based resin such as Arton (trade name : made by Corporation) and Apel (made by Mitsui Chemicals Inc.); and the like.

On a surface of the resin film, an inorganic coating film, an organic coating film, or a hybrid coating film of both thereof may be formed. Preferably, the resin film is a barrier film in which a vapor transmission rate (25±0.5°C; relative humidity: (90±2)%RH) measured by a method in conformity with JIS K 7129-1992 is 0.01 g/($m^2$·24h) or less. More preferably, the resin film is a high barrier film in which an oxygen transmission rate measured by a method in conformity with JIS-K 7126-1987 is $10^{-3}$ ml/$m^2$·24h·atm) or less and a vapor transmission rate measured thereby is $10^{-5}$ g/($m^2$·24h) or less.

A material that forms the barrier film just needs to be a material having a function to suppress invasion of water, oxygen and the like, which bring a deterioration of the element. For example, as the material concerned, silicon oxide, silicon dioxide, silicon nitride and the like can be used. More preferably, a stack structure of such an inorganic layer and a layer made of an organic material is provided in order to further eliminate fragility of the film concerned. A stacking order of the inorganic layer and the organic layer is not particularly limited; however, preferably, both thereof are alternately stacked on each other plural times.

A forming method of the barrier film is not particularly limited; and for example, there can be used a vacuum evaporation method, a sputtering method, a reactive sputtering method, a molecular beam epitaxy method, a cluster ion beam method, an ion plating method, a plasma polymerization method, an atmospheric pressure plasma polymerization method, a plasma CVD method, a laser CVD method, a thermal CVD method, a coating method, and the like. However, an atmospheric plasma polymerization method as described in Japanese Patent Laid-Open Publication No. 2004-68143 is particularly preferable.

As the opaque support substrate, for example, a metal plate of aluminum, stainless steel and the like, a film, an opaque resin substrate, a substrate made of ceramics, and the like are mentioned.

External extraction efficiency of the light emission of the organic EL element of the present invention is preferably 1% or more, more preferably 5% or more.

Here, a following relationship is established:

External extraction quantum efficiency (%)

= number of photons emitted to outside of organic EL element

/ (number of electrons flown to organic EL element)×100

Moreover, a hue improvement filter such as a color filter may be used in combination, or a color conversion filter that converts a light emitting color, which comes from the organic EL element, into many colors by using a fluorescent material, may be used in combination. In the case of using the color conversion filter, preferably, λmax of the light emission of the organic EL element is 480 nm or less.

«Fabrication method of organic EL element»

As an example of a fabrication method of the organic EL element, a description is made of a fabrication method of an element composed of the anode / the hole injection layer / the hole transportation layer / the light emitting layer / the hole blocking layer / the electron transportation layer / the cathode buffer layer (the electron injection layer) / the cathode.

First, on an appropriate base material, a desired electrode substance, for example, a thin film made of a substance for the anode is formed so that a film thickness thereof can become 1 μm or less, preferably, 10 nm to 200 nm, whereby the anode is fabricated.

Next, on the anode, thin films as element materials containing organic compounds are formed, which are such as the hole injection layer, the hole transportation layer, the light emitting layer, and the cathode buffer layer.

As a forming method of the thin films, for example, a vacuum evaporation method and a wet method (also referred to as a wet process) can be employed to deposit the thin films concerned.

As the wet method, there are a spin coat method, a cast method, a die coat method, a blade coat method, a roll coat method, an ink-jet method, a printing method, a spray coat method, a curtain coat method, an LB method, and the like. From viewpoints that it is possible to form precise thin films and that productivity is high, methods such as the die coat method, the roll coat method, the ink-jet method, and the spray coat method, in each of which a roll-to-roll method suitability are preferable. Moreover, different deposition methods may be applied for each of the layers.

As a liquid medium that dissolves or disperses the organic EL material according to the present invention, for example, there can be used organic solvents, which are such as: ketones such as methylethylketone and cyclohexanone; fatty acid esters such as ethyl acetate; halogenated hydrocarbons such as dichlorobenzene; aromatic hydrocarbons such as toluene, xylene, mesitylene and cyclohexylbenzene; fatty hydrocarbons such as cyclohexane, Decalin, and dodecane; and DMF and DMSO.

Moreover, with regard to a dispersion method, the organic EL material can be dispersed by a dispersion method such as an ultrasonic wave, high shearing force dispersion, and media dispersion.

After these layers are formed, a thin film made of a substance for the cathode is formed thereon so that a film thickness thereof can become 1 μm or less, preferably, 50 nm to 200 nm, and the anode is thereby fabricated, whereby the desired organic EL element is obtained.

Moreover, by reversing such a forming order as described above, it is also possible to fabricate the cathode, the cathode buffer layer, the electron transportation layer, the hole blocking layer, the light emitting layer, the hole transportation layer, the hole injection layer and the anode.

With regard to the fabrication of the organic EL element of the present invention, it is preferable to fabricate the same throughout from the hole injection layer to the cathode during single vacuum evacuation; however, the organic EL element may be taken out on the way, and may be subjected to a different deposition method. In this event, it is preferable to perform the operation under a dry inert gas atmosphere.

«Sealing»

As sealing means for use in the present invention, for example, a method of adhering a sealing member and the electrodes and the support substrate to each other by an adhesive can be mentioned.

The sealing member just needs to be arranged so as to cover a display region of the organic EL element, and may have either of a recessed plate shape and a flat plate shape. Moreover, transparency and electric insulating property are not particularly required for the sealing member.

Specifically, a glass plate, a polymer plate/film, a metal plate/film, and the like are mentioned. As the glass plate, in particular, soda-lime glass, barium/strontium-containing glass, lead glass, aluminosilicate glass, borosilicate glass, barium borosilicate glass, quarts, and the like can be mentioned.

Moreover, as the polymer plate, those made of polycarbonate, acrylic, polyethylene terephthalate, polyether sulfide, polysulfone and the like can be mentioned.

As the metal plate, those can be mentioned, each of which is made of one or more metals selected from the group consisting of stainless steel, iron, copper, aluminum, magnesium, nickel, zinc, chromium, titanium, molybdenum, silicon, germanium and tantalum, or made of an alloy thereof.

In the present invention, the polymer film and the metal film can be preferably used since the element can be thinned.

Moreover, preferably, the polymer film is a film in which an oxygen transmission rate measured by a method in conformity with JIS-K 7126-1987 is $10^{-3}$ ml/m$^2$·24h·atm) or less and a vapor transmission rate (25±0.5°C; relative humidity: (90±2)%RH) measured by a method in conformity with JIS K 7129-1992 is $1\times10^{-3}$ g/(m$^2$·24h) or less.

For processing the sealing member into a recessed shape, sand blast processing, chemical etching processing and the like are used.

As the adhesive, specifically, photo-curing and thermo-curing adhesives such as acrylic acid oligomer and methacrylic acid oligomer, each of which has a reactive vinyl group, and an adhesive of a moisture-curing type or the like, such as 2-cyanoacrylic acid ester, can be mentioned. Moreover, thermo-and chemical curing-type (two-liquid mixture) adhesive such as an epoxy-based one can be mentioned. Moreover, hot melt-type polyamide, polyester and polyolefin can be mentioned. Moreover, an ultraviolet-curing epoxy resin adhesive of a cationic-curing type can be mentioned.

Note that, in some case, the organic EL element is deteriorated owing to heat treatment, and accordingly, one for which the adhesion and the curing can be performed from room temperature to 80°C is preferable. Moreover, a drying agent may be dispersed into the adhesive. For coating the adhesive on a sealing portion, a commercially available dispenser may be used, or the adhesive may be printed like screen printing.

Moreover, the following formation can also be suitably performed. Specifically, on an outside of such an electrode on a side opposite to the support substrate while sandwiching the organic layer therebetween, a layer of inorganic or organic matter is formed in a form of coating the electrode concerned and the organic layer and contacting the support substrate, and the layer thus coated is used as a sealing film. In this case, a material that forms the film concerned just needs to a material having such a function to suppress invasion of water, oxygen and the like, which bring a deterioration of the element. For example, as the material concerned, silicon oxide, silicon dioxide, silicon nitride and the like can be used.

More preferably, a stack structure of such an inorganic layer and a layer made of an organic material is provided in order to further eliminate fragility of the film concerned. A forming method of the film concerned is not particularly

limited; and for example, there can be used a vacuum evaporation method, a sputtering method, a reactive sputtering method, a molecular beam epitaxy method, a cluster ion beam method, an ion plating method, a plasma polymerization method, an atmospheric pressure plasma polymerization method, a plasma CVD method, a laser CVD method, a thermal CVD method, a coating method, and the like.

In a gaseous phase and a liquid phase, into a gap between the sealing member and the display region of the organic EL element, it is preferable to inject inert gas such as nitrogen and argon and inert liquid such as hydrocarbon fluoride and silicon oil. Moreover, it is also possible to evacuate the gap. Furthermore, a hygroscopic compound can also be sealed into an inside of the gap.

As the hygroscopic compound, for example, there are mentioned metal oxides (for example, sodium oxide, potassium oxide, calcium oxide, barium oxide, magnesium oxide, aluminum oxide and the like), sulfates (for example, sodium sulfate, calcium sulfate, magnesium sulfate, cobalt sulfate and the like), metal halides (for example, calcium chloride, magnesium fluoride, cesium fluoride, tantalum fluoride, cerium bromide, magnesium bromide, barium iodide, magnesium iodide, and the like), perchlorates (for example, barium perchlorate, magnesium perchlorate and the like), and the like, and anhydrides are suitably used in the sulfates, the metal halides and the perchlorates.

«Protection film, protection plate»

On an outside of the above-described sealing film or the above-described sealing film on the side opposite to the support substrate while sandwiching the organic layer therebetween, a protection film or a protection plate may be provided in order to enhance mechanical strength of the element. In particular, in the case where the sealing is performed by the above-described sealing film, mechanical strength thereof is not necessarily high, and accordingly, it is preferable to provide the protection film or the protection plate, which is as described above. As a material usable for the protection film or the protection plate, a glass plate, a polymer plate/film, a metal plate/film and the like, which are similar to those used for the sealing, can be used; however, it is preferable to use the polymer film since the polymer film concerned is lightweight and enables the organic EL element to be thinned.

«Light extraction»

With regard to the organic EL element, it is generally said that light is emitted in an inside of the layer in which a refractive index is higher (approximately 1.7 to 2.1) than that of air, and that no more than approximately 15% to 20% among the light generated in the light emitting layer can be extracted. The reason for this is as follows. That is to say, light made incident onto an interface (interface between the transparent substrate and the air) at an angle $\theta$ equal to or more than a critical angle causes total reflection, and cannot be extracted to the outside of the element. Moreover, the light causes the total reflection between the transparent electrode or the light emitting layer and the transparent substrate, the light is guided through the transparent electrode or the light emitting layer, and as a result, the light escapes in a direction of a side surface of the element.

As methods for enhancing efficiency of this light extraction, for example, there are: a method of preventing the total reflection on the interface between the transparent substrate and the air by forming irregularities on the surface of the transparent substrate (US Patent No. 4,774,435); a method of enhancing the efficiency by imparting light collection characteristics to the substrate (Japanese Patent Laid-Open Publication No. S63-314795 (published in 1988)); a method of forming reflection surfaces on the side surface and the like of the element (Japanese Patent Laid-Open Publication No. H01-220394) ; a method of forming a reflection preventing film by introducing a flat layer, which has an intermediate refractive index, between the substrate and the light emitting material (Japanese Patent Laid-Open Publication No.S62-172691 (published in 1987) ; a method of introducing a flat layer, which has a refractive index lower than that of the substrate, between the substrate and the light emitting material (Japanese Patent Laid-Open Publication No. 2001-202827); a method of forming a diffraction grating in a space between any layers of the substrate, the transparent electrode layer and the light emitting layer (the space including a space between the substrate and the outside) (Japanese Patent Laid-Open Publication No. H11-283751 (published in 1999) ; and the like.

In the present invention, these methods can be used in combination with the organic EL element of the present invention; however, the method of introducing a flat layer, which has a refractive index lower than that of the substrate, between the substrate and the light emitting material, or the of forming a diffraction grating in a space between any layers of the substrate, the transparent electrode layer and the light emitting layer (the space including a space between the substrate and the outside) can be suitably used.

In the present invention, an element, which has higher brightness and far more excellent durability, can be obtained by combining these means.

If, between the transparent electrode and the transparent substrate, a medium with a low refractive index is formed with a thickness longer than a wavelength of the light, then external extraction efficiency of the light, which comes from the transparent electrode, is increased as the refractive index of the medium is lower.

As such a low refractive index layer, for example, aero gel, porous silica, magnesium fluoride, a fluorine-based polymer, and the like are mentioned. In general, the refractive index of the transparent substrate is approximately 1.5 to 1.7, and accordingly, the refractive index of the low refractive index layer is preferably approximately 1. 5 or less, and moreover, preferably, 1.35 or less.

Moreover, desirably, the thickness of the low refractive index medium becomes twice or more the wavelength of the light in the medium. This is because, if the thickness of the low refractive index medium becomes approximately the wavelength of the light, which is also a thickness at which an electromagnetic wave oozes owing to an evanescent phenomenon, then an effect of the low refractive index layer is decreased.

The method of introducing a diffraction grating into the interface causing the total reflection or into any medium has a feature that the effect of enhancing the light extraction efficiency is high. In the light generated from the light emitting layer, with regard to light, which cannot come out owing to the total reflection between the layers, this method is aimed to diffract and extract the light concerned to the outside by introducing the diffraction grating into the space between any layers or into the medium (into the transparent electrode or into the transparent electrode) by using property that the diffraction grating can change an orientation of the light to a specific direction different from a refraction direction by so-called Bragg diffraction such as primary diffraction and secondary diffraction.

Desirably, the diffraction grating to be introduced has a two-dimensional periodic refractive index. The reason for this is as follows. That is to say, the light emitted in the light emitting layer is generated randomly in every direction, and accordingly, by a general one-dimensional diffraction grating that has a periodic refractive index distribution only in a certain direction, only light that travels in a specific direction is diffracted, and the light extraction efficiency is not increased to a large extent.

However, the refractive index distribution is made into a two-dimensional distribution, whereby the light that travels in every direction is diffracted, and the light extraction efficiency is increased.

As mentioned above, a position into which the diffraction grating is introduced may be the space between any layers or the inside of the medium (inside of the transparent substrate and inside of the transparent electrode); however, desirably, the position is the vicinity of the organic light emitting layer as a place where the light is generated.

At this time, preferably, the period of the diffraction grating is approximately 1/2 to 3 times the wavelength of the light in the medium.

With regard to an array of the diffraction grating, preferably, the array concerned is repeated two-dimensionally as in a square lattice shape, a triangular lattice shape, a honeycomb lattice shape, and the like.

«Light condensing sheet»

The organic EL element of the present invention is processed so as to provide, for example, a micro lens array-like structure on a light extraction side of the substrate, or the organic EL element concerned is combined with a so-called light condensing sheet, whereby the light is condensed in a specific direction, for example, a front direction with respect to the light emitting surface of the element. In such a way, brightness of the element in a specific direction can be enhanced.

As an example of the micro lens array, on the light extraction side of the substrate, such quadrangular pyramids in which a side length becomes 30 μm and a vertex angle becomes 90 degrees are arrayed two-dimensionally. Preferably, the side length ranges from 10 μm to 100 μm. If the side length becomes smaller than this range, then an effect of the diffraction occurs to tint the light, and if the side length becomes larger than this range, then a thickness of the light condensing sheet becomes thick, and this is not preferable.

As the light condensing sheet, for example, one is usable, which is put into practical use for an LED backlight of a liquid crystal display device. As the sheet as described above, for example, a brightness enhancement film (BEF) made by Sumitomo 3M Limited, and the like can be used.

With regard to a shape of a prism sheet, for example, the prism sheet may be one in which a triangular stripe with a vertex angle of 90 degrees and a pitch of 50 μm is formed on a base material. Alternatively, the prism sheet may have a shape in which vertices are rounded, a shape in which the pitch is randomly changed, and other shapes.

Moreover, in order to control a light radiation angle from the light emitting element, a light diffusion plate/film may be used in combination with the light condensing sheet. For example, a diffusion film (Lightup) made by Kimoto Co., Ltd., and the like can be used.

«Usage purpose»

The organic EL element can be used as a display device, a display and a variety of light emitting sources. As the light emitting sources, for example, there are mentioned: light sources of illumination devices (home lighting, car room lighting), a timepiece, a backlight for a liquid crystal display, a signboard advertisement, a traffic signal, and an optical recording medium; a light source of an electrophotographic copier; a light source of an optical communication

processor; a light source of a light sensor; and the like, and the light emitting sources are not limited to these. However, in particular, the organic EL device can be effectively used as the backlight of the liquid crystal display device and the illumination light source.

At the time of the deposition, for the organic EL element of the present invention, patterning may be implemented by a metal mask, an ink-jet printing method and the like according to needs. In the case of performing the patterning, the patterning may be performed only for the electrodes, for the electrodes and the light emitting layer, or for all of the layers of the element. In the event of fabricating the element, a method heretofore known in public can be used.

The colors to be emitted from the organic EL element of the present invention and the compounds according to the present invention are decided by colors when results measured by a spectral radiation brightness meter CS-1000 (made by Konica Minolta Sensing, Inc.) are allowed to apply to the CIE chromaticity coordinates in FIG. 4. 16 in the page 108 of "Color Science Handbook, New Edition" (edited by The Color Science Association of Japan, University of Tokyo Press, 1985).

Moreover, in the case where the organic EL element of the present invention is a white element, a white color stands for a color in which chromaticity in the CIE 1931 color system at 1000 cd/$m^2$ is within a region of X = 0. 33±0. 07 and Y = 0.33±0.1 when 2-degree viewing angle front brightness is measured by the above-described method.

«Display device»

A description is made of a display device of the present invention. The display device of the present invention is a device including the organic EL element of the present invention. The display device of the present invention may be monochromatic or multicolored; however, a description is made here of the multicolored display device.

In the case of the multicolored display device, a shadow mask is provided only at the time of forming the light emitting layer, and on one surface thereof, a film can be formed by an evaporation method, a cast method, a spin coat method, an ink-jet method, a printing method and the like.

In the case of performing the patterning only for the light emitting layer, a method thereof is not limited; however, preferably, the method is an evaporation method, an ink-jet method, a spin coat method, and a printing method.

A configuration of the organic EL element provided in the display device is selected from among the above-described configuration examples of the organic EL element according to needs.

Moreover, a manufacturing method of the organic EL element is as shown in one aspect of the above-described manufacture of the organic EL element of the present invention.

In the case of applying a direct current voltage to the multicolored display device thus obtained, when the anode is set at a positive (+) polarity, the cathode is set at a negative (-) polarity, and a voltage approximately ranging from 2 V to 40 V is applied thereto, then light emission can be observed. Moreover, even if a voltage is applied to the multicolored display device in a reverse polarity relationship, a voltage does not flow therethrough, and light emission never occurs. Moreover, in the case of applying an alternating current voltage to the multicolored display device, light is emitted only when the anode turns to a positive state and the cathode turns to a negative state. Note that a waveform of the alternating current to be applied may be arbitrary.

The multicolored display device can be used as a display device, a display and a variety of light emission sources. In the display device and the display device, full color display is enabled by using three types of organic EL elements which emit blue, red and green color.

As the display device and the display, a television set, a personal computer, a mobile instrument, an AV instrument, a character broadcast display, an information display in an automobile, and the like are mentioned. In particular, the multicolored display device may be used as a display device that reproduces a still image and a moving picture, and a drive method in the case of using the multicolored display device as a display device for reproducing the moving picture may be a simple matrix (passive matrix) method or an active matrix method.

As the light emitting sources, there are mentioned: light sources of home lighting, car room lighting, a timepiece, a backlight for a liquid crystal display, a signboard advertisement, a traffic signal, and an optical recording medium; a light source of an electrophotographic copier; a light source of an optical communication processor; a light source of a light sensor; and the like; however, the present invention is not limited to these.

A description is made below of an example of the display device, which includes the organic EL element of the present invention, based on the drawings.

FIG. 1 is a schematic view showing an example of the display device composed of the organic EL element. For example, FIG. 1 is a schematic view of a display of a cellular phone or the like, which performs display of image information by the light emission of the organic EL element.

A display 1 is composed of: a display unit A including a plurality of pixels; a control unit B that performs image scanning of the display unit A based on the image information; and the like.

The control unit B and the display unit A are electrically connected to each other, scanning signals and image data signals are individually sent to the plurality of pixels based on the image information from the outside, and by the

scanning signals, the pixels for each of scan lines sequentially emit light in response to the image data signals to scan the image, and then display the image information on the display unit A.

FIG. 2 is a schematic view of the display unit A.

On the substrate, the display unit A includes: a wiring portion including pluralities of scan lines 5 and data lines 6; a plurality of pixels 3; and the like. A description is made below of the main members of the display unit A.

FIG. 2 shows the case where light emitted by the pixels 3 is extracted in a white arrow direction (downward direction) .

The pluralities of scan lines 5 and data lines 6 of the wiring portion are individually made of conductive materials, and the scan lines 5 and the data lines 6 perpendicularly intersect each other, and are connected to the pixels 3 at positions where both of them perpendicularly intersect each other (details thereof are not shown).

Upon being applied with scan signals from the scan lines 5, the pixels 3 receive image data signals from the data lines 6, and emit light in response to the received image data.

Pixels in which a color of light emission is in a red region, pixels in which a color of light emission is in a green region, and pixels in which a color of light emission is in a blue region are appropriately arranged on the same substrate, whereby full color display is enabled.

Next, a description is made of a light emission process of the pixels. FIG. 3 is a schematic view of the pixels.

Each of the pixels includes an organic EL element 10, a switching transistor 11, a drive transistor 12, a capacitor 13, and the like. For the plurality of pixels, organic EL elements which emit red light, green light and blue light are used as such organic EL elements 10, and these are arrayed on the same substrate, whereby the full color display is enabled.

In FIG. 3, the image data signal is applied to a drain of the switching transistor 11 from the control unit B through the data line 6. Then, when the scan signal is applied to a gate of the switching transistor 11 from the control unit B through the scan line 5, drive of the switching transistor 11 is turned on, and the image data signal applied to the drain is transmitted to the capacitor 13 and a gate of the drive transistor 12.

By the transmission of the image data signal, the capacitor 13 is charged in response to a potential of the image data signal, and drive of the drive transistor 12 is turned on. In the drive transistor 12, a drain thereof is connected to a power supply line 7, a source thereof is connected to an electrode of the organic EL element 10, and in response to a potential of the image data signal applied to the gate thereof, a current is supplied from the power supply line 7 to the organic EL element 10.

When the scan signals shift to the next scan line 5 by sequential scanning of the control unit B, the drive of the switching transistor 11 is turned off. However, even if the drive of the switching transistor 11 is turned off, the capacitor 13 holds the potential of the charged image data signal, and accordingly, an ON state of the drive of the drive transistor 12 is held, and the light emission of the organic EL element 10 is continued until the next application of the scan signal is performed. When the scan signal is applied next by the sequential scanning, the drive transistor 12 is driven in response to a potential of the next image data signal synchronized with the scan signal, and the organic EL element 10 emits light.

Specifically, with regard to the light emission of the organic EL element 10, for the organic EL element 10 of each of the plurality of pixels, the switching transistor 11 and the drive transistor 12, which are active elements, are provided, whereby the light emission of the organic EL element 10 of each of the plurality of pixels 3 is performed. Such a light emission method is referred to as an active matrix method.

Here, the light emission of the organic EL element may be light emission with a plurality of gradations, which are brought by a multi-valued image data signal having a plurality of gradation potentials, or may be ON/OFF of a predetermined light transmission amount by a binary image data signal. Moreover, with regard to the holding of the potential of the capacitor 13, the potential concerned may be continuously held until the next application of the scan signal, or may be discharged immediately before the scan signal is applied next.

In the present invention, without being limited to the above-mentioned active matrix method, light transmission drive of a passive matrix method may be adopted, in which the organic EL element is allowed to emit light in response to the data signal only when the scan signal is scanned.

FIG. 4 is a schematic view of a display device according to the passive matrix method. In FIG. 4, the plurality of scan lines and the plurality of image data lines 6 are provided in a lattice shape so as to be opposed to each other while sandwiching the pixels 3 therebetween.

When the scan signals of the scan lines 5 are applied by sequential scanning, the pixels 3 connected to the scan lines 5 to which the scan signals are applied emit light in response to the image data signals.

In the passive matrix method, there are no active elements in the pixel 3, and reduction of manufacturing cost of the organic EL element can be achieved.

«Illumination device»

A description is made of the illumination device of the present invention. The illumination device of the present invention includes the above-described organic EL element.

The organic EL element of the present invention may be used as an organic EL element provided with a resonator structure. As usage purposes of the organic EL element having the resonator structure as described above, a light source of an optical recording medium, a light source of an electrophotographic copier, a light source of an optical communication processor, a light source of a light sensor, and the like are mentioned; however, the usages purposes are not limited to these. Moreover, the organic EL element may be used for the above-described usage purposes by allowing the organic EL element concerned to perform laser oscillation.

Moreover, the organic EL element of the present invention may be used as a type of lamp such as an illumination lamp and an exposure light source, or may be used as a projection device of an image projection type, or as a display device (display) of a type of directly visually recognizing a still image and a moving picture.

A drive method in the case of using the organic the organic EL element as the display device for reproducing a moving picture may be either of a simple matrix (passive matrix) method and an active matrix method. Moreover, two or more types of the organic EL elements of the present invention, which have different light emission colors, are used, thus making it possible to fabricate a full color display device.

Moreover, the organic EL material of the present invention can be applied to an organic EL element that serves as an illumination device and generates substantially white light emission. A plurality of light emission colors are emitted simultaneously by a plurality of the light emitting materials, and white light emission is obtained by a color mixed thereby. A combination of the plurality of light emission colors may be one in which three maximum light emission wavelengths of the three primary colors which are red, green and blue are contained, or one in which two maximum light emission wavelengths using a complementary color relationship such as a relationship between blue and yellow and a relationship between blue green and orange are contained.

Moreover, a combination of the light emitting materials, which is for obtaining a plurality of light emission colors, may be either of one in which a plurality of materials which emit phosphorescent or fluorescent light are combined with one another and one in which light emitting materials which emit fluorescent or phosphorescent light and dye materials which emit the light coming from the light emitting materials as excitation light are combined with one another. In the white organic EL element according to the present invention, a plurality of light emitting dopants just need to be combined and mixed with one another.

A mask is provided only at the time of forming the light emitting layer, the hole transportation layer, the electron transportation layer or the like, and a way of coating the layer concerned is differentiated by the mask. As described above, simple arrangement is sufficient for the coating, and other layers are common. Accordingly, patterning for the mask or the like is unnecessary, and for example, an electrode film can be formed on the entire surface by a cast method, a spin coat method, an ink-jet method, a printing method and the like, and productivity is also enhanced.

According to this method, unlike a white organic EL device in which light emitting elements with a plurality of colors are arrayed in parallel in an array shape, the elements themselves emit white light.

The light emitting material for use in the light emitting layer is not particularly limited. For example, in the case of a backlight of a liquid crystal display element, then from among the metal complexes according to the present invention and publicly known light emitting materials, arbitrary ones just need to be selected and combined to give the white color emission so as to adapt to a wavelength range corresponding to color filter (CF) characteristics.

«One aspect of illumination device of the present invention»

A description is made of one aspect of the illumination device of the present invention, which includes the organic EL element of the present invention.

A non-light emitting surface of the organic EL element of the present invention is covered with a glass case, a glass substrate with a thickness of 300 $\mu$m is used as a sealing substrate, and an epoxy-based photo-curing adhesive (Luxtrack LC0629B made by Toagosei Co., Ltd.) is applied as a sealing material on a periphery of the glass substrate. Then, an obtained resultant is stacked on the cathode, and is brought into intimate contact with a transparent support substrate, is irradiated with UV light from the glass substrate side, and is cured and sealed. In such a way, an illumination device as shown in FIG. 5 and FIG. 6 can be formed.

FIG. 5 shows a rough view of the illumination device, in which an organic EL element 101 of the present invention is covered with a glass cover 102 (note that such a sealing operation using the glass cover was performed in a glove box under a nitrogen atmosphere (under an atmosphere of high-purity nitrogen gas with purity of 99.999% or more) without bringing the organic EL element 101 in contact with the atmosphere).

FIG. 6 shows a cross-sectional view of the illumination device, and in FIG. 6, reference numeral 105 denotes the cathode, reference numeral 106 denotes the organic EL layer, and reference numeral 107 denotes the glass subtracted attached with the transparent electrode. Note that an inside of the glass cover 102 is filled with nitrogen gas 108, and is provided with a water catching agent 109.

The present invention is described below in detail by examples; however, the present invention is not limited to these.

Moreover, structures of compounds to be used in the examples described low are shown below.

COMPARISON 1

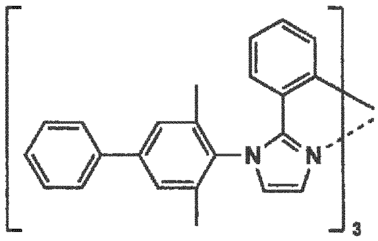

COMPARISON 2

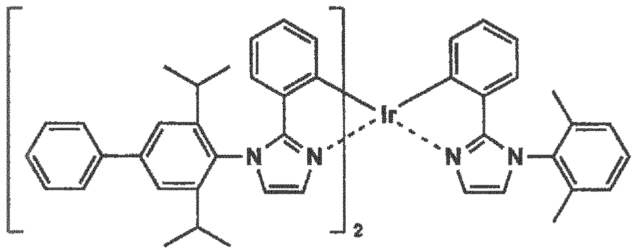

COMPARISON 3

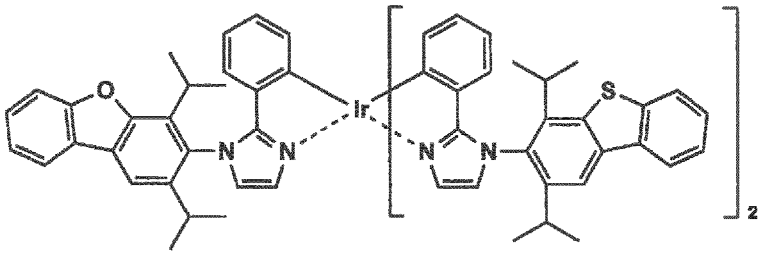

COMPARISON 4

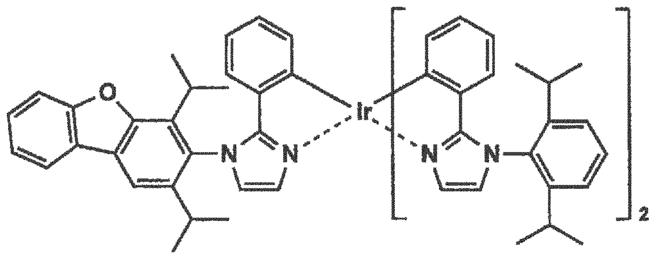

α −NPD

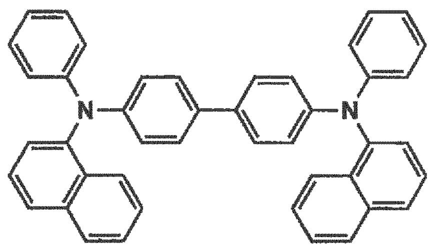

ADS−254

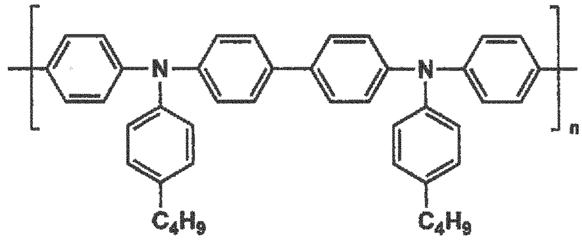

HOLE TRANSPORTATION MATERIAL 7

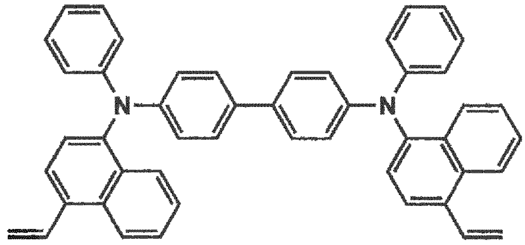

HI−1

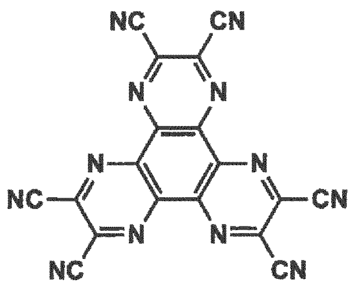

HI−2

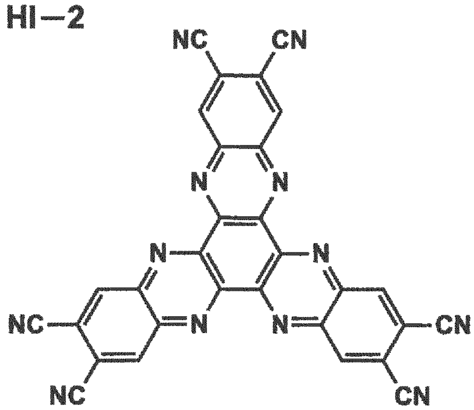

[Example 1]

«Fabrication of organic EL element 1-1»

Patterning was performed for a substrate (NA45 made by NH Technoglass Corporation) in which indium tin oxide (ITO) was deposited as an anode to a thickness of 100 nm on a glass substrate with dimensions of 100 mm × 100 mm × 1.1 mm. Thereafter, this transparent support substrate provided with the ITO transparent electrode was subjected to ultrasonic cleaning by isopropyl alcohol, was dried by dry nitrogen gas, and was subjected to UV ozone cleaning for 5 minutes.

On this transparent support substrate, a thin film was formed by a spin coat method under conditions of 3000 rpm and 30 seconds by using a solution obtained by diluting poly(3,4-ethylenedioxythiophene)-polystyrenesulfonate (PEDOT/PSS, made by H. C. Starck GmbH, Clevios P VPAI 4083) to 70% by pure water. Thereafter, the formed thin film was dried at 200°C for 1 hour, and a first hole transportation layer with a film thickness of 20 nm was provided.

This transparent support substrate was fixed to a substrate holder of a commercially available vacuum evaporation device. Meanwhile, 200 mg of α-NPD was put as a hole transportation material into a molybdenum-made resistance heating boat, 200 mg of OC-30 was put as a host compound into another molybdenum-made resistance heating boat, 200 mg of ET-8 was put as an electron transportation material into another molybdenum-made resistance heating boat, and 100 mg of Comparison 1 was put as a dopant compound into another molybdenum-made resistance heating boat. Then, these boats were mounted onto the vacuum evaporation device.

Subsequently, a vacuum column was decompressed to $4\times10^{-4}$ Pa, and thereafter, the above-described heating boat into which the α-NPD was put was energized and heated, and the α-NPD was evaporated onto the transparent support substrate at an evaporation rate of 0.1 nm/sec., whereby a second hole transportation layer with a film thickness

of 20 nm was provided.

Moreover, the above-described boat into which the OC-30 was put as the host compound and the above-described boat into which Comparison 1 was put as the dopant compound were energized and heated, and were co-evaporated onto the above-described second hole transportation layer at evaporation rates of 0.1 nm/sec. and 0.006 nm/sec., respectively, whereby a light emitting layer with a film thickness of 40 nm was provided.

Furthermore, the above-described heating boat into which the ET-8 was put was energized and heated, and the ET-8 was evaporated onto the above-described light emitting layer at an evaporation rate of 0.1 nm/sec., whereby an electron transportation layer with a film thickness of 30 nm was provided.

Note that a substrate temperature at the time of evaporation was room temperature.

Subsequently, lithium fluoride was evaporated to form a cathode buffer layer with a film thickness of 0.5 nm, and further, aluminum was evaporated to form a cathode with a film thickness of 110 nm, whereby an organic EL element 1-1 was fabricated.

«Fabrication of organic EL elements 1-2 to 1-10»

In the fabrication of the organic EL element 1-1, the host compound and the dopant compound in the light emitting layer were changed to compounds described in Table 1.

Similarly except for the above-described change, organic EL elements 1-2 to 1-10 were individually fabricated.

«Evaluation of organic EL elements 1-1 to 1-10»

In the event of evaluating the obtained organic EL elements 1-1 to 1-10, the non-light emitting surface of each of the already fabricated organic EL elements was covered with a glass case, a glass substrate with a thickness of 300 μm was used as a sealing substrate, and an epoxy-based photo-curing adhesive (Luxtrack LC0629B made by Toagosei Co., Ltd.) was applied as a sealing material on a periphery of the glass substrate. Then, an obtained resultant was stacked on the above-described cathode, and was brought into intimate contact with the above-described transparent support substrate, was irradiated with UV light from the glass substrate side, and was cured and sealed. In such a way, an illumination device as shown in FIG. 5 and FIG. 6 was fabricated, and each of the organic EL elements 1-1 to 1-10 was evaluated.

For the respective samples fabricated as described above, the following evaluation was performed. Evaluation results are shown in Table 1 of FIG. 8.

(1) External extraction quantum efficiency (also simply referred to as efficiency)

Lighting was performed for each of the organic EL elements under conditions where a temperature was room temperature (approximately 23 to 25°C) and a current was as constant as 2.5 mA/cm$^2$, and light emission brightness (L) [cd/m2] thereof immediately after the lighting was started was measured, whereby the external extraction quantum efficiency (η) was calculated.

Here, the measurement of the light emission brightness was performed by using the CS-1000 (made by Konica Minolta Sensing, Inc.), and each external extraction quantum efficiency was represented by a relative value in which the organic EL element 1-1 was taken as 100.

(2) Half-life

Evaluation of a half-life of each of the organic EL elements was performed in accordance with a measurement method shown below.

Each of the organic EL elements was subjected to constant current drive by a current that gave initial brightness of 1000 cd/m$^2$, and a time when the brightness of each organic EL element became 1/2 of the initial brightness was obtained, and the obtained time was defined as a scale of the half-life.

Note that each half-life was represented by a relative value in which the organic EL element 1-1 was taken as 100.

(3) Voltage rise at drive time

A voltage at the time when each of the organic EL elements was driven under the conditions where the temperature was the room temperature (approximately 23°C to 25°C) and the current was as constant as 2.5 mA/cm$^2$ was measured, and each of measurement results was calculated by a calculation expression shown below. Then, the results thus obtained were shown in Table 1.

Each of the results was represented by a relative value in which the organic EL element 1-1 was taken as 100.

Voltage rise (relative value) at drive time = drive voltage at time when brightness is reduced to half - initial drive voltage

Note that a smaller value indicates that the voltage rise at the drive time is smaller with respect to the comparison examples.

(4) Thermal stability evaluation

For each of the organic EL elements 1-1 to 1-10, five elements with the same configuration were fabricated (for example, organic EL elements 1-1, 1-1b, 1-1c, 1-1d, 1-1e) by using the same evaporation boat (molybdenum-made resistance heating boat).

For each of the organic EL elements 1-1 to 1-10, by a similar method to the above, the half-lives were measured individually for the element (for example, organic EL element 1-1) fabricated for the first time, for the element (for example, organic EL element 1-1c) fabricated for the third time, for the element (for example, organic EL element 1-1e) fabricated for the fifth time. Each half-life of each of the elements was represented by a relative value in which the organic EL element 1-1 was taken as 100.

(5) Summary

From Table 1, it is understood that, with respect to the organic EL elements 1-1 and 1-2 of the comparison examples, each of the organic EL elements 1-3 to 1-10 of the present invention exhibits higher light emission efficiency and a longer lifetime, and characteristics thereof as an element are enhanced such that the voltage rise at the drive time is also suppressed. Moreover, with regard to each of the organic EL elements 1-1 and 1-2 of the comparison examples, the half-life thereof was gradually decreased in order of the element fabricated for the first time, the element fabricated for the third time and the element fabricated for the fifth time, and meanwhile, with regard to each of the organic EL elements 1-3 to 1-10 of the present invention, the half-life thereof was hardly decreased in order of the element fabricated for the first time, the element fabricated for the third time and the element fabricated for the fifth time, and it is understood that the dopant compounds for use in the organic EL element of the present invention are excellent in thermal stability.

[Example 2]

«Fabrication of organic EL element 2-1»

Patterning was performed for a substrate (NA45 made by AvanStrate Inc.) in which indium tin oxide (ITO) was deposited as an anode to a thickness of 100 nm on a glass substrate with dimensions of 100 mm × 100 mm × 1.1 mm. Thereafter, this transparent support substrate provided with the ITO transparent electrode was subjected to ultrasonic cleaning by isopropyl alcohol, was dried by dry nitrogen gas, and was subjected to UV ozone cleaning for 5 minutes.

On this transparent support substrate, a thin film was formed by the spin coat method by using a solution obtained by diluting poly(3,4-ethylenedioxythiophene)-polystyrenesulfonate (PEDOT/PSS, made by Bayer AG, Baytron P A1 4083,) to 70% by pure water. Thereafter, the formed thin film was dried at 200 °C for 1 hour, and a first hole transportation layer with a film thickness of 30 nm was provided.

On this first hole transportation layer, a thin film was formed by the spin coat method by using a chlorobenzene solution of poly(N,N'-bis(4-butylphenyl)-N,N/-bis(phenyl))benzidine (ADS-254-made by American Dye Source, Inc.) as a hole transportation material. The formed thin film was heated and dried at 150°C for 1 hour, and a second hole transportation layer with a film thickness of 40 nm was provided.

On this second hole transportation layer, a thin film was formed by the spin coat method by using the OC-11 as the hose compound and a butyl acetate solution of Comparison example 1, which served as the dopant compound. The formed thin film was heated and dried at 120°C for 1 hour, and a light emitting layer with a film thickness of 30 nm was provided.

On this light emitting layer, a thin film was formed by the spin coat method by using a 1-butanol solution as ET-11 as an electron transportation material, whereby an electron transportation layer with a film thickness of 20 nm was provided.

This substrate was mounted on the vacuum evaporation device, and the vacuum column was decompressed to $4 \times 10^{-4}$ Pa. Subsequently, lithium fluoride was evaporated onto the substrate, an electron injection layer with a film thickness of 1.0 nm was thereby formed, and aluminum was evaporated, and a cathode with a film thickness of 110 nm was formed, whereby an organic EL element 2-1 was fabricated.

«Fabrication of organic EL elements 2-2 to 2-7»

In the fabrication of the organic EL element 2-1, the host compound and the dopant compound in the light emitting layer were changed to compounds described in Table 2.
Similarly except for the above-described change, organic EL elements 2-2 to 2-7 were individually fabricated.

«Evaluation of organic EL elements 2-1 to 2-7»

In the event of evaluating the obtained organic EL elements 2-1 to 2-7, each of the organic EL elements concerned was sealed in a similar way to the organic EL elements 1-1 to 1-10 of Example 1, and an illumination device as shown in FIG. 5 and FIG. 6 was fabricated, and each of the organic EL elements 2-1 to 2-7 was evaluated.
For the respective samples fabricated as described above, the evaluations were performed regarding the external extraction quantum efficiency, the half-life and the voltage rise at the drive time in a similar way to Example 1. Evaluation results are shown in Table 2 of FIG. 9. Note that the measurement results of the external extraction quantum efficiency, the half-life and the voltage rise at the drive time in Table 2 were represented by relative values in which measurement values of the organic EL element 2-1 were taken as 100.
From Table 2, it is understood that, with respect to the organic EL elements 2-1 and 2-2 of the comparison examples, each of the organic EL elements 2-3 to 2-7 of the present invention exhibits higher light emission efficiency and a longer lifetime, and characteristics thereof as an element are enhanced such that the voltage rise at the drive time is suppressed.

[Example 3]

«Fabrication of white light emitting organic EL element 3-1»

Patterning was performed for a substrate (NA45 made by NH Technoglass Corporation) in which indium tin oxide (ITO) was deposited as an anode to a thickness of 100 nm on a glass substrate with dimensions of 100 mm × 100 mm × 1.1 mm. Thereafter, this transparent support substrate provided with the ITO transparent electrode was subjected to ultrasonic cleaning by isopropyl alcohol, was dried by dry nitrogen gas, and was subjected to UV ozone cleaning for 5 minutes.
This transparent support substrate was fixed to a substrate holder of a commercially available vacuum evaporation device. Meanwhile, 200 mg of the α-NPD was put as a hole transportation material into a molybdenum-made resistance heating boat, 200mg of OC-11 was put as a host compound into another molybdenum-made resistance heating boat, 200 mg of the ET-11 was put as an electron transportation material into another molybdenum-made resistance heating boat, 100 mg of Comparison 1 was put as a dopant compound into another molybdenum-made resistance heating boat, and 100 mg of D-10 was put as a dopant compound into another molybdenum-made resistance heating boat. Then, these boats were mounted onto the vacuum evaporation device.
Subsequently, a vacuum column was decompressed to $4 \times 10^{-4}$ Pa, and thereafter, the above-described heating boat into which the α-NPD was put was energized separately from others, and the α-NPD was evaporated onto the transparent support substrate at an evaporation rate of 0.1 nm/sec., whereby a first hole transportation layer with a film thickness of 20 nm was provided.
Moreover, the above-described heating boat into which the OC-11 was put as the host compound was energized, and the above-described heating boats into which Comparison example 1 and the D-10 were put as the dopant compounds were energized, and these compounds were adjusted so that evaporation rates of Compound 9, Comparison example 1 and the D-10 could be 100: 5: 0.6, and were evaporated so that a total film thickness thereof could be 30 nm. In such a way, a light emitting layer was provided.
Moreover, the above-described heating boat into which the ET-11 was put was further energized and heated, and the ET-11 was evaporated onto the above-described light emitting layer at an evaporation rate of 0.1 mm/sec., whereby an electron transportation layer with a film thickness of 30 nm was provided.
Note that a substrate temperature at the time of evaporation was room temperature.
Subsequently, lithium fluoride was evaporated to form a cathode buffer layer with a film thickness of 0.5 nm, and further, aluminum was evaporated to form a cathode with a film thickness of 110 nm, whereby an organic EL element 3-1 was fabricated.
When the fabricated organic EL element 3-1 was energized, substantially white light was obtained, and it is understood that the organic EL element 3-1 can be used as the illumination device. Note that it is understood that white light emission is obtained similarly even if the illustrated compound for use is substituted for other compounds.

«Fabrication of organic EL elements 3-2 to 3-5»

In the fabrication of the organic EL element 3-1, the host compound and the dopant compound in the light emitting layer were changed to compounds described in Table 3.
Similarly except for the above-described change, organic EL elements 3-2 to 3-5 were individually fabricated.

«Evaluation of organic EL elements 3-1 to 3-5»

In the event of evaluating the obtained organic EL elements 3-1 to 3-5, each of the organic EL elements concerned was sealed in a similar way to the organic EL elements 1-1 to 1-10 of Example 1, and an illumination device as shown in FIG. 5 and FIG. 6 was fabricated, and each of the organic EL elements 3-1 to 3-5 was evaluated.
For the respective samples fabricated as described above, the evaluations were performed regarding the external extraction quantum efficiency, the half-life, the voltage rise at the drive time and the thermal stability in a similar way to Example 1. Evaluation results are shown in Table 3 of FIG. 10. Note that the measurement results of the external extraction quantum efficiency, the half-life and the voltage rise at the drive time in Table 3 were represented by relative values in which measurement values of the organic EL element 3-1 (element fabricated for the first time) were taken as 100.
From Table 3, it is understood that, with respect to the organic EL elements 3-1 and 3-2 of the comparison examples, each of the organic EL elements 3-3 to 3-5 of the present invention exhibits higher light emission efficiency and a longer lifetime, and characteristics thereof as an element are enhanced such that the voltage rise at the drive time is also suppressed. Moreover, with regard to each of the organic EL elements 3-1 and 3-2 of the comparison examples, the half-life thereof was gradually decreased in order of the element fabricated for the first time, the element fabricated for the third time and the element fabricated for the fifth time, and meanwhile, with regard to each of the organic EL elements 3-3 to 3-5 of the present invention, the half-life thereof was hardly decreased in order of the element fabricated for the first time, the element fabricated for the third time and the element fabricated for the fifth time, and it is understood that the dopant compounds for use in the organic EL element of the present invention are excellent in thermal stability.

[Example 4]

«Fabrication of organic EL full color display»

FIGS. 7A to 7E show rough schematic views of an organic EL full color display device.
Patterning was performed at a pitch of 100 μm for a substrate (NA45 made by NH Technoglass Corporation) in which an ITO transparent electrode 202 was deposited as an anode to a thickness of 100 nm on a glass substrate 201 (refer to FIG. 7A). Thereafter, on gaps on the ITO transparent electrode 202 on this glass substrate 201, partition walls 203 (width: 20 μm; thickness: 2.0 μm) made of non-photosensitive polyimide were formed by lithography (refer to FIG. 7B).
Onto spaces among the partition walls 203 on the ITO electrode 202, a hole injection layer component with the following composition was discharged and injected by using an ink-jet heat (MJ800C made by Seiko Epson Corp.), was irradiated with ultraviolet light for 200 seconds, and was subjected to drying treatment at 60°C for 10 minutes, whereby a hole injection layer 204 with a film thickness of 40 nm was provided (refer to FIG. 7C).
On this hole injection layer 204, in a similar way, a blue light emitting layer component, a green light emitting layer component and a red light emitting layer component, which individually have the following compositions, were discharged and injected by using ink-jet heads, and were subjected to drying treatment at 60°C for 10 minutes, whereby light emitting layers 205B, 205G and 205R of the respective colors were provided (refer to FIG. 7D).
Next, an electron transportation material (ET-10) was evaporated so as to cover the respective light emitting layers 205B, 205G and 205R, and an electron transportation layer (not shown) with a film thickness of 20 nm was thereby provided, and further, lithium fluoride was evaporated thereon, and a cathode buffer layer (not shown) with a film thickness of 0.6 nm was thereby provided. Then, Al was evaporated on the cathode buffer layer, and a cathode 106 with a film thickness of 130 nm was thereby provided. In such a way, an organic EL element was fabricated (refer to FIG. 7E).
It was found out that the fabricated organic EL element exhibited blue, green and red light emission by applying a voltage to electrodes thereof, and was usable as a full color display device.

(Hole injection layer component)

Hole transportation material 7: 20 mass parts
Cyclohexylbenzene: 50 mass parts

Isopropylbiphenyl: 50 mass parts

(Blue light emitting layer component)

Host material 1: 0.7 mass part
DP-38: 0.04 mass part
Cyclohexylbenzene: 50 mass parts Isopropylbiphenyl: 50 mass parts

(Green light emitting layer component)

Host material 1: 0.7 mass part
D-1: 0.04 mass part
Cyclohexylbenzene: 50 mass parts
Isopropylbiphenyl: 50 mass parts

(Red light emitting layer component)

Host material 1: 0.7 mass part
D-10: 0.04 mass part
Cyclohexylbenzene: 50 mass parts
Isopropylbiphenyl: 50 mass parts

[Example 5]

«Fabrication of organic EL element 5-1»

In the fabrication of the organic EL element 1-1, Comparison example 3 was used as the dopant compound, the evaporation rate of the dopant compound was set at 0.005 nm/sec. , and the film thickness of the light emitting layer was changed to 50 nm.

Similarly except for the above-described changes, an organic EL element 5-1 was fabricated.

«Fabrication of organic EL elements 5-2 to 5-12»

In the fabrication of the organic EL element 5-1, the dopant compound and the evaporation rate of the dopant compound were changed as described in Table 4.

Similarly except for the above-described changes, organic EL elements 5-2 to 5-12 were individually fabricated.

«Evaluation of organic EL elements 5-1 to 5-12»

In the event of evaluating the obtained organic EL elements 5-1 to 5-12, each of the organic EL elements concerned was sealed in a similar way to the organic EL elements 1-1 to 1-10 of Example 1, and an illumination device as shown in FIG. 5 and FIG. 6 was fabricated, and each of the organic EL elements 5-1 to 5-12 was evaluated.

For the respective samples fabricated as described above, the evaluations were performed regarding the external extraction quantum efficiency and the half-life in a similar way to Example 1. Moreover, for the drive voltage, evaluation was performed in a manner as below. Evaluation results are shown in Table 4 of FIG. 11. Note that the measurement results of the external extraction quantum efficiency, the half-life and the drive voltage in Table 4 were represented by relative values in which measurement values of the organic EL element 5-3 were taken as 100.

[Measurement of drive voltage]

A voltage at the time when each of the organic EL elements was driven under the conditions where the temperature was the room temperature (approximately 23°C to 25°C) and the current was as constant as 2.5 $mA/cm^2$ was

measured.

Note that a smaller value indicates that the voltage at the drive time is smaller with respect to the comparison examples.

From Table 4, each of the dopants of the present invention has high carrier transportability, and accordingly, in the element using the dopant of the present invention, the drive voltage does not rise largely even in a region where a dopant concentration is low, and the external extraction quantum efficiency is also high. Meanwhile, even in a region where the dopant concentration is high, high external extraction quantum efficiency and a long half-life are obtained, and it is assumed that these are because dispersibility of the dopant is improved, and coagulation thereof is suppressed. In such a way, in the present invention, with regard to the external extraction quantum efficiency, the drive voltage and the half-life, dopant concentration dependencies thereof become smaller than in the comparative examples.

[Example 6]

«Fabrication of organic EL element 6-1»

Patterning was performed for a substrate (NA45 made by NH Technoglass Corporation) in which indium tin oxide (ITO) was deposited as an anode to a thickness of 100 nm on a glass substrate with dimensions of 100 mm × 100 mm × 1.1 mm. Thereafter, this transparent support substrate provided with the ITO transparent electrode was subjected to ultrasonic cleaning by isopropyl alcohol, was dried by dry nitrogen gas, and was subjected to UV ozone cleaning for 5 minutes.

On this transparent support substrate, a thin film was formed by a spin coat method under conditions of 3000 rpm and 30 seconds by using a solution obtained by diluting poly(3,4-ethylenedioxythiophene)-polystyrenesulfonate (PEDOT/PSS, made by H. C. Starck GmbH, Clevios P VPAI 4083) to 70% by pure water. Thereafter, the formed thin film was dried at 200°C for 1 hour, and a first hole transportation layer with a film thickness of 20 nm was provided.

This transparent support substrate was fixed to a substrate holder of a commercially available vacuum evaporation device. Meanwhile, 200 mg of the α-NPD was put as a hole transportation material into a molybdenum-made resistance heating boat, 200 mg of Compound 24 was put as a host compound into another molybdenum-made resistance heating boat, 200 mg of the ET-8 was put as an electron transportation material into another molybdenum-made resistance heating boat, 100 mg of Comparison 4 was put as a blue dopant compound into another molybdenum-made resistance heating boat, and 100 mg of the D-10 was put as a red dopant compound into another molybdenum-made resistance heating boat. Then, these boats were mounted onto the vacuum evaporation device.

Subsequently, a vacuum column was decompressed to $4\times10^{-4}$ Pa, and thereafter, the above-described heating boat into which the α-NPD was put was energized and heated, and the α-NPD was evaporated onto the first hole transportation layer at an evaporation rate of 0.1 nm/sec., whereby a second hole transportation layer with a film thickness of 20 nm was provided.

Moreover, the above-described boat into which the OC-30 was put as the host compound, the above-described boat into which Comparison 4 was put as the blue dopant compound, and the above-described boat into which the DC-10 was put as the red dopant were energized and heated, and were co-evaporated onto the above-described second hole transportation layer at evaporation rates of 0.1 nm/sec., 0.010 nm/sec. and 0.0002 nm/sec., respectively, whereby a light emitting layer with a film thickness of 40 nm was provided.

Furthermore, Compound 24 was evaporated onto the light emitting layer at an evaporation rate of 0.1 nm/sec., whereby a hole blocking layer with a film thickness of 5 nm was provided.

Furthermore, the above-described heating boat into which the ET-8 was put was energized and heated, and the ET-8 was evaporated onto the above-described hole blocking layer at an evaporation rate of 0.1 nm/sec., whereby an electron transportation layer with a film thickness of 30 nm was provided.

Note that a substrate temperature at the time of evaporation was room temperature.

Subsequently, lithium fluoride was evaporated to form a cathode buffer layer with a film thickness of 0.5 nm, and further, aluminum was evaporated to form a cathode with a film thickness of 110 nm, whereby an organic EL element 6-1 was fabricated.

«Fabrication of organic EL elements 6-2 to 6-16»

In the fabrication of the organic EL element 6-1, the host compound, the dopant compounds and the evaporation rates of the dopant compounds in the light emitting layer were changed to those described in Table 5 of FIG. 12.

Similarly except for the above-described change, organic EL elements 6-2 to 6-16 were individually fabricated.

«Evaluation of organic EL elements 6-1 to 6-16»

In the event of evaluating the obtained organic EL elements 6-1 to 6-16, each of the organic EL elements concerned was sealed in a similar way to the organic EL elements 1-1 to 1-10 of Example 1, and an illumination device as shown in FIG. 5 and FIG. 6 was fabricated, and each of the organic EL elements 6-1 to 6-16 was evaluated.
For the respective samples fabricated as described above, the evaluations were performed regarding the external extraction quantum efficiency and the half-life in a similar way to Example 1. Moreover, regarding chroma stability (chroma shift) with elapse of a drive time, evaluation was performed in a similar way. Evaluation results are shown in Table 5 of FIG. 12. Note that the measurement results of the external extraction quantum efficiency, the half-life and the chroma shift in Table 5 were represented by relative values in which measurement values of the organic EL element 6-2 were taken as 100.

[Evaluation of chroma stability (chroma shift) with elapse of drive time]

Brightness variations at the continuous drive time were traced while taking front brightness of 4000 cd/$m^2$ as initial brightness, and chroma at t = 0 (initial) and chroma at the time when the brightness was reduced to a half were measured by the spectral radiation brightness meter CS-1000 (made by Konica Minolta Sensing, Inc.), and a chroma difference $\Delta E$ therebetween was obtained by the following expression. Note that, in the following expression, x and y are the chroma x and y in the CIE 1931 color system.

$$\Delta E = (\Delta x^2+\Delta y^2)^{1/2}$$

From Table 5, it is understood that, in the elements using the dopants of the present invention, the light emission efficiency is high in the region where the dopant concentration is high, the light emission lifetime is long, and further, the chroma shift at the continuous drive time is small.

[Example 7]

«Fabrication of organic EL element 7-1»

A quartz substrate with dimensions of 100 mm x 100 mm x 1.1 mm was subjected to ultrasonic cleaning by isopropyl alcohol, was dried by dry nitrogen gas, and was subjected to UV ozone cleaning for 5 minutes.
This quartz substrate was fixed to a substrate holder of a commercially available vacuum evaporation device. Meanwhile, 200 mg of the OC-29 was put as a host compound into a molybdenum-made resistance heating boat, and 100 mg of Comparison 1 was put as a dopant compound into another molybdenum-made resistance heating boat. Then, these boats were mounted on the vacuum evaporation device.
Subsequently, a vacuum column was decompressed to $4\times10^{-4}$ Pa, and thereafter, the above-described heating boats into which the OC-29 and Comparison 1 were put were energized and heated, and were co-evaporated onto the above-described quartz substrate at evaporation rates of 0.1 nm/sec. and 0.005 nm/sec. , respectively, whereby a light emitting layer with a film thickness of 40 nm was provided. In such a way, an organic EL element 7-1 was obtained. A concentration of Comparison 1 after the evaporation was 5%.

«Fabrication of organic EL elements 7-2 to 7-6»

In the fabrication of the organic EL element 7-1, the dopant compound and the dopant concentration were changed to those described in Table 6 of FIG. 13.
Similarly except for the above-described change, organic EL elements 7-2 to 7-6 were individually fabricated.

«Evaluation of organic EL elements 7-1 to 7-6»

In the event of evaluating the obtained organic EL elements 7-1 to 7-6, the non-light emitting surface of each of the already fabricated organic EL elements was covered with a glass case, a glass substrate with a thickness of 300 $\mu$m was used as a sealing substrate, and an epoxy-based photo-curing adhesive (Luxtrack LC0629B made by Toagosei Co., Ltd.) was applied as a sealing material on a periphery of the glass substrate. Then, an obtained resultant was brought into intimate contact with the above-described quartz substrate, was irradiated with UV light from the glass substrate side, and was cured and sealed. In such a way, an illumination device as shown in FIG. 5 and FIG. 6 was

fabricated, and each of the organic EL elements 7-1 to 7-6 was evaluated.

For the respective samples fabricated as described above, the following evaluation was performed. Evaluation results are shown in Table 6.

[Measurement of photoluminescence intensity (PL intensity)]

An absorption spectrum of the dopant compound was measured in advance by using a dichloromethane solution (dichloromethane for absorption analysis, Spectrosol, made by Wako Pure Chemical Industries, Ltd.) of the dopant compound, and a maximum absorption wavelength in a range of 300 nm to 350 nm was set as excitation light. In this event, a concentration of the solution was approximately $10^{-5}$ mol/L.

For the illumination device of each of the fabricated organic EL elements 7-1 to 7-6, the dopant was excited by irradiation of the excitation light at room temperature, and a peak area value of an obtained light emission spectrum was obtained. This area value is a value in which absorption by the excitation light is corrected. Note that the measurement was performed by a spectrophotometer U-3300 and a fluorophotometer F-4500, which are made by Hitachi, Ltd.

Peak areas obtained in the organic EL elements 7-1 and 7-4, in each of which the dopant concentration was 5%, were taken as 100, and the cases where the dopant concentrations were 15% and 25% were compared with each other, and each of the organic EL elements 7-1 to 7-6 was evaluated.

From Table 6, it is understood that the elements using the dopant compounds of the present invention exhibit high PL intensities even in the region where the dopant concentration is high. It can be assumed that this is because the dispersibility of the dopant compound of the present invention is high and coagulation thereof is suppressed even in such a high-concentration region.

Moreover, for the above-described organic EL elements 7-3 and 7-6, stability of each thereof at a high-temperature and high-humidity storage time was also evaluated.

That is to say, the organic EL elements 7-3 and 7-6 were stored for 24 hours under conditions of 60°C and 70%RH, and the PL intensities thereof before and after the storage were compared with each other, and comparison results were regarded as the stability evaluation at the high-temperature and high-humidity storage time.

Evaluation results are shown in Table 7 of FIG. 14.

From Table 7, it is understood that each of the elements using the dopant compounds of the present invention exhibits high PL intensity even after the storage and has high stability at the time of the high-temperature and high-humidity storage.

[Example 8]

«Fabrication of emitting organic EL element 8-1»

Patterning was performed for a substrate (NA45 made by NH Technoglass Corporation) in which indium tin oxide (ITO) was deposited as an anode to a thickness of 100 nm on a glass substrate with dimensions of 100 mm × 100 mm × 1.1 mm. Thereafter, this transparent support substrate provided with the ITO transparent electrode was subjected to ultrasonic cleaning by isopropyl alcohol, was dried by dry nitrogen gas, and was subjected to UV ozone cleaning for 5 minutes.

This transparent support substrate was fixed to a substrate holder of a commercially available vacuum evaporation device. Meanwhile, 200 mg of HI-1 was put as a first hole transportation material into a molybdenum-made resistance heating boat, 200 mg of the α-NPD was put as a second hole transportation material into another molybdenum-made resistance heating boat, 200 mg of OC-23 was put as a first host compound into another molybdenum-made resistance heating boat, 200 mg of Compound 27 was put as a second host compound into another molybdenum-made resistance heating boat, 200 mg of the ET-42 was put as an electron transportation material into another molybdenum-made resistance heating boat, 100 mg of Comparison 3 was put as a dopant compound into another molybdenum-made resistance heating boat, 100 mg of D-3 was put as a dopant compound into another molybdenum-made resistance heating boat, and 100 mg of D-11 was put as a dopant compound into another molybdenum-made resistance heating boat. Then, these boats were mounted onto the vacuum evaporation device.

Subsequently, a vacuum column was decompressed to $4\times10^{-4}$ Pa, and thereafter, the above-described heating boat into which the HI-1 was put was energized and heated, and was evaporated onto the transparent support substrate at an evaporation rate of 0.1 nm/sec. , whereby a first hole transportation layer with a film thickness of 10 nm was provided.

Subsequently, the above-described heating boat into which the α-NPD was put was energized and heated, and was evaporated onto the transparent support substrate at an evaporation rate of 0.1 nm/sec., whereby a second hole transportation layer with a film thickness of 20 nm was provided.

Moreover, the above-described heating boat into which the OC-23 was put as the host compound was energized and heated, and the above-described heating boats into which D-3 and D-11 were put as the dopant compounds were

energized and heated, and these compounds were adjusted so that evaporation rates of OC-23, D-3 and D-11 could be 100: 5: 0.5, and were evaporated so that a total film thickness thereof could be 30 nm. In such a way, a first light emitting layer was provided.

Moreover, the above-described heating boat into which the Compound 27 was put as host compound was energized and heated, and the above-described heating boat into which Comparison 3 was put as the dopant compounds was energized and heated, and were evaporated onto the above-described first light emitting layer at an evaporation rate respectively of 0. 1 mm/sec., 0. 012 mm/sec. , whereby a light emitting layer with a film thickness of 40 nm was provided.

Moreover, the above-described heating boat into which the ET-42 was put was further energized and heated, and the ET-42 was evaporated onto the above-described light emitting layer at an evaporation rate of 0. 1 mm/sec. , whereby an electron transportation layer with a film thickness of 30 nm was provided.

Note that a substrate temperature at the time of evaporation was room temperature.

Subsequently, lithium fluoride was evaporated to form a cathode buffer layer with a film thickness of 0.5 nm, and further, aluminum was evaporated to form a cathode with a film thickness of 110 nm, whereby an organic EL element 8-1 was fabricated.

«Fabrication of organic EL elements 8-2 to 8-7»

In the fabrication of the organic EL element 8-1, the host compound and the dopant compound in the light emitting layer were changed to compounds described in Table 8 of FIG. 15.

Similarly except for the above-described change, organic EL elements 8-2 to 8-7 were individually fabricated.

«Evaluation of organic EL elements 8-1 to 8-7»

In the event of evaluating the obtained organic EL elements 8-1 to 8-7, the non-light emitting surface of each of the already fabricated organic EL elements was covered with a glass case, a glass substrate with a thickness of 300 μm was used as a sealing substrate, and an epoxy-based photo-curing adhesive (Luxtrack LC0629B made by Toagosei Co., Ltd.) was applied as a sealing material on a periphery of the glass substrate. Then, an obtained resultant was stacked on the above-described cathode, and was brought into intimate contact with the above-described transparent support substrate, was irradiated with UV light from the glass substrate side, and was cured and sealed. In such a way, an illumination device as shown in FIG. 5 and FIG. 6 was fabricated, and was evaluated.

For the respective samples fabricated as described above, the evaluations were performed regarding the external extraction quantum efficiency, the half-life and the thermal stability in a similar way to Example 1. Further, evaluation for drive voltage is performed in the similar way to Example 5. Evaluation results are shown in Table 8. Note that the measurement results of the external extraction quantum efficiency, the half-life and the drive voltage in Table 8 were represented by relative values in which measurement values of the organic EL element 8-1 (the element fabricated for the first time) were taken as 100.

From Table 8, it is understood that, with respect to the organic EL element 8-1 of the comparison example, each of the organic EL elements 8-2 to 8-7 of the present invention exhibits higher light emission efficiency, a longer lifetime and low drive voltage, and characteristics thereof as an element are enhanced. Moreover, with regard to the organic EL element 8-1 of the comparison example, the half-life thereof was gradually decreased in order of the element fabricated for the first time, the element fabricated for the third time and the element fabricated for the fifth time, and meanwhile, with regard to each of the organic EL elements 8-2 to 8-7 of the present invention, the half-life thereof was hardly decreased in order of the element fabricated for the first time, the element fabricated for the third time and the element fabricated for the fifth time, and it is understood that the dopant compounds for use in the organic EL element of the present invention are excellent in thermal stability.

[Example 9]

«Fabrication of emitting organic EL element 9-1»

Patterning was performed for a substrate (NA45 made by NH Technoglass Corporation) in which indium tin oxide (ITO) was deposited as an anode to a thickness of 100 nm on a glass substrate with dimensions of 100 mm × 100 mm × 1.1 mm. Thereafter, this transparent support substrate provided with the ITO transparent electrode was subjected to ultrasonic cleaning by isopropyl alcohol, was dried by dry nitrogen gas, and was subjected to UV ozone cleaning for 5 minutes.

This transparent support substrate was fixed to a substrate holder of a commercially available vacuum evaporation device. Meanwhile, 200 mg of HI-2 was put as a first hole transportation material into a molybdenum-made

resistance heating boat, 200 mg of the α-NPD was put as a second hole transportation material into another molybdenum-made resistance heating boat, 200 mg of OC-25 was put as a host compound into another molybdenum-made resistance heating boat, 200 mg of the ET-9 was put as an electron transportation material into another molybdenum-made resistance heating boat, and 100 mg of Comparison 1 was put as a dopant compound into another molybdenum-made resistance heating boat. Then, these boats were mounted onto the vacuum evaporation device.

Subsequently, a vacuum column was decompressed to $4\times10^{-4}$ Pa, and thereafter, the above-described heating boat into which the HI-2 was put was energized and heated, and was evaporated onto the transparent support substrate at an evaporation rate of 0.1 nm/sec. , whereby a first hole transportation layer with a film thickness of 10 nm was provided.

Subsequently, the above-described heating boat into which the α-NPD was put was energized and heated, and was evaporated onto the transparent support substrate at an evaporation rate of 0.1 nm/sec., whereby a second hole transportation layer with a film thickness of 20 nm was provided.

Moreover, the above-described heating boat into which the OC-25 was put as the host compound was energized and heated, and the above-described heating boat into which Comparison 1 was put as the dopant compounds was energized and heated, and these compounds were evaporated onto the first light emitting layer at an evaporation rate respectively of 0. 1 nm/sec. , 0.010 nm/sec., whereby a light emitting layer with a film thickness of 50 nm was provided.

Moreover, the above-described heating boat into which the ET-9 was put was further energized and heated, and the ET-9 was evaporated onto the above-described light emitting layer at an evaporation rate of 0.1 mm/sec., whereby an electron transportation layer with a film thickness of 30 nm was provided.

Note that a substrate temperature at the time of evaporation was room temperature.

Subsequently, lithium fluoride was evaporated to form a cathode buffer layer with a film thickness of 0.5 nm, and further, aluminum was evaporated to form a cathode with a film thickness of 110 nm, whereby an organic EL element 9-1 was fabricated.

«Fabrication of organic EL elements 9-2 to 9-7»

In the fabrication of the organic EL element 9-1, the host compound and the dopant compound in the light emitting layer were changed to compounds described in Table 9 of FIG. 16.

Similarly except for the above-described change, organic EL elements 9-2 to 9-7 were individually fabricated.

«Evaluation of organic EL elements 9-1 to 9-7»

In the event of evaluating the obtained organic EL elements 9-1 to 9-7, the non-light emitting surface of each of the already fabricated organic EL elements was covered with a glass case, a glass substrate with a thickness of 300 μm was used as a sealing substrate, and an epoxy-based photo-curing adhesive (Luxtrack LC0629B made by Toagosei Co., Ltd.) was applied as a sealing material on a periphery of the glass substrate. Then, an obtained resultant was stacked on the above-described cathode, and was brought into intimate contact with the above-described transparent support substrate, was irradiated with UV light from the glass substrate side, and was cured and sealed. In such a way, an illumination device as shown in FIG. 5 and FIG. 6 was fabricated, and was evaluated.

For the respective samples fabricated as described above, the evaluations were performed regarding the external extraction quantum efficiency, the half-life and the voltage rise at drive time in a similar way to Example 1. Evaluation results are shown in Table 9. Note that the measurement results of the external extraction quantum efficiency, the half-life and the voltage rise at drive time in Table 9 were represented by relative values in which measurement values of the organic EL element 9-1 were taken as 100.

From Table 9, it is understood that, with respect to the organic EL element 9-1 of the comparison example, each of the organic EL elements 9-2 to 9-7 of the present invention exhibits higher light emission efficiency, a longer lifetime and suppressing the voltage rise at drive time, and characteristics thereof as an element are enhanced.

## Claims

1. An iridium complex compound represented by a following general formula (1):

general formula (1)

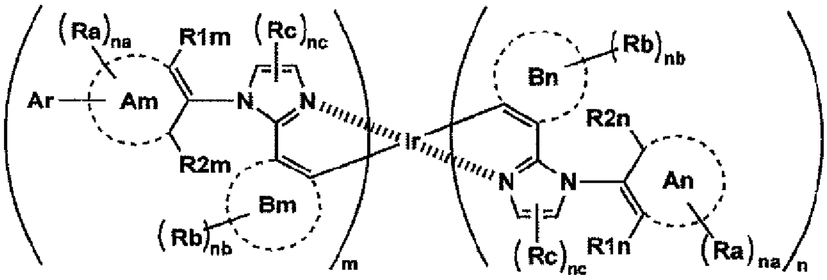

wherein in the general formula (1), each of a ring Am, a ring An, a ring Bm and a ring Bn represents a five-membered or six-membered aromatic hydrocarbon ring or aromatic heterocyclic ring; the ring An is a single ring or condensed ring composed of two rings; Ar represents an aromatic hydrocarbon ring, an aromatic heterocyclic ring, a non-aromatic hydrocarbon ring, or a non-aromatic heterocyclic ring; independently of one another, each of R1m, R2m, R1n and R2n represents an alkyl group with a carbon number of 2 or more, an aromatic hydrocarbon ring group, an aromatic heterocyclic ring group, a non-aromatic hydrocarbon ring group, or a non-aromatic heterocyclic group, and moreover, may have a substituent; independently of one another, each of Ra, Rb and Rc represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent; Ar and Ra do not bind to form a ring; each of na and nc represents 1 or 2, and nb represents an integer of 1 to 4; m represents 1, and n represents 2, and note that a state where structures of three ligands arranged in Ir are entirely same does not occur.

2. The iridium complex compound as claimed in claim 1, wherein the iridium complex is represented by a following general formula (2):

general formula (2)

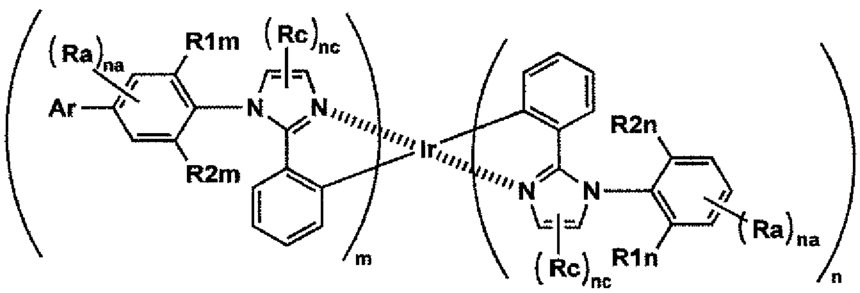

3. The iridium complex compound as claimed in claim 1, wherein the iridium complex is represented by a following general formula (3):

general formula (3)

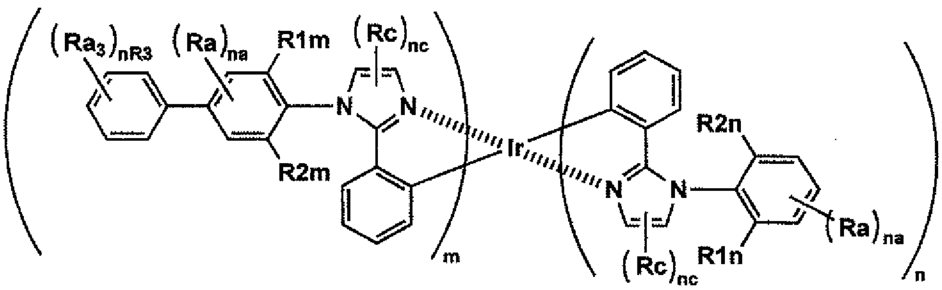

wherein in the general formula (3), Ra3 represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent and nR3 represents an integer of 1 to 5.

**4.** An organic electroluminescent element material represented by a following general formula (1):

general formula (1)

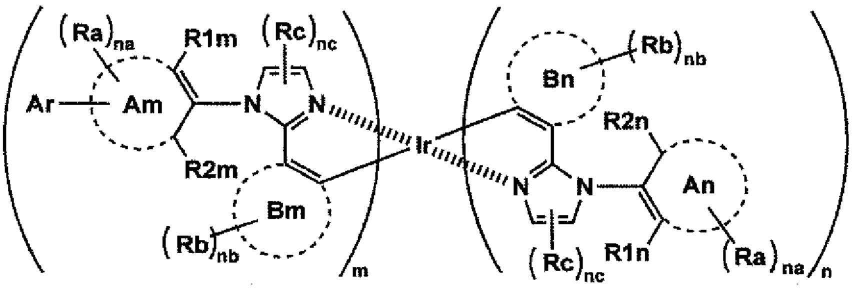

wherein in the general formula (1), each of a ring Am, a ring An, a ring Bm and a ring Bn represents a five-membered or six-membered aromatic hydrocarbon ring or aromatic heterocyclic ring; the ring An is a single ring or condensed ring composed of two rings; Ar represents an aromatic hydrocarbon ring, an aromatic heterocyclic ring, a non-aromatic hydrocarbon ring, or a non-aromatic heterocyclic ring; independently of one another, each of R1m, R2m, R1n and R2n represents an alkyl group with a carbon number of 2 or more, an aromatic hydrocarbon ring group, an aromatic heterocyclic ring group, a non-aromatic hydrocarbon ring group, or a non-aromatic heterocyclic group, and moreover, may have a substituent; independently of one another, each of Ra, Rb and Rc represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent; Ar and Ra do not bind to form a ring; each of na and nc represents 1 or 2, and nb represents an integer of 1 to 4; m represents 1, and n represents 2, and note that a state where structures of three ligands arranged in Ir are entirely same does not occur.

**5.** The organic electroluminescent element material as claimed in claim 4, wherein the organic electroluminescent element material is represented by a following general formula (2) :

general formula (2)

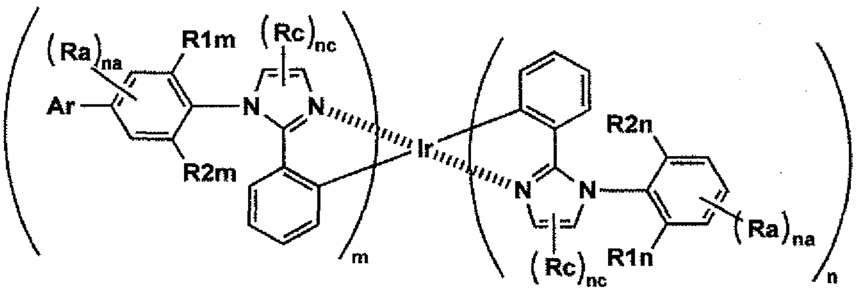

6. The organic electroluminescent element material as claimed in claim 4, wherein the organic electroluminescent element material is represented by a following general formula (3) :

general formula (3)

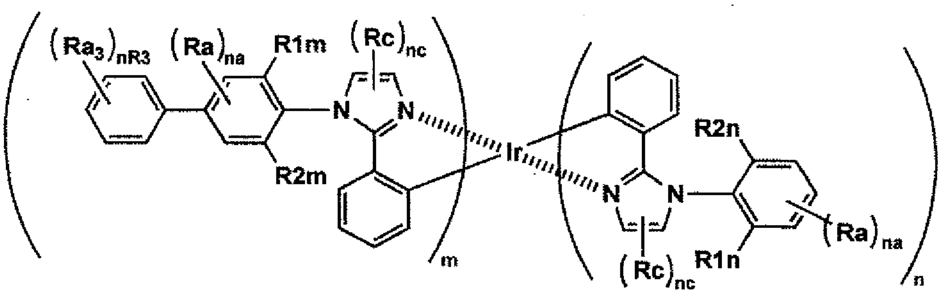

wherein in the general formula (3), Ra3 represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent; and nR3 represents an integer of 1 to 5.

7. An organic electroluminescent element in which at least one organic layer including a light emitting layer is sandwiched between an anode and a cathode,
wherein the at least one organic layer comprises an iridium complex compound represented by a following general formula (1):

general formula (1)

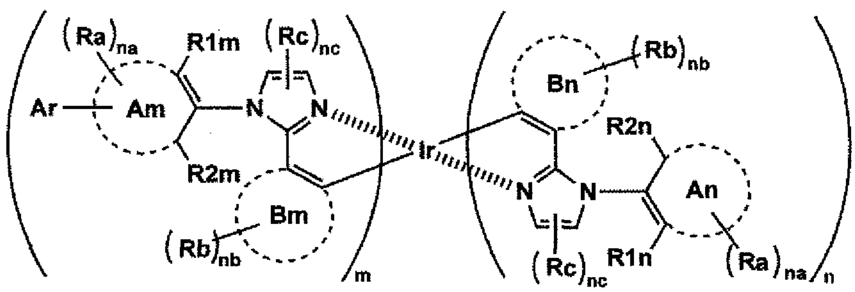

wherein in the general formula (1), each of a ring Am, a ring An, a ring Bm and a ring Bn represents a five-membered or six-membered aromatic hydrocarbon ring or aromatic heterocyclic ring; the ring An is a single ring or condensed ring composed of two rings; Ar represents an aromatic hydrocarbon ring, an aromatic heterocyclic ring, a non-aromatic hydrocarbon ring, or a non-aromatic heterocyclic ring; independently of one another, each of R1m, R2m, R1n and R2n represents an alkyl group with a carbon number of 2 or more, an aromatic hydrocarbon ring group, an aromatic heterocyclic ring group, a non-aromatic hydrocarbon ring group, or a non-aromatic heterocyclic group, and moreover, may have a substituent; independently of one another, each of Ra, Rb and Rc represents a hydrogen atom, a halogen atom, a cyano group, an alkyl group, an alkenyl group, an alkynyl group, an alkoxy group, an amino

group, a silyl group, an arylalkyl group, an aryl group, a heteroaryl group, the non-aromatic hydrocarbon ring group or the non-aromatic heterocyclic ring group, and may further have a substituent; Ar and Ra do not bind to form a ring; each of na and nc represents 1 or 2, and nb represents an integer of 1 to 4; m represents 1, and n represents 2, and note that a state where structures of three ligands arranged in Ir are entirely same does not occur.

**8.** The organic electroluminescent element as claimed in claim 7, wherein in the general formula (1), the ring Bn represents a benzene ring.

**9.** The organic electroluminescent element as claimed in claim 7 or 8, wherein in the general formula (1), the ring Bm represents a benzene ring.

**10.** The organic electroluminescent element as claimed in claim 7,
wherein the iridium complex compound is represented by a following general formula (2):

general formula (2)

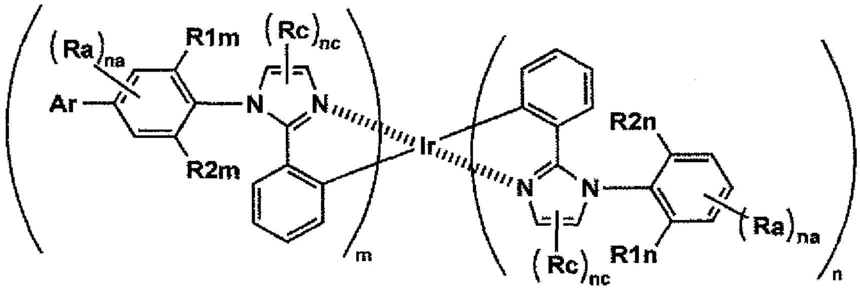

**11.** The organic electroluminescent element as claimed in any one of claims 7-10, wherein in the general formula (1) or (2), the ring Ar represents a benzene ring.

**12.** The organic electroluminescent element as claimed in claim 7,
wherein the iridium complex compound is represented by a following general formula (3):

general formula (3)

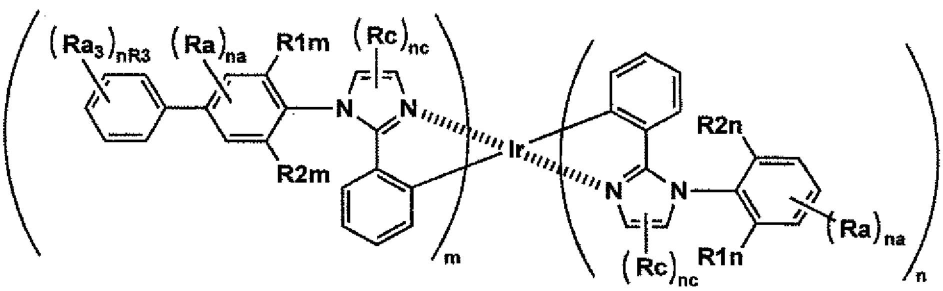

wherein in the general formula (3), Ra3 represents a hydrogen atom, a halogen atom, a cyano group, an alkyl group, an alkenyl group, an alkynyl group, an alkoxy group, an amino group, a silyl group, an arylalkyl group, an aryl group, a heteroaryl group, the non-aromatic hydrocarbon ring group or the non-aromatic heterocyclic ring group, and may further have a substituent; and nR3 represents an integer of 1 to 5.

**13.** The organic electroluminescent element as claimed in any one of claims 7-12, wherein in the general formula (1), (2) or (3), each of R1n and R2n is an alkyl group with a carbon number of 2 or more or a cycloalkyl group.

**14.** The organic electroluminescent element as claimed in any one of claims 7-13, wherein in the general formula (1), (2) or (3), each of R1m and R2m is an alkyl group with a carbon number of 2 or more or a cycloalkyl group.

**15.** The organic electroluminescent element as claimed in any one of claims 7-14, wherein in the general formula (1),

(2) or (3), at least one of R1n and R2n is a branched alkyl group with a carbon atom number of 3 or more.

16. The organic electroluminescent element as claimed in any one of claims 7-15, wherein in the general formula (1), (2) or (3), at least one of R1m and R2m is a branched alkyl group with a carbon atom number of 3 or more.

17. The organic electroluminescent element as claimed in any one of claims 7-16, wherein in the general formula (1), (2) or (3), R1n, R2n, R1m and R2m respectively are a branched alkyl group with a carbon atom number of 3 or more.

18. The organic electroluminescent element as claimed in any one of claims 7-17, wherein a light emission color is white.

19. An illumination device comprising the organic electroluminescent element as claimed in any one of claims 7-18.

20. A display device comprising the organic electroluminescent element as claimed in any one of claims 7-19.

## Patentansprüche

1. Iridiumkomplexverbindung, die durch eine folgende allgemeine Formel (1) dargestellt ist:

allgemeine Formel (1)

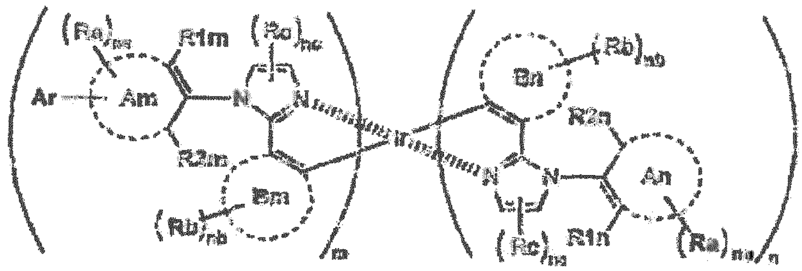

,

wobei in der allgemeinen Formel (1) jeweils ein Ring Am, ein Ring An, ein Ring Bm und ein Ring Bn einen fünfgliedrigen oder sechsgliedrigen aromatischen Kohlenwasserstoffring oder aromatischen heterocyclischen Ring darstellen; der Ring An ein Einzelring ist oder ein kondensierter Ring ist, der aus zwei Ringen besteht; Ar einen aromatischen Kohlenwasserstoffring, einen aromatischen heterocyclischen Ring, einen nicht-aromatischen Kohlenwasserstoffring oder einen nicht-aromatischen heterocyclischen Ring darstellt; unabhängig voneinander R1m, R2m, R1n und R2n jeweils eine Alkylgruppe mit einer Kohlenstoffanzahl von 2 oder mehr, eine aromatische Kohlenwasserstoff-Ringgruppe, eine aromatische heterocyclische Ringgruppe, eine nicht-aromatische Kohlenwasserstoff-Ringgruppe oder eine nicht -aromatische heterocyclische Gruppe darstellt, und außerdem einen Substituenten aufweisen kann; unabhängig voneinander Ra, Rb und Rc jeweils ein Wasserstoffatom, ein Halogenatom, eine Cyanogruppe, eine Alkylgruppe, eine Alkenylgruppe, eine Alkinylgruppe, eine Alkoxygruppe, eine Aminogruppe, eine Silylgruppe, eine Arylalkylgruppe, eine Arylgruppe, eine Heteroarylgruppe, die nicht-aromatische Kohlenwasserstoff-Ringgruppe oder die nicht-aromatische heterocyclische Ringgruppe darstellt, und außerdem einen Substituenten aufweisen kann; Ar und Ra nicht unter Bildung eines Ringes binden; na und nc jeweils 1 oder 2 darstellen; und nb eine ganze Zahl von 1 bis 4 darstellt; m 1 darstellt und n 2 darstellt, und zu beachten ist, dass kein Zustand, wobei Strukturen von drei in Ir angeordneten Liganden, die vollkommen gleich sind, auftritt.

2. Iridiumkomplexverbindung nach Anspruch 1, wobei der Iridiumkomplex eine folgende allgemeine Formel (2) dargestellt ist:

allgemeine Formel (2)

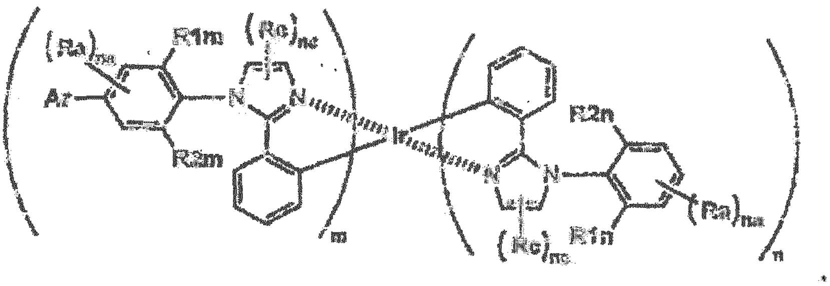

,

3. Iridiumkomplexverbindung nach Anspruch 1, wobei der Iridiumkomplex durch eine folgende allgemeine Formel (3) dargestellt ist:

allgemeine Formel (3)

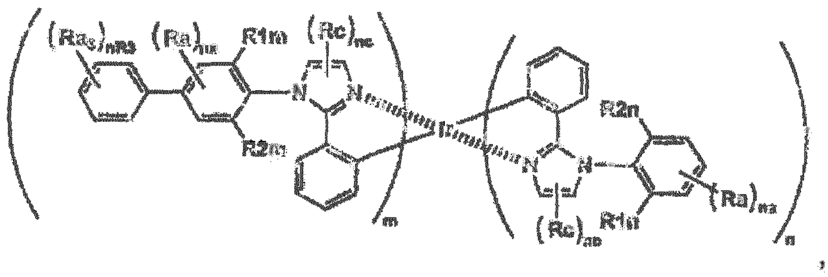

,

wobei in der allgemeinen Formel (3) Ra3 ein Wasserstoffatom, ein Halogenatom, eine Cyanogruppe, eine Alkylgruppe, eine Alkenylgruppe, eine Alkinylgruppe, eine Alkoxygruppe, eine Aminogruppe, eine Silylgruppe, eine Arylalkylgruppe, eine Arylgruppe, eine Heteroarylgruppe, die nicht-aromatische Kohlenwasserstoff-Ringgruppe oder die nicht-aromatische heterocyclische Ringgruppe darstellt, und außerdem einen Substituenten aufweisen kann, und R3 eine ganze Zahl von 1 bis 5 darstellt.

4. Organisches Elektrolumineszenz-Elementmaterial, das durch eine folgende allgemeine Formel (1) dargestellt ist:

allgemeine Formel (1)

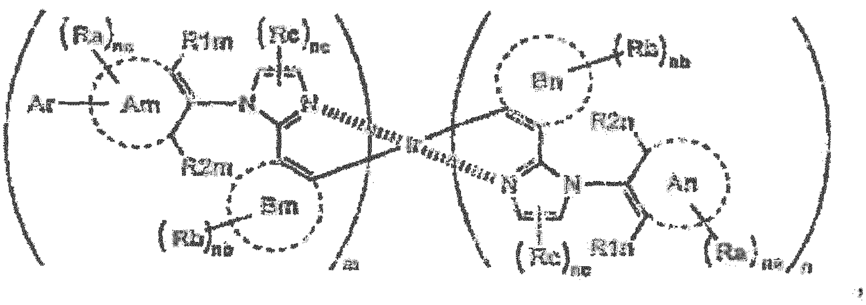

,

wobei in der allgemeinen Formel (1) jeweils ein Ring Am, ein Ring An, ein Ring Bm und ein Ring Bn einen fünfgliedrigen oder sechsgliedrigen aromatischen Kohlenwasserstoffring oder aromatischen heterocyclischen Ring darstellen; der Ring An ein Einzelring ist oder ein kondensierter Ring ist, der aus zwei Ringen besteht; Ar einen aromatischen Kohlenwasserstoffring, einen aromatischen heterocyclischen Ring, einen nicht-aromatischen Kohlenwasserstoffring oder einen nicht-aromatischen heterocyclischen Ring darstellt; unabhängig voneinander R1m, R2m, R1n und R2n jeweils eine Alkylgruppe mit einer Kohlenstoffanzahl von 2 oder mehr, eine aromatische Kohlenwasserstoff-Ringgruppe, eine aromatische heterocyclische Ringgruppe, eine nicht-aromatische Kohlenwasserstoff-Ringgruppe oder eine nicht -aromatische heterocyclische Gruppe darstellt, und außerdem einen Substituenten aufweisen kann; unabhängig voneinander Ra, Rb und Rc jeweils ein Wasserstoffatom, ein Halogenatom, eine Cyanogruppe, eine Alkylgruppe, eine Alkenylgruppe, eine Alkinylgruppe, eine Alkoxygruppe, eine Aminogruppe, eine Silylgruppe, eine Arylalkylgruppe, eine Arylgruppe, eine Heteroarylgruppe, die nicht-aromatische Kohlenwasserstoff-Ringgruppe oder die nicht-aromatische heterocyclische Ringgruppe darstellt, und außerdem einen Substituenten aufweisen kann; Ar und Ra nicht unter Bildung eines Ringes binden; na und nc jeweils 1 oder 2 darstellen; und nb eine ganze Zahl von 1 bis 4 darstellt; m 1 darstellt und n 2 darstellt, und zu beachten ist, dass kein Zustand, wobei Strukturen von drei in Ir angeordneten Liganden, die vollkommen gleich sind, auftritt.

**5.** Organisches Elektrolumineszenz-Elementmaterial nach Anspruch 4, wobei das organische Elektrolumineszenz-Elementmaterial durch eine allgemeine Formel (2) dargestellt ist:

allgemeine Formel (2)

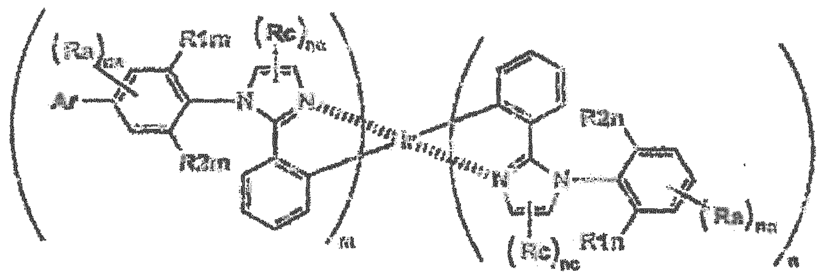

.

**6.** Organisches Elektrolumineszenz-Elementmaterial nach Anspruch 4, wobei das organische Elektrolumineszenz-Elementmaterial durch eine folgende allgemeine Formel (3) dargestellt ist:

allgemeine Formel (3)

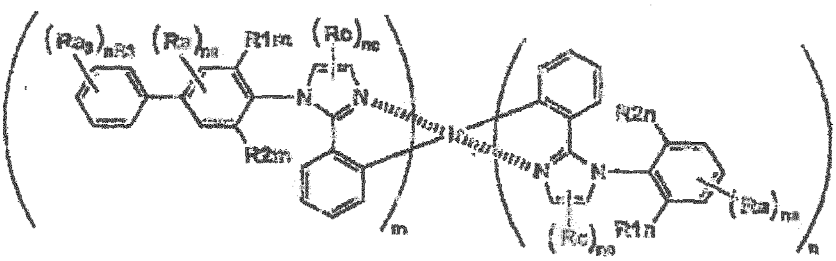

,

wobei in der allgemeinen Formel (3) Ra3 ein Wasserstoffatom, ein Halogenatom, eine Cyanogruppe, eine Alkylgruppe, eine Alkenylgruppe, eine Alkinylgruppe, eine Alkoxygruppe, eine Aminogruppe, eine Silylgruppe, eine Arylalkylgruppe, eine Arylgruppe, eine Heteroarylgruppe, die nicht-aromatische Kohlenwasserstoff-Ringgruppe oder die nicht-aromatische heterocyclische Ringgruppe darstellt, und außerdem einen Substituenten aufweisen kann, und R3 eine ganze Zahl von 1 bis 5 darstellt.

**7.** Organisches Elektrolumineszenz-Element, in dem mindestens eine organische Schicht, die eine lichtemittierende Schicht einschließt, zwischen einer Anode und einer Kathode eingeschlossen ist, wobei die mindestens eine organische Schicht eine Iridiumkomplexverbindung umfasst, die durch eine folgende allgemeine Formel (1) dargestellt ist:

allgemeine Formel (1)

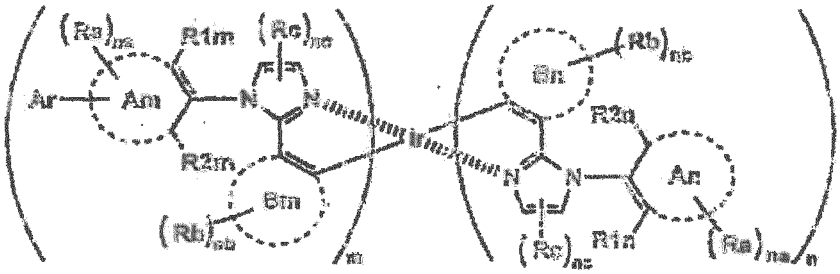

,

wobei in der allgemeinen Formel (1) jeweils ein Ring Am, ein Ring An, ein Ring Bm und ein Ring Bn einen fünfgliedrigen oder sechsgliedrigen aromatischen Kohlenwasserstoffring oder aromatischen heterocyclischen Ring darstellen; der Ring An ein Einzelring ist oder ein kondensierter Ring ist, der aus zwei Ringen besteht; Ar einen aromatischen Kohlenwasserstoffring, einen aromatischen heterocyclischen Ring, einen nicht-aromatischen Kohlenwasserstoffring oder einen nicht-aromatischen heterocyclischen Ring darstellt; unabhängig voneinander R1m, R2m, R1n und R2n jeweils eine Alkylgruppe mit einer Kohlenstoffanzahl von 2 oder mehr, eine aromatische Kohlenwasserstoff-Ringgruppe, eine aromatische heterocyclische Ringgruppe, eine nicht-aromatische Kohlenwasserstoff-Ringgruppe oder eine nicht -aromatische heterocyclische Gruppe darstellt, und außerdem einen Substituenten aufweisen kann; unabhängig voneinander Ra, Rb und Rc jeweils ein Wasserstoffatom, ein Halogenatom, eine Cyanogruppe, eine Alkylgruppe, eine Alkenylgruppe, eine Alkinylgruppe, eine Alkoxygruppe, eine Aminogruppe, eine Silylgruppe, eine Arylalkylgruppe, eine Arylgruppe, eine Heteroarylgruppe, die nicht-aromatische Kohlenwasserstoff-Ringgruppe oder die nicht-aromatische heterocyclische Ringgruppe darstellt, und außerdem einen Substituenten aufweisen kann; Ar und Ra nicht unter Bildung eines Ringes binden; na und nc jeweils 1 oder 2 darstellen; und nb eine ganze Zahl von 1 bis 4 darstellt; m 1 darstellt und n 2 darstellt, und zu beachten ist, dass kein Zustand, wobei Strukturen von drei in Ir angeordneten Liganden, die vollkommen gleich sind, auftritt.

**8.** Organisches Elektrolumineszenz-Element nach Anspruch 7, wobei in der allgemeinen Formel (1) der Ring Bn einen Benzolring darstellt.

**9.** Organisches Elektrolumineszenz-Element nach Anspruch 7 oder 8, wobei in der allgemeinen Formel (1) der Ring Bm einen Benzolring darstellt.

**10.** Organisches Elektrolumineszenz-Element nach Anspruch 7, wobei die Iridiumkomplexverbindung durch eine folgende allgemeine Formel (2) dargestellt ist:

allgemeine Formel (2):

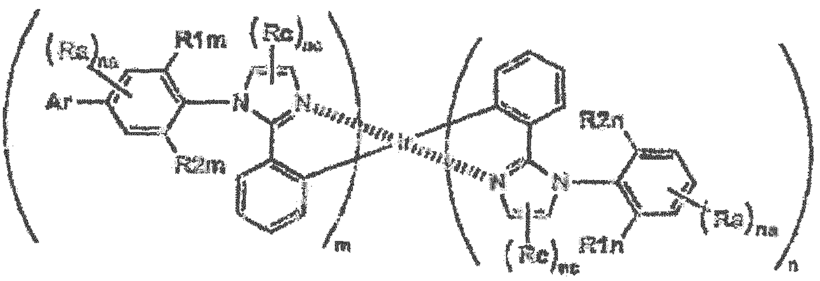

.

**11.** Organisches Elektrolumineszenz-Element nach einem der Ansprüche 7 - 10, wobei in der allgemeinen Formel (1) oder (2) der Ring Ar einen Benzolring darstellt.

**12.** Organisches Elektrolumineszenz-Element nach Anspruch 7, wobei die Iridiumkomplexverbindung durch eine folgende allgemeine Formel (3) dargestellt ist:

allgemeine Formel (3)

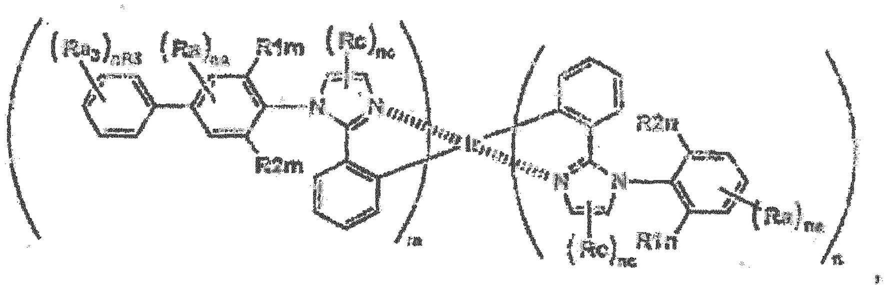

wobei in der allgemeinen Formel (3) Ra3 ein Wasserstoffatom, ein Halogenatom, eine Cyanogruppe, eine Alkylgruppe, eine Alkenylgruppe, eine Alkinylgruppe, eine Alkoxygruppe, eine Aminogruppe, eine Silylgruppe, eine Arylalkylgruppe, eine Arylgruppe, eine Heteroarylgruppe, die nicht-aromatische Kohlenwasserstoff-Ringgruppe oder die nicht-aromatische heterocyclische Ringgruppe darstellt, und außerdem einen Substituenten aufweisen kann, und R3 eine ganze Zahl von 1 bis 5 darstellt.

**13.** Organisches Elektrolumineszenz-Element nach einem der Ansprüche 7 - 12, wobei in der allgemeinen Formel (1), (2) oder (3) R1n und R2n jeweils eine Alkylgruppe mit einer Kohlenstoffanzahl von 2 oder mehr oder eine Cycloalkylgruppe darstellen.

**14.** Organisches Elektrolumineszenz-Element nach einem der Ansprüche 7 - 13, wobei in der allgemeinen Formel (1), (2) oder (3) R1m und R2m jeweils eine Alkylgruppe mit einer Kohlenstoffanzahl von 2 oder mehr oder eine Cycloalkylgruppe darstellen.

**15.** Organisches Elektrolumineszenz-Element nach einem der Ansprüche 7 - 14, wobei in der allgemeinen Formel (1), (2) oder (3) mindestens eines von R1 n und R2n eine verzweigte Alkylgruppe mit einer Kohlenstoffatomanzahl von 3 oder mehr ist.

**16.** Organisches Elektrolumineszenz-Element nach einem der Ansprüche 7 - 15, wobei in der allgemeinen Formel (1), (2) oder (3) mindestens eines von R1m und R2m eine verzweigte Alkylgruppe mit einer Kohlenstoffatomanzahl von 3 oder mehr ist.

**17.** Organisches Elektrolumineszenz-Element nach einem der Ansprüche 7 - 16, wobei in der allgemeinen Formel (1), (2) oder (3) R1n, R2n, R1m und R2m jeweils eine verzweigte Alkylgruppe mit einer Kohlenstoffatomanzahl von 3 oder mehr sind.

**18.** Organisches Elektrolumineszenz-Element nach einem der Ansprüche 7 - 17, wobei eine Lichtemissionsfarbe Weiß ist.

**19.** Beleuchtungsgerät, umfassend das organische Elektrolumineszenz-Element nach einem der Ansprüche 7 - 18.

**20.** Anzeigegerät, umfassend das organische Elektrolumineszenz-Element nach einem der Ansprüche 7 - 19.

## Revendications

**1.** Composé complexe d'iridium représenté par une formule générale (1) :

Formule générale (1)

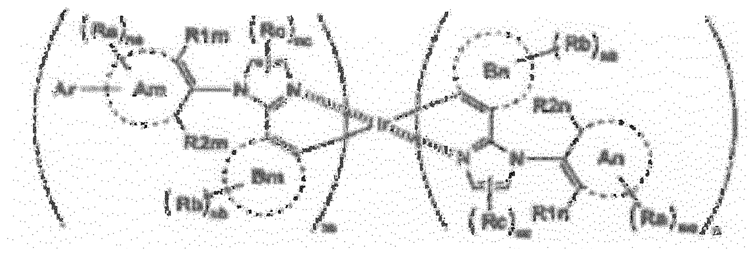

dans lequel dans la formule générale (1) chacun d'un cycle Am, d'un cycle An, d'un cycle Bm et d'un cycle Bn représente un cycle hydrocarbure aromatique à cinq chaînons ou six chaînons ou un cycle hétérocyclique aromatique ; le cycle An est un simple cycle ou un cycle condensé composé de deux cycles ; Ar représente un cycle hydrocarbure aromatique, un cycle hétérocyclique aromatique, un cycle hydrocarbure non aromatique ou un cycle hétérocyclique non aromatique ; indépendamment l'un de l'autre, chacun de R1m, R2m, R1n et R2n représente un groupe alkyle avec un nombre de carbones de 2 ou plus, un groupe cyclique hydrocarbure aromatique, un groupe cyclique hétérocyclique aromatique, un groupe cyclique hydrocarbure non aromatique ou un groupe hétérocyclique non aromatique, et de plus, peut avoir un substituant ; indépendamment l'un de l'autre, chacun de Ra, Rb et Rc représente un atome d'hydrogène, un atome d'halogène, un groupe cyano, un groupe alkyle, un groupe alcényle, un groupe alcynyle, une groupe alcoxy, un groupe amino, un groupe silyle, un groupe arylalkyle, un groupe aryle, un groupe hétéroaryle, le groupe cyclique hydrocarbure non aromatique ou le groupe cyclique hétérocyclique non aromatique, et peut en outre avoir un substituant ; Ar et Ra ne se lient pas pour former un cycle ; chacun de na et nc représente 1 ou 2, et nb représente un nombre entier de 1 à 4 ; m représente 1, et n représente 2, et notez qu'un état où les structures de trois ligands disposés dans Ir sont entièrement les mêmes ne se produit pas.

2. Composé de complexe d'iridium selon la revendication 1, dans lequel le complexe d'iridium est représenté par une formule générale (2) suivante :

formule générale (2)

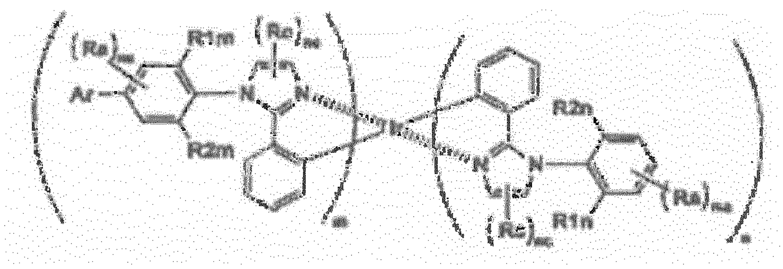

3. Composé de complexe d'iridium selon la revendication 1, dans lequel le complexe d'iridium est représenté par une formule générale (3) suivante :

formule générale (3)

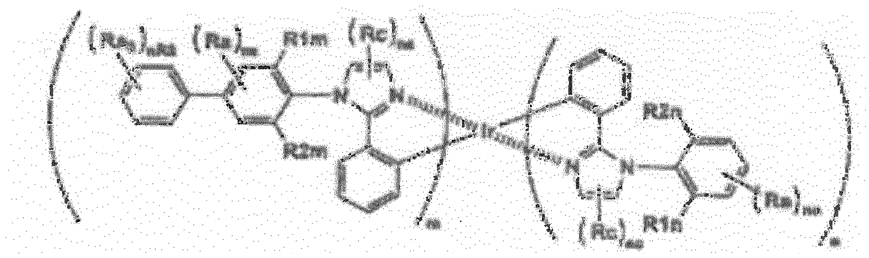

dans lequel dans la formule générale (3), Ra3 représente un atome d'hydrogène, un atome d'halogène, un groupe cyano, un groupe alkyle, un groupe alcényle, un groupe alcynyle, une groupe alcoxy, un groupe amino, un groupe silyle, un groupe arylalkyle, un groupe aryle, un groupe hétéroaryle, le groupe cyclique hydrocarbure non aromatique ou le groupe cyclique hétérocyclique non aromatique, et peut en outre avoir un substituant et nR3 représente un nombre entier de 1 à 5.

**4.** Matériau d'élément électroluminescent organique représenté par une formule générale (1)

formule générale (1)

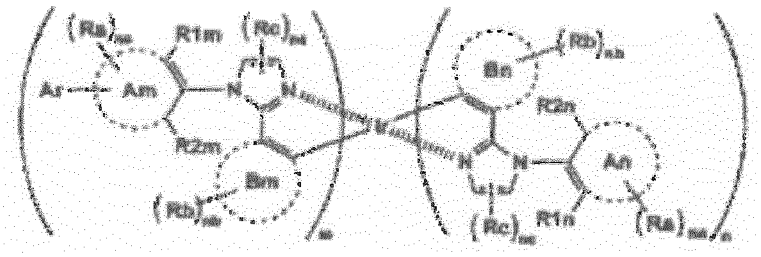

dans lequel, dans la formule générale (1), chacun d'un cycle Am, d'un cycle An, d'un cycle Bm et d'un cycle Bn représente un cycle hydrocarbure aromatique à cinq chaînons ou six chaînons ou un cycle hétérocyclique aromatique ; le cycle An est un simple cycle ou un cycle condensé composé de deux cycles ; Ar représente un cycle hydrocarbure aromatique, un cycle hétérocyclique aromatique, un cycle hydrocarbure non aromatique ou un cycle hétérocyclique non aromatique ; indépendamment l'un de l'autre, chacun de R1 m, R2m, R1 n et R2n représente un groupe alkyle avec un nombre de carbones de 2 ou plus, un groupe cyclique hydrocarbure aromatique, un groupe cyclique hétérocyclique aromatique, un groupe cyclique hydrocarbure non aromatique ou un groupe hétérocyclique non aromatique, et de plus, peut avoir un substituant ; indépendamment l'un de l'autre, chacun de Ra, Rb et Rc représente un atome d'hydrogène, un atome d'halogène, un groupe cyano, un groupe alkyle, un groupe alcényle, un groupe alcynyle, une groupe alcoxy, un groupe amino, un groupe silyle, un groupe arylalkyle, un groupe aryle, un groupe hétéroaryle, le groupe cyclique hydrocarbure non aromatique ou le groupe cyclique hétérocyclique non aromatique, et peut en outre avoir un substituant ; Ar et Ra ne se lient pas pour former un cycle ; chacun de na et nc représente 1 ou 2, et nb représente un nombre entier de 1 à 4 ; m représente 1, et n représente 2, et notez qu'un état où les structures de trois ligands disposés dans Ir sont entièrement les mêmes ne se produit pas.

**5.** Matériau d'élément électroluminescent organique selon la revendication 4, dans lequel le matériau d'élément électroluminescent organique est représenté par une formule générale (2) :

formule générale (2)

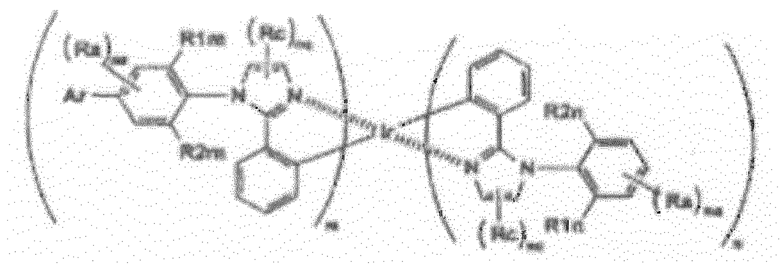

**6.** Matériau d'élément électroluminescent organique selon la revendication 4, dans lequel le matériau d'élément électroluminescent organique est représenté par une formule générale (3)

formule générale (3)

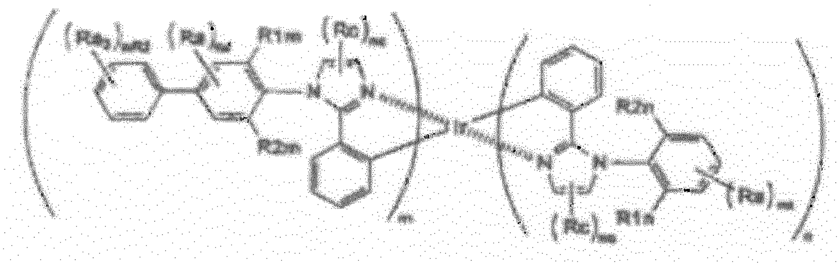

dans lequel dans la formule générale (3), Ra3 représente un atome d'hydrogène, un atome d'halogène, un groupe cyano, un groupe alkyle, un groupe alcényle, un groupe alcynyle, une groupe alcoxy, un groupe amino, un groupe silyle, un groupe arylalkyle, un groupe aryle, un groupe hétéroaryle, le groupe cyclique hydrocarbure non aromatique ou le groupe cyclique hétérocyclique non aromatique, et peut en outre avoir un substituant et nR3 représente un nombre entier de 1 à 5.

**7.** Élément électroluminescent organique dans lequel au moins un couche organique comprenant une couche émettrice de lumière est prise en sandwich entre une anode et une cathode,
dans lequel la au moins une couche organique comprend un composé complexe d'iridium représenté par une formule générale (1) suivante :

formule générale (1)

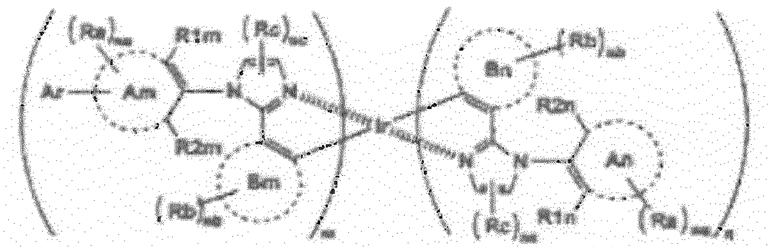

dans lequel dans la formule générale (1), chacun d'un cycle Am, d'un cycle An, d'un cycle Bm et d'un cycle Bn représente un cycle hydrocarbure aromatique à cinq chaînons ou six chaînons ou un cycle hétérocyclique aromatique ; le cycle An est un simple cycle ou un cycle condensé composé de deux cycles ; Ar représente un cycle hydrocarbure aromatique, un cycle hétérocyclique aromatique, un cycle hydrocarbure non aromatique ou un cycle hétérocyclique non aromatique ; indépendamment l'un de l'autre, chacun de R1m, R2m, R1n et R2n représente un groupe alkyle avec un nombre de carbones de 2 ou plus, un groupe cyclique hydrocarbure aromatique, un groupe cyclique hétérocyclique aromatique, un groupe cyclique hydrocarbure non aromatique ou un groupe hétérocyclique non aromatique, et de plus, peut avoir un substituant ; indépendamment l'un de l'autre, chacun de Ra, Rb et Rc représente un atome d'hydrogène, un atome d'halogène, un groupe cyano, un groupe alkyle, un groupe alcényle, un groupe alcynyle, une groupe alcoxy, un groupe amino, un groupe silyle, un groupe arylalkyle, un groupe aryle, un groupe hétéroaryle, le groupe cyclique hydrocarbure non aromatique ou le groupe cyclique hétérocyclique non aromatique, et peut en outre avoir un substituant ; Ar et Ra ne se lient pas pour former un cycle ; chacun de na et nc représente 1 ou 2, et nb représente un nombre entier de 1 à 4 ; m représente 1, et n représente 2, et notez qu'un état où les structures de trois ligands disposés dans Ir sont entièrement les mêmes ne se produit pas.

**8.** Élément électroluminescent organique selon la revendication 7, dans lequel dans la formule générale (1), le cycle Bn représente un cycle benzène.

**9.** Élément électroluminescent organique selon la revendication 7 ou 8, dans lequel dans la formule générale (1), le cycle Bm représente un cycle benzène.

**10.** Élément électroluminescent organique selon la revendication 7,
dans lequel le composé complexe d'iridium est représenté par une formule générale (2):

formule générale (2)

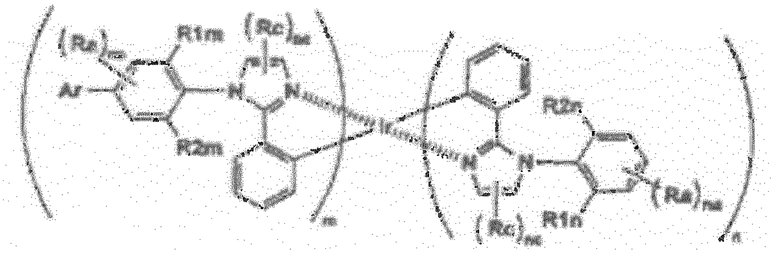

11. Élément électroluminescent organique selon l'une quelconque des revendications 7 à 10, dans lequel dans la formule générale (1) ou (2), le cycle Ar représente un cycle benzène.

12. Élément électroluminescent organique selon la revendication 7, dans lequel le composé complexe d'iridium est représenté par une formule générale (3) :

formule générale (3)

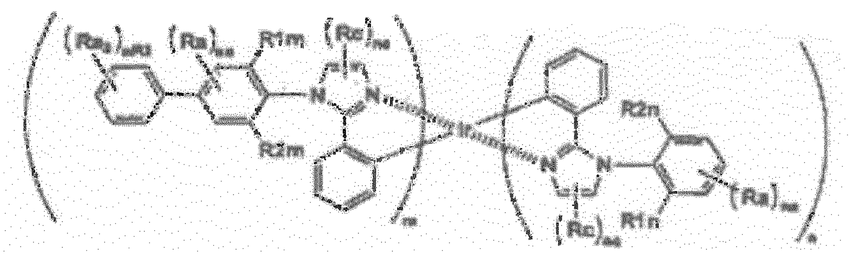

dans lequel dans la formule générale (3), Ra3 représente un atome d'hydrogène, un atome d'halogène, un groupe cyano, un groupe alkyle, un groupe alcényle, un groupe alcynyle, une groupe alcoxy, un groupe amino, un groupe silyle, un groupe arylalkyle, un groupe aryle, un groupe hétéroaryle, le groupe cyclique hydrocarbure non aromatique ou le groupe cyclique hétérocyclique non aromatique, et peut en outre avoir un substituant ; et nR3 représente un nombre entier de 1 à 5.

13. Élément électroluminescent organique selon l'une quelconque des revendications 7 à 12, dans lequel dans la formule générale (1), (2) ou (3), chacun de R1n et R2n est un groupe alkyle avec un nombre de carbones de 2 ou plus ou un groupe cycloalkyle.

14. Élément électroluminescent organique selon l'une quelconque des revendications 7 à 13, dans lequel dans la formule générale (1), (2) ou (3), chacun de R1 m et R2m est un groupe alkyle avec un nombre de carbones de 2 ou plus ou un groupe cycloalkyle.

15. Élément électroluminescent organique selon l'une quelconque des revendications 7 à 14, dans lequel dans la formule générale (1), (2) ou (3), au moins un de R1n et R2n est un groupe alkyle ramifié avec un nombre de carbones de 3 ou plus.

16. Élément électroluminescent organique selon l'une quelconque des revendications 7 à 15, dans lequel dans la formule générale (1), (2) ou (3), au moins un de R1m et R2m est un groupe alkyle ramifié avec un nombre de carbones de 3 ou plus.

17. Élément électroluminescent organique selon l'une quelconque des revendications 7 à 16, dans lequel dans la formule générale (1), (2) ou (3), R1n, R2n, R1 m et R2m sont respectivement un groupe alkyle ramifié avec un nombre de carbones de 3 ou plus.

**18.** Élément électroluminescent organique selon l'une quelconque des revendications 7 à 17, dans lequel une couleur d'émission de lumière est le blanc.

**19.** Dispositif d'illumination comprenant l'élément électroluminescent organique selon l'une quelconque des revendications 7 à 18.

**20.** Dispositif d'affichage comprenant l'élément électroluminescent organique selon l'une quelconque des revendications 7 à 19.

FIG.1

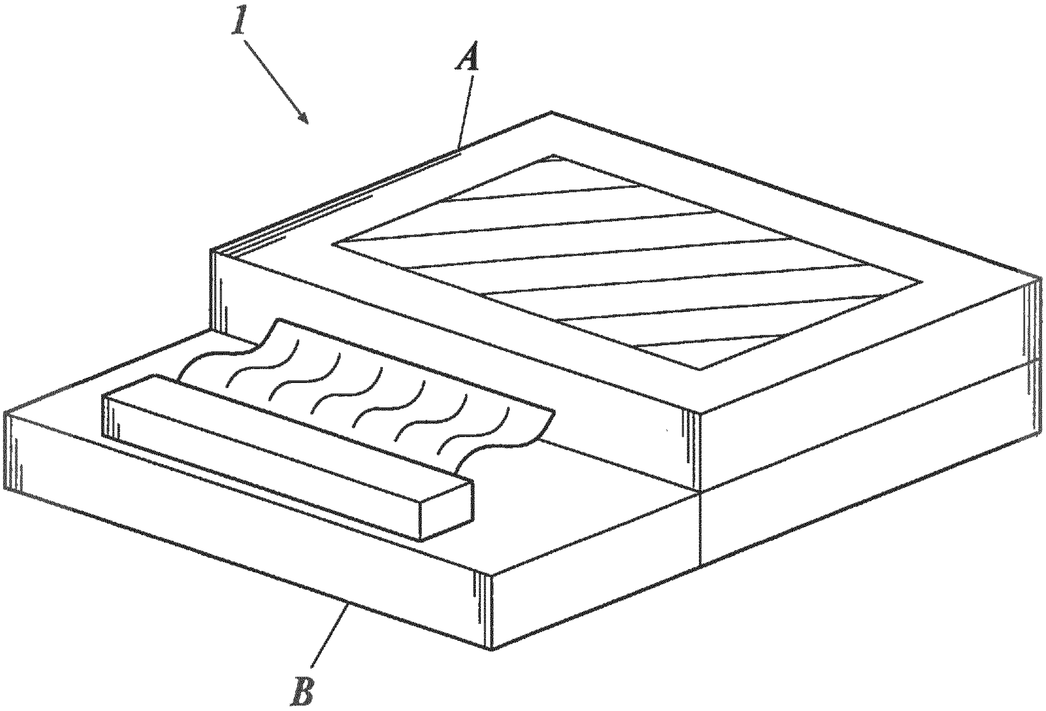


FIG.2

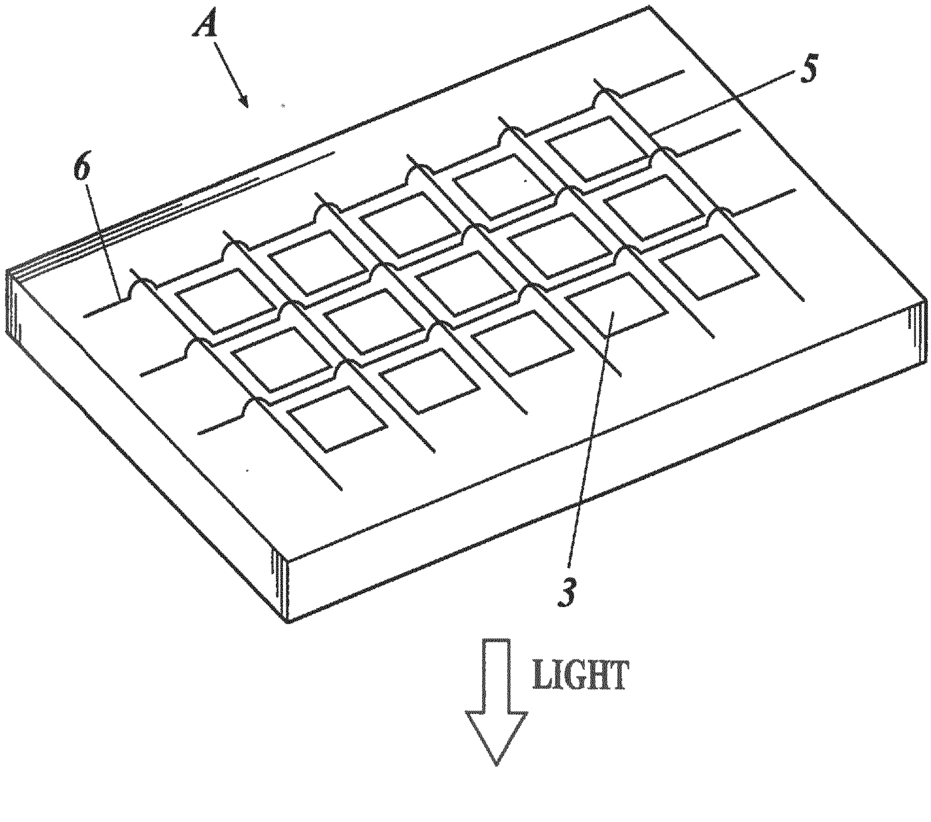

FIG.3

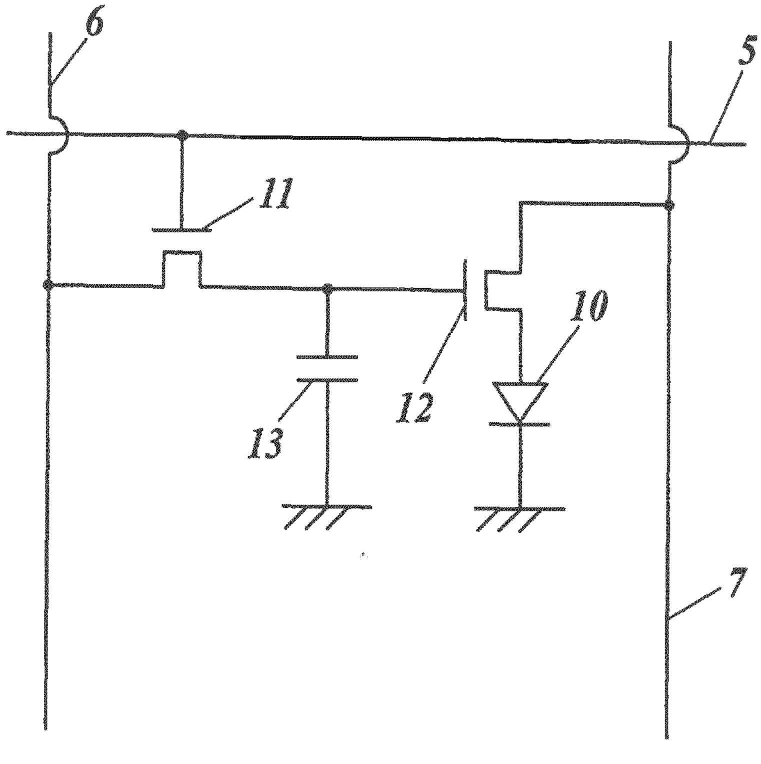

FIG.4

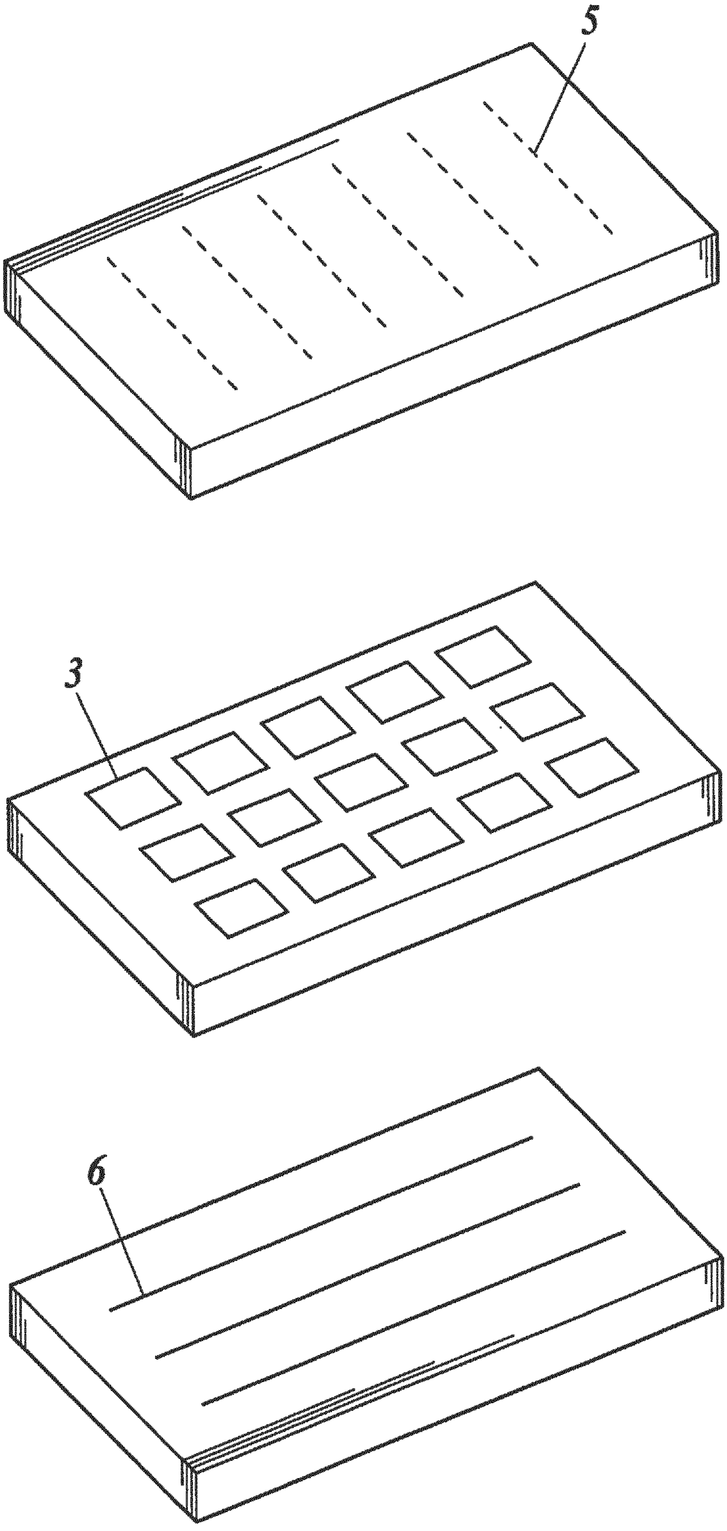

FIG.5

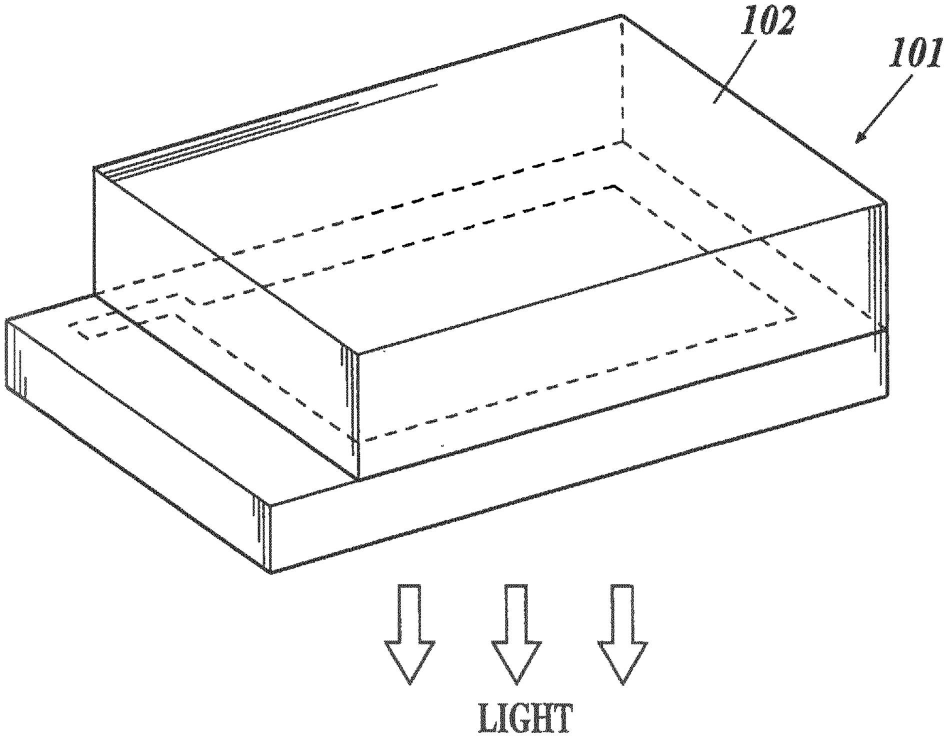


FIG.6

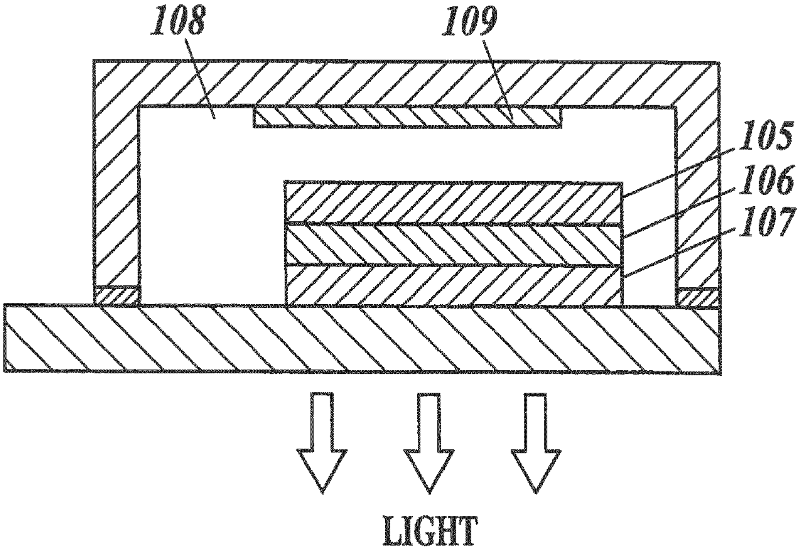

FIG. 7A

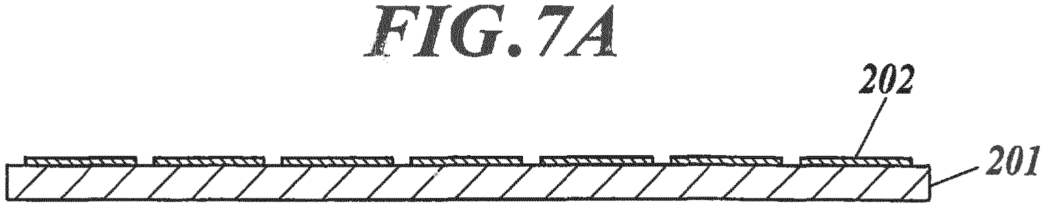


FIG. 7B

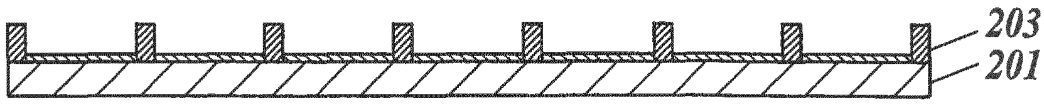


FIG. 7C

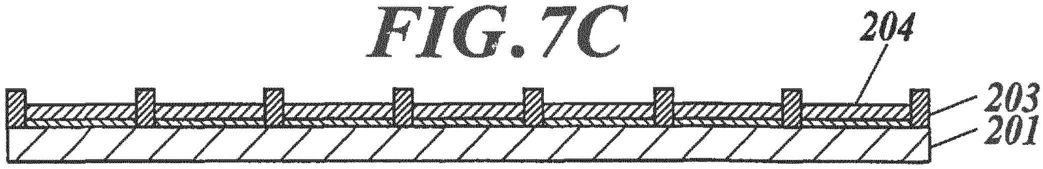


FIG. 7D

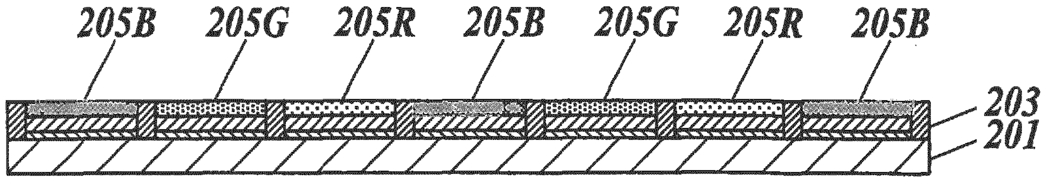


FIG. 7E

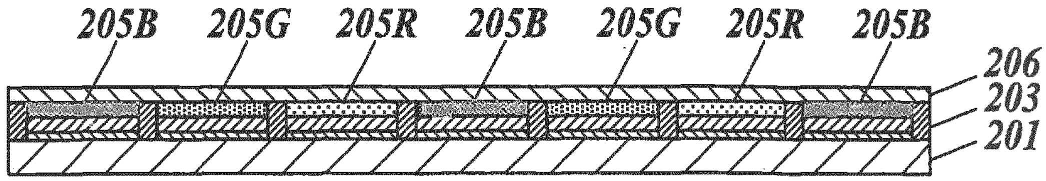

# FIG.8

TABLE 1

| ELEMENT NUMBER | HOST COMPOUND | DOPANT COMPOUND | EXTERNAL QUANTUM EFFICIENCY | HALF-LIFE | VOLTAGE RISE AT DRIVE TIME | THERMAL STABILITY EVALUATION | | REMARKS |
|---|---|---|---|---|---|---|---|---|
| | | | | | | HALF-LIFE (3RD TIME) | HALF-LIFE (5TH TIME) | |
| 1−1 | OC-30 | COMPARISON 1 | 100 | 100 | 100 | 82 | 70 | COMPARATIVE EXAMPLE |
| 1−2 | OC-30 | COMPARISON 2 | 101 | 97 | 99 | 91 | 85 | COMPARATIVE EXAMPLE |
| 1−3 | OC-30 | DP-1 | 107 | 120 | 80 | 120 | 119 | not according to the invention |
| 1−4 | OC-11 | DP-2 | 105 | 113 | 77 | 114 | 113 | PRESENT INVENTION |
| 1−5 | OC-29 | DP-5 | 103 | 108 | 90 | 106 | 103 | not according to the invention |
| 1−6 | OC-29 | DP-6 | 110 | 110 | 88 | 109 | 110 | not according to the invention |
| 1−7 | OC-15 | DP-10 | 110 | 107 | 91 | 106 | 105 | not according to the invention |
| 1−8 | 1 | DP-18 | 111 | 112 | 85 | 111 | 112 | PRESENT INVENTION |
| 1−9 | 53 | DP-19 | 108 | 109 | 90 | 109 | 108 | not according to the invention |
| 1−10 | 1 | DP-20 | 107 | 105 | 91 | 105 | 106 | PRESENT INVENTION |

# FIG. 9

TABLE 2

| ELEMENT NUMBER | HOST COMPOUND | DOPANT COMPOUND | EXTERNAL QUANTUM EFFICIENCY | HALF-LIFE | VOLTAGE RISE AT DRIVE TIME | REMARKS |
|---|---|---|---|---|---|---|
| 2−1 | OC-11 | COMPARISON 1 | 100 | 100 | 100 | COMPARATIVE EXAMPLE |
| 2−2 | OC-11 | COMPARISON 2 | 100 | 99 | 99 | COMPARATIVE EXAMPLE |
| 2−3 | OC-11 | DP-1 | 111 | 120 | 80 | not according to the invention |
| 2−4 | OC-4 | DP-3 | 112 | 118 | 77 | not according to the invention |
| 2−5 | OC-12 | DP-9 | 110 | 111 | 90 | not according to the invention |
| 2−6 | OC-29 | DP-13 | 108 | 107 | 85 | not according to the invention |
| 2−7 | 26 | DP-18 | 112 | 107 | 91 | PRESENT INVENTION |

# FIG.10

TABLE 3

| ELEMENT NUMBER | HOST COMPOUND | DOPANT COMPOUND | EXTERNAL QUANTUM EFFICIENCY | HALF-LIFE | VOLTAGE RISE AT DRIVE TIME | THERMAL STABILITY EVALUATION | | REMARKS |
|---|---|---|---|---|---|---|---|---|
| | | | | | | HALF-LIFE (3RD TIME) | HALF-LIFE (5TH TIME) | |
| 3−1 | OC−11 | COMPARISON 1 | 100 | 100 | 100 | 80 | 65 | COMPARATIVE EXAMPLE |
| 3−2 | OC−11 | COMPARISON 2 | 101 | 97 | 101 | 88 | 75 | COMPARATIVE EXAMPLE |
| 3−3 | OC−11 | DP−1 | 107 | 122 | 80 | 123 | 122 | not according to the |
| 3−4 | OC−11 | DP−4 | 105 | 121 | 77 | 120 | 120 | PRESENT INVENTION |
| 3−5 | 1 | DP−21 | 111 | 112 | 85 | 111 | 112 | PRESENT INVENTION |

# FIG.11

TABLE 4

| ELEMENT NUMBER | DOPANT COMPOUND | EVAPORATION RATE [nm/s] | EXTERNAL QUANTUM EFFICIENCY | HALF-LIFE | DRIVE VOLTAGE | REMARKS |
|---|---|---|---|---|---|---|
| 5−1 | COMPARISON 3 | 0.005 | 40 | 54 | 120 | COMPARATIVE EXAMPLE |
| 5−2 | COMPARISON 3 | 0.010 | 70 | 88 | 107 | COMPARATIVE EXAMPLE |
| 5−3 | COMPARISON 3 | 0.015 | 100 | 100 | 100 | COMPARATIVE EXAMPLE |
| 5−4 | COMPARISON 3 | 0.025 | 68 | 70 | 98 | COMPARATIVE EXAMPLE |
| 5−5 | DP-38 | 0.005 | 110 | 320 | 88 | PRESENT INVENTION |
| 5−6 | DP-38 | 0.010 | 117 | 360 | 83 | PRESENT INVENTION |
| 5−7 | DP-38 | 0.015 | 119 | 350 | 80 | PRESENT INVENTION |
| 5−8 | DP-38 | 0.025 | 113 | 310 | 77 | PRESENT INVENTION |
| 5−9 | DP-73 | 0.005 | 105 | 165 | 101 | PRESENT INVENTION |
| 5−10 | DP-73 | 0.010 | 112 | 157 | 92 | PRESENT INVENTION |
| 5−11 | DP-73 | 0.015 | 111 | 152 | 89 | PRESENT INVENTION |
| 5−12 | DP-73 | 0.025 | 102 | 139 | 87 | PRESENT INVENTION |

# FIG.12

TABLE 5

| ELEMENT NUMBER | HOST COMPOUND | DOPANT COMPOUND | EVAPORATION RATE [nm/s] | EXTERNAL QUANTUM EFFICIENCY | HALF-LIFE | CHROMA SHIFT [ΔE] | REMARKS |
|---|---|---|---|---|---|---|---|
| 6−1 | 24 | COMPARISON 4 | 0.010 | 71 | 88 | 0.08 | COMPARATIVE EXAMPLE |
| 6−2 | 24 | COMPARISON 4 | 0.015 | 100 | 100 | 0.07 | COMPARATIVE EXAMPLE |
| 6−3 | 24 | COMPARISON 4 | 0.020 | 85 | 92 | 0.07 | COMPARATIVE EXAMPLE |
| 6−4 | 24 | COMPARISON 4 | 0.025 | 65 | 87 | 0.06 | COMPARATIVE EXAMPLE |
| 6−5 | 24 | DP-18 | 0.010 | 104 | 110 | 0.06 | PRESENT INVENTION |
| 6−6 | 24 | DP-18 | 0.015 | 110 | 115 | 0.06 | PRESENT INVENTION |
| 6−7 | 24 | DP-18 | 0.020 | 111 | 118 | 0.04 | PRESENT INVENTION |
| 6−8 | 24 | DP-18 | 0.025 | 110 | 116 | 0.03 | PRESENT INVENTION |
| 6−9 | 24 | DP-38 | 0.010 | 110 | 207 | 0.05 | PRESENT INVENTION |
| 6−10 | 24 | DP-38 | 0.015 | 116 | 216 | 0.03 | PRESENT INVENTION |
| 6−11 | 24 | DP-38 | 0.020 | 118 | 231 | 0.02 | PRESENT INVENTION |
| 6−12 | 24 | DP-38 | 0.025 | 115 | 210 | 0.02 | PRESENT INVENTION |
| 6−13 | OC-15 | DP-38 | 0.010 | 105 | 107 | 0.06 | PRESENT INVENTION |
| 6−14 | OC-15 | DP-38 | 0.015 | 109 | 116 | 0.05 | PRESENT INVENTION |
| 6−15 | OC-15 | DP-38 | 0.020 | 112 | 112 | 0.03 | PRESENT INVENTION |
| 6−16 | OC-15 | DP-38 | 0.025 | 108 | 110 | 0.02 | PRESENT INVENTION |

# *FIG.13*

TABLE 6

| ELEMENT NUMBER | DOPANT COMPOUND | DOPANT CONCENTRATION [%] | PL INTENSITY | REMARKS |
|---|---|---|---|---|
| 7−1 | COMPARISON 1 | 5 | 100 | COMPARATIVE EXAMPLE |
| 7−2 | COMPARISON 1 | 15 | 95 | COMPARATIVE EXAMPLE |
| 7−3 | COMPARISON 1 | 25 | 89 | COMPARATIVE EXAMPLE |
| 7−4 | DP-38 | 5 | 100 | PRESENT INVENTION |
| 7−5 | DP-38 | 15 | 97 | PRESENT INVENTION |
| 7−6 | DP-38 | 25 | 95 | PRESENT INVENTION |

# FIG.14

TABLE 7

| ELEMENT NUMBER | PL INTENSITY BEFORE STORAGE | PL INTENSITY AFTER STORAGE | REMARKS |
|---|---|---|---|
| 7−3 | 89 | 74 | COMPARATIVE EXAMPLE |
| 7−6 | 95 | 87 | PRESENT INVENTION |

# FIG.15

TABLE 8

| ELEMENT NUMBER | HOST COMPOUND | DOPANT COMPOUND | EXTERNAL QUANTUM EFFICIENCY | HALF-LIFE | VOLTAGE RISE AT DRIVE TIME | THERMAL STABILITY EVALUATION | | REMARKS |
|---|---|---|---|---|---|---|---|---|
| | | | | | | HALF-LIFE (3RD TIME) | HALF-LIFE (5TH TIME) | |
| 8−1 | COMPOUND 27 | COMPARISON 3 | 100 | 100 | 100 | 78 | 67 | COMPARATIVE EXAMPLE |
| 8−2 | COMPOUND 27 | DP−42 | 105 | 115 | 93 | 113 | 110 | PRESENT INVENTION |
| 8−3 | COMPOUND 27 | DP−44 | 108 | 113 | 92 | 112 | 111 | PRESENT INVENTION |
| 8−4 | COMPOUND 27 | DP−58 | 107 | 117 | 90 | 116 | 115 | PRESENT INVENTION |
| 8−5 | COMPOUND 27 | DP−8 | 110 | 122 | 89 | 121 | 121 | PRESENT INVENTION |
| 8−6 | COMPOUND 27 | DP−37 | 111 | 121 | 87 | 122 | 122 | not according to the invention |
| 8−7 | COMPOUND 8 | DP−37 | 110 | 125 | 84 | 124 | 123 | not according to the invention |

# FIG.16

TABLE 9

| ELEMENT NUMBER | HOST COMPOUND | DOPANT COMPOUND | EXTERNAL QUANTUM EFFICIENCY | HALF-LIFE | VOLTAGE RISE AT DRIVE TIME | REMARKS |
|---|---|---|---|---|---|---|
| 9−1 | OC-25 | COMPARISON 1 | 100 | 100 | 100 | COMPARATIVE EXAMPLE |
| 9−2 | OC-25 | DP-34 | 108 | 121 | 80 | not according to the invention |
| 9−3 | OC-25 | DP-61 | 106 | 125 | 82 | PRESENT INVENTION |
| 9−4 | OC-25 | DP-61 | 110 | 128 | 77 | PRESENT INVENTION |
| 9−5 | OC-25 | DP-13 | 112 | 132 | 79 | not according to the invention |
| 9−6 | COMPOUND 55 | COMPARISON 2 | 104 | 111 | 95 | COMPARATIVE EXAMPLE |
| 9−7 | COMPOUND 55 | DP-67 | 128 | 150 | 75 | PRESENT INVENTION |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005112765 A
- US 20110057559 A
- US 20110204333 A
- JP 2009130094 A
- US 2009243479 A1
- WO 2006121811 A
- US 2006835469 A
- US 20060202194 A
- US 20070087321 A
- WO 2009100991 A
- WO 2008101842 A
- WO 2003040257 A
- US 20050244673 A
- US 20020034656 A
- US 7332232 B
- US 20090108737 A
- US 20090039776 A
- US 6921915 B
- US 6687266 B
- US 20070190359 A
- US 2006008670 A
- WO 2009050290 A
- US 20090165846 A
- US 20080015355 A
- US 7250226 B
- US 7396598 B
- WO 2002015645 A
- US 20060263635 A
- WO 2009000673 A
- US 20030138657 A
- US 20030152802 A
- US 7090928 B
- WO 2002002714 A
- WO 2006009024 A
- WO 2007097149 A
- WO 2006056418 A
- WO 2005019373 A
- US 7534505 B
- US 7445855 B
- US 20080297033 A
- US 7338722 B
- US 20020134984 A
- WO 2005123873 A
- WO 2007004380 A
- WO 2006082742 A
- US 7279704 B
- WO 2006098120 A
- WO 2006103874 A
- WO 2011063083 A
- US 20110215710 A
- WO 2005076380 A
- WO 2010032663 A
- WO 2008140115 A
- JP 2012069737 A
- JP 2011181303 A
- WO 2007052431 A
- JP 2009114086 A
- WO 2011134013 A
- WO 2011157339 A
- WO 2010086089 A
- WO 2009113646 A
- WO 2012020327 A
- WO 2011051404 A
- US 7544426 B
- US 6821645 B
- JP 2003081988 A
- JP 2002302671 A
- JP 2002363552 A
- WO 2011004639 A
- JP 2001257076 A
- JP 2002308855 A
- JP 2001313179 A
- JP 2002319491 A
- JP 2001357977 A
- JP 2002334786 A
- JP 2002008860 A
- JP 2002334787 A
- JP 2002015871 A
- JP 2002334788 A
- JP 2002043056 A
- JP 2002334789 A
- JP 2002075645 A
- JP 2002338579 A
- JP 2002105445 A
- JP 2002343568 A
- JP 2002141173 A
- JP 2002352957 A
- JP 2002203683 A
- JP 2002363227 A
- JP 2002231453 A
- JP 2003003165 A
- JP 2002234888 A
- JP 2003027048 A
- JP 2002255934 A
- JP 2002260861 A
- JP 2002280183 A
- JP 2002299060 A
- JP 2002302516 A

- JP 2002305083 A
- JP 2002305084 A
- JP 2002308837 A
- US 20050025993 A
- WO 2008132085 A
- WO 2003060956 A
- US 7230107 B
- US 6S28187 A
- US 20090179554 A
- US 20090115316 A
- US 20090101870 A
- US 20040036077 A
- JP 2010251675 A
- JP 2009209133 A
- JP 2009124114 A
- JP 2008277810 A
- JP 2006156445 A
- JP 2005340122 A
- JP 2003045662 A
- JP 2003031367 A
- JP 2003282270 A
- WO 2011086935 A
- WO 2010150593 A
- WO 2010047707 A
- WO 2009069442 A
- WO 2009066779 A
- WO 2009054253 A
- WO 2008114690 A
- WO 2007086552 A
- WO 2006067931 A
- WO 2005085387 A
- WO 2004080975 A
- WO 2004063159 A
- US 7964293 B
- US 2009030202 A
- EP 2311826 A
- JP 2011272858 A
- JP H0945479 B
- JP H09260062 B
- JP H08288069 B
- JP 2003519432 A
- JP 2006135145 A
- JP H06325781 B
- JP H0917574 B
- JP H1074586 B
- JP H11204258 B
- JP H11204359 B
- US 5061569 A
- JP H04308688 B
- JP H11251067 B
- JP H04297076 B
- JP 2000196140 A
- JP 2001102175 A
- JP 2004068143 A
- US 4774435 A
- JP S63314795 B
- JP H01220394 B
- JP S62172691 B
- JP 2001202827 A
- JP H11283751 B


**Non-patent literature cited in the description**


- **M. A. BALDO et al.** *nature,* 1998, vol. 395, 151-154
- Electrode Material. Organic EL Element and Front Line of Industrialization Thereof. NTS Inc, 30 November 1998, 123-166
- Organic EL element and Front Line of Industrialization Thereof. NTS Inc, 30 November 1998, 237
- **M. J. FRISCH et al.** Gaussian98, Revision A. Gaussian, Inc, 2002, vol. 11, 4
- **J. HUANG.** *Applied Physics Letters,* 2002, vol. 80, 139
- *J. Appl. Phys.,* 2004, vol. 95, 5773
- Color Science Handbook, New Edition. University of Tokyo Press, 1985